(19) Europäisches Patentamt
European Patent Office
Office européen des brevets

(11) EP 4 333 590 B1

(12) EUROPEAN PATENT SPECIFICATION

(45) Date of publication and mention of the grant of the patent:
**21.05.2025 Bulletin 2025/21**

(21) Application number: **22192905.2**

(22) Date of filing: **30.08.2022**

(51) International Patent Classification (IPC):
***H10K 50/19** (2023.01)* ***H10K 85/60** (2023.01)*
*H10K 101/30 (2023.01)*

(52) Cooperative Patent Classification (CPC):
**H10K 85/60; H10K 50/11; H10K 50/19;**
H10K 2101/30; H10K 2101/40

(54) **ORGANIC ELECTROLUMINESCENT DEVICE COMPRISING A COMPOUND OF FORMULA (I) AND A COMPOUND OF FORMULA (II), AND DISPLAY DEVICE COMPRISING THE ORGANIC ELECTROLUMINESCENT DEVICE**

ORGANISCHE ELEKTROLUMINESZENZVORRICHTUNG MIT EINER VERBINDUNG DER FORMEL (I) UND EINER VERBINDUNG DER FORMEL (II) SOWIE ANZEIGEVORRICHTUNG MIT DER ORGANISCHEN ELEKTROLUMINESZENZVORRICHTUNG

DISPOSITIF ÉLECTROLUMINESCENT ORGANIQUE COMPRENANT UN COMPOSÉ DE FORMULE (I) ET UN COMPOSÉ DE FORMULE (II), ET DISPOSITIF D'AFFICHAGE COMPRENANT LE DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**06.03.2024 Bulletin 2024/10**

(73) Proprietor: **Novaled GmbH**
**01099 Dresden (DE)**

(72) Inventors:
- **LUSCHTINETZ, Regina**
  **01099 Dresden (DE)**
- **SCHULZE, Benjamin**
  **01099 Dresden (DE)**
- **ROSENOW, Thomas**
  **01099 Dresden (DE)**
- **NÜLLEN, Max Peter**
  **01099 Dresden (DE)**
- **WUDARCZYK, Jakob Jacek**
  **01099 Dresden (DE)**

(74) Representative: **Michalski Hüttermann & Partner Patentanwälte mbB**
**Kaistraße 16A**
**40221 Düsseldorf (DE)**

(56) References cited:
**EP-A1- 3 989 305** **WO-A1-2022/161706**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

### Technical Field

The present invention relates to an electroluminescent device comprising a compound of formula (I) and a compound of formula (II), and a display device comprising the organic electroluminescent device.

### Background Art

Organic electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic light emitting diode may be affected by characteristics of the semiconductor layers, and among them, may be affected by characteristics of the compounds contained in the semiconductor layers. WO 2022/161706 A1 discloses the manufacturing of an OLED comprising multiple light emitting units comprising one specific radialene compound in the hole injecting layer and other radialene compounds in the p-charge generation layer. EP 3989305 A1 discloses OLEDs comprising multiple light emitting units comprising a radialene compound in the hole injecting layer and the same radialene compound in the p-charge generation layer.

There remains a need to improve performance of organic electroluminescent devices, in particular to achieve improved operating voltage, improved operating voltage stability over time and improved current efficiency.

### DISCLOSURE

An aspect of the present invention provides an organic electroluminescent device comprising an anode layer, a cathode layer, a hole injection layer, at least two light-emitting units, and at least one charge generation layer, wherein at least one charge generation layer comprises a p-type charge generation layer;

wherein each light-emitting unit comprises at least one light-emitting layer,
wherein each of the at least one charge generation layer is disposed independently between a set of two adjacent light-emitting units of the at least two light-emitting units;
wherein the hole injection layer is arranged closer to the anode layer than the p-type charge generation layer;
wherein the hole injection layer comprises a first radialene compound of formula (I) and a first hole transport matrix compound, wherein the first radialene compound of formula (I) is represented by:

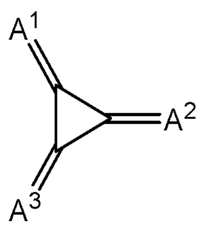
(I),

wherein in formula (I):

$A^1$ is independently selected from a group of formula (Ia):

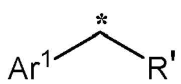
(Ia),

wherein

$Ar^1$ is independently selected from substituted or unsubstituted $C_6$ to $C_{36}$ aryl, and substituted or unsubstituted $C_2$ to $C_{36}$ heteroaryl; wherein

one or more of the substituents of $Ar^1$ are independently selected from the group comprising D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl;
wherein
the one or more substituents of the $C_6$ to $C_{30}$ aryl, $C_6$ to $C_{30}$ heteroaryl, $C_1$ to $C_8$ alkyl, and $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$A^2$ is independently selected from a group of formula (Ib):

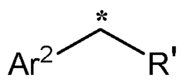 (Ib),

wherein
$Ar^2$ is independently selected from substituted or unsubstituted $C_6$ to $C_{36}$ aryl, and substituted or unsubstituted $C_2$ to $C_{36}$ heteroaryl; wherein

one or more of the substituents of $Ar^2$ are independently selected from the group comprising D, an electron-withdrawing group, halogen, Cl, F, CN, $NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl;
wherein
the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$A^3$ is independently selected from a group of formula (Ic):

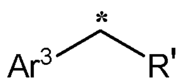 (Ic),

wherein
$Ar^3$ is independently selected from substituted or unsubstituted $C_6$ to $C_{36}$ aryl, and substituted or unsubstituted $C_2$ to $C_{36}$ heteroaryl; wherein
one or more of the substituents of $Ar^3$ are independently selected from the group comprising D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl, wherein
the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

in $A^1$, $A^2$, and $A^3$ each R' is independently selected from substituted or unsubstituted $C_6$ to $C_{18}$ aryl, substituted or unsubstituted $C_3$ to $C_{18}$ heteroaryl, electron-withdrawing group, substituted or unsubstituted $C_1$ to $C_8$ alkyl, partially fluorinated $C_1$ to $C_8$ alkyl, perfluorinated $C_1$ to $C_8$ alkyl, halogen, F and CN; wherein
one or more of the substituents of $C_6$ to $C_{18}$ aryl, $C_6$ to $C_{18}$ heteroaryl, $C_1$ to $C_8$ alkyl, are independently selected from D, an electron-withdrawing group, halogen, Cl, F, CN, $-NO_2$, partially fluorinated $C_1$ to $C_6$ alkyl, perfluorinated $C_1$ to $C_6$

alkyl, partially fluorinated $C_1$ to $C_6$ alkoxy, perfluorinated $C_1$ to $C_6$ alkoxy;
wherein
the first radialene compound of formula (I) has a LUMO energy level of ≤ -5.20 eV; wherein
the p-type charge generation layer comprises a second radialene compound of formula (II) and a second hole transport matrix compound; and

wherein the second radialene compound of formula (II) is represented by:

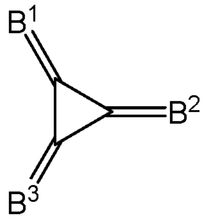
(II),

wherein in formula (II):

$B^1$ is independently selected from a group of formula (IIa):

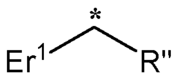
(IIa),

wherein
$Er^1$ is independently selected from substituted or unsubstituted $C_6$ to $C_{36}$ aryl, and substituted or unsubstituted $C_2$ to $C_{36}$ heteroaryl; wherein
one or more of the substituents of $Er^1$ are independently selected from the group comprising D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$B^2$ is independently selected from a group of formula (IIb):

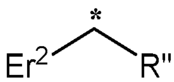
(IIb),

wherein
$Er^2$ is independently selected from substituted or unsubstituted $C_6$ to $C_{36}$ aryl, and substituted or unsubstituted $C_2$ to $C_{36}$ heteroaryl; wherein
one or more of the substituents of $Er^2$ are independently selected from the group comprising D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and; wherein
the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$B^3$ is independently selected from a group of formula (Ic):

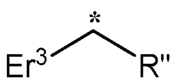
(IIc),

wherein

$Er^3$ is independently selected from substituted or unsubstituted $C_6$ to $C_{36}$ aryl, and substituted or unsubstituted $C_2$ to $C_{36}$ heteroaryl; wherein

one or more of the substituents of $Er^3$ are independently selected from the group comprising D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein
in $B^1$, $B^2$, and $B^3$ each R" is independently selected from substituted or unsubstituted $C_6$ to $C_{18}$ aryl, substituted or unsubstituted $C_3$ to $C_{18}$ heteroaryl, electron-withdrawing group, substituted or unsubstituted $C_1$ to $C_8$ alkyl, partially fluorinated $C_1$ to $C_8$ alkyl, perfluorinated $C_1$ to $C_8$ alkyl, halogen, F and CN;
wherein the one or more substituents of $C_6$ to $C_{18}$ aryl, $C_6$ to $C_{18}$ heteroaryl, $C_1$ to Cs alkyl, are independently selected from D, an electron-withdrawing group, halogen, Cl, F, CN, $-NO_2$, partially fluorinated $C_1$ to $C_6$ alkyl, perfluorinated $C_1$ to $C_6$ alkyl, partially fluorinated $C_1$ to $C_6$ alkoxy, perfluorinated $C_1$ to $C_6$ alkoxy;
wherein
the first radialene compound of formula (I) and the second radialene compound of formula (II) are selected different from each other; and wherein the asterisk "*" denotes the binding position.

The LUMO energy level is calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

The organic electroluminescent device comprises an anode layer, a cathode layer, a hole injection layer, at least two light-emitting units, and at least one charge generation layer, wherein at least one charge generation layer comprises a p-type charge generation layer;

wherein each light-emitting unit comprises at least one light-emitting layer,
wherein each of the at least one charge generation layer is disposed independently between a set of two adjacent light-emitting units of the at least two light-emitting units;
wherein the hole injection layer is arranged closer to the anode layer than the p-type charge generation layer;
wherein the hole injection layer comprises a first radialene compound of formula (I) and a first hole transport matrix compound, wherein the first radialene compound of formula (I) is represented by:

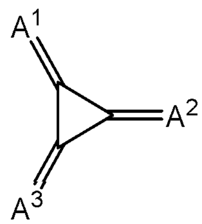
(I),

wherein in formula (I):

$A^1$ is independently selected from a group of formula (Ia):

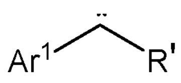
(Ia),

wherein
$Ar^1$ is independently selected from substituted or unsubstituted $C_6$ to $C_{36}$ aryl, and substituted or unsubstituted $C_2$ to $C_{36}$ heteroaryl; wherein

one or more of the substituents of $Ar^1$ are independently selected from the group comprising D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy,

partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl;

wherein

the one or more substituents of the $C_6$ to $C_{30}$ aryl, $C_6$ to $C_{30}$ heteroaryl, $C_1$ to $C_8$ alkyl, and $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$A^2$ is independently selected from a group of formula (Ib):

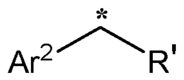 (Ib),

wherein

$Ar^2$ is independently selected from substituted or unsubstituted $C_6$ to $C_{36}$ aryl, and substituted or unsubstituted $C_2$ to $C_{36}$ heteroaryl; wherein

one or more of the substituents of $Ar^2$ are independently selected from the group comprising D, an electron-withdrawing group, halogen, Cl, F, CN, $NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl;

wherein

the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$A^3$ is independently selected from a group of formula (Ic):

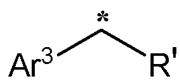 (Ic),

wherein

$Ar^3$ is independently selected from substituted or unsubstituted $C_6$ to $C_{36}$ aryl, and substituted or unsubstituted $C_2$ to $C_{36}$ heteroaryl; wherein

one or more of the substituents of $Ar^3$ are independently selected from the group comprising D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl, wherein

the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

in $A^1$, $A^2$, and $A^3$ each R' is independently selected from substituted or unsubstituted $C_6$ to $C_{18}$ aryl, substituted or unsubstituted $C_3$ to $C_{18}$ heteroaryl, electron-withdrawing group, substituted or unsubstituted $C_1$ to $C_8$ alkyl, partially fluorinated $C_1$ to $C_8$ alkyl, perfluorinated $C_1$ to $C_8$ alkyl, halogen, F and CN; wherein

one or more of the substituents of $C_6$ to $C_{18}$ aryl, $C_6$ to $C_{18}$ heteroaryl, $C_1$ to $C_8$ alkyl, are independently selected from D, an electron-withdrawing group, halogen, Cl, F, CN, $-NO_2$, partially fluorinated $C_1$ to $C_6$ alkyl, perfluorinated $C_1$ to $C_6$ alkyl, partially fluorinated $C_1$ to $C_6$ alkoxy, perfluorinated $C_1$ to $C_6$ alkoxy;

wherein

the first radialene compound of formula (I) has a LUMO energy level that is when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase of ≤ -5.20 eV;

wherein

the p-type charge generation layer comprises a second radialene compound of formula (II) and a second hole transport matrix compound; and

wherein the second radialene compound of formula (II) is represented by:

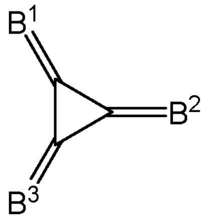

(II),

wherein in formula (II):

$B^1$ is independently selected from a group of formula (IIa):

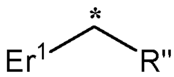

(IIa),

wherein

$Er^1$ is independently selected from substituted or unsubstituted $C_6$ to $C_{36}$ aryl, and substituted or unsubstituted $C_2$ to $C_{36}$ heteroaryl; wherein

one or more of the substituents of $Er^1$ are independently selected from the group comprising D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$B^2$ is independently selected from a group of formula (IIb):

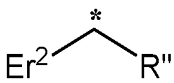

(IIb),

wherein

$Er^2$ is independently selected from substituted or unsubstituted $C_6$ to $C_{36}$ aryl, and substituted or unsubstituted $C_2$ to $C_{36}$ heteroaryl; wherein

one or more of the substituents of $Er^2$ are independently selected from the group comprising D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and; wherein

the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$B^3$ is independently selected from a group of formula (Ic):

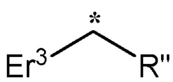

(IIc),

wherein

$Er^3$ is independently selected from substituted or unsubstituted $C_6$ to $C_{36}$ aryl, and substituted or unsubstituted $C_2$ to $C_{36}$ heteroaryl; wherein

one or more of the substituents of $Er^3$ are independently selected from the group comprising D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

in $B^1$, $B^2$, and $B^3$ each R" is independently selected from substituted or unsubstituted $C_6$ to $C_{18}$ aryl, substituted or unsubstituted $C_3$ to $C_{18}$ heteroaryl, electron-withdrawing group, substituted or unsubstituted $C_1$ to $C_8$ alkyl, partially fluorinated $C_1$ to $C_8$ alkyl, perfluorinated $C_1$ to $C_8$ alkyl, halogen, F and CN;

wherein the one or more substituents of $C_6$ to $C_{18}$ aryl, $C_6$ to $C_{18}$ heteroaryl, $C_1$ to $C_8$ alkyl, are independently selected from D, an electron-withdrawing group, halogen, Cl, F, CN, $-NO_2$, partially fluorinated $C_1$ to $C_6$ alkyl, perfluorinated $C_1$ to $C_6$ alkyl, partially fluorinated $C_1$ to $C_6$ alkoxy, perfluorinated $C_1$ to $C_6$ alkoxy;

wherein

the first radialene compound of formula (I) and the second radialene compound of formula (II) are selected different from each other; and wherein the asterisk "*" denotes the binding position.

It should be noted that throughout the application and the claims any $A^1$, $A^2$, and $A^3$, $Ar^1$, $Ar^2$, and $Ar^3$, $B^1$, $B^2$, and $B^3$, $Er^1$, $Er^2$, and $Er^3$, R'; R", etc. always refer to the same moieties, unless otherwise noted.

In the present specification, when a definition is not otherwise provided, "substituted" refers to one substituted with a D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl; wherein the one or more substituents of the $C_6$ to $C_{30}$ aryl, $C_6$ to $C_{30}$ heteroaryl, $C_1$ to $C_8$ alkyl, and $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy.

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, an "alkyl group" refers to a saturated aliphatic hydrocarbyl group.

The alkyl group may be a $C_1$ to $C_8$ alkyl group. More specifically, the alkyl group may be a $C_1$ to $C_6$ alkyl group or a $C_1$ to $C_4$ alkyl group. For example, a $C_1$ to $C_4$ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an isopropyl group, a butyl group, an iso-butyl group, a sec-butyl group, a tert-butyl group, a pentyl group, a hexyl group.

The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methyl cyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S and most preferred N.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphthyl or fluoren-2-yl.

In the present specification, "aryl group" refers to a hydrocarbyl group which may comprises fused aryl rings" or "condensed aryl rings.

Analogously, under heteroaryl, it is especially where suitable understood a group derived by formal abstraction of one ring hydrogen from a heterocyclic aromatic ring in a compound comprising at least one such ring.

In the present specification, "heteroaryl group" may comprises fused aryl rings" or "condensed aryl rings" and/or fused heteroaryl rings" or "condensed hetero aryl rings".

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common $sp^2$-hybridized carbon atoms.

The term "cyano moiety" refers to a CN substituent.

The term "electron-withdrawing group" refers to a chemical group in a molecule, which can draw electrons away from an adjacent part of the molecule. The distance over which the electron-withdrawing group can exert its effect, namely the number of bonds over which the electron-withdrawing effect spans, is extended by conjugated pi-electron systems such as aromatic systems. Examples of electron-withdrawing groups include $NO_2$, CN, halogen, Cl, F, partially fluorinated or perfluorinated alkyl and partially fluorinated or perfluorinated $C_1$ to $C_{12}$ alkyl, partially fluorinated or perfluorinated alkoxy, partially fluorinated or perfluorinated $C_1$ to $C_6$ alkoxy.

In the present specification, the single bond refers to a direct bond.

The term "n-type charge generation layer" is sometimes in the art also named n-CGL or electron generation layer and is intended to include the both.

The term "p-type charge generation layer" is sometimes in the art also named p-CGL or hole generation layer and is intended to include the both.

The term "free of", "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms "anode", "anode layer" and "anode electrode" are used synonymously.

The terms "cathode", "cathode layer" and "cathode electrode" are used synonymously.

The term "top emission device" is understood to mean an organic electronic device wherein the light is emitted through the cathode layer.

The term "bottom emission device" is understood to mean an organic electronic device wherein the light is emitted through the substrate.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

## Advantageous Effects

Surprisingly, it was found that the organic electroluminescent device according to the invention solves the problem underlying the present invention by enabling devices in various aspects superior over the organic electroluminescent devices known in the art, in particular with respect to improved operating voltage, improved operating voltage stability over time and improved current efficiency.

Furthermore, it could surprisingly be found that a radialene with a lower LUMO as p-dopant in the hole injection layer may improve the voltage rise remarkably.

Moreover it was surprisingly be found that an OLED comprising a hole injection layer and p-type charge generation layer, wherein different radialene dopant in hole injection layer (HIL) and p-type charge generation layer (p-CGL), and the radialene in the HIL have a LUMO energy level of $\leq$ -5.20 eV results in a voltage rise over time that is reduced remarkably.

According to one embodiment, each of the at least one charge generation layer comprises a p-type charge generation layer.

## Organic electroluminescent device

According to one embodiment, the organic electroluminescent device comprises at least three light-emitting units, and at least one charge generation layer, wherein each of the at least one charge generation layer is disposed

independently between one set of two adjacent light-emitting units of the at least three light-emitting units.

According to one embodiment, between one set of two adjacent light-emitting units, no more than one charge generation layer is arranged, in particular no more than one charge generation layer comprising a p-type charge generation layer and an n-type charge generation layer.

According to one embodiment, between each set of two adjacent light-emitting units, no more than one charge generation layer is arranged, in particular no more than one charge generation layer comprising a p-type charge generation layer and an n-type charge generation layer.

According to one embodiment, the organic electroluminescent device comprises at least three light-emitting units, and at least one or two charge generation layer, wherein each of the at least one charge generation layer is disposed independently between one set of two adjacent light-emitting units of the at least three light-emitting units, wherein the at least one or two charge generation layer comprises a p-type charge generation layer, wherein the p-type charge generation layer comprises a second radialene compound of formula (II) and a second hole transport matrix compound.

According to one embodiment, the organic electroluminescent device comprises at least three light-emitting units, and at least two charge generation layer, wherein each of the at least two charge generation layers are disposed independently between one set of two adjacent light-emitting units of the at least three light-emitting units; or the organic electroluminescent device comprises at least four light-emitting units, and at least three charge generation layer, wherein each of the at least three charge generation layers are disposed independently between one set of two adjacent light-emitting units of the at least four light-emitting units.

According to one embodiment, the organic electroluminescent device comprises at least four light-emitting units, and at least one, two or three charge generation layer, wherein each of the at least one, two or three charge generation layer is disposed independently between one set of two adjacent light-emitting units of the at least four light-emitting units.

According to one embodiment, the organic electroluminescent device comprises at least four light-emitting units, and at least one, two or three charge generation layer, wherein each of the at least one, two or three charge generation layer is disposed independently between one set of two adjacent light-emitting units of the at least four light-emitting units, wherein the at least one charge generation layer comprises a p-type charge generation layer, wherein the p-type charge generation layer comprises a second radialene compound of formula (II) and a second hole transport matrix compound.

According to one embodiment, the organic electroluminescent device comprises at least three light-emitting units, and at least two charge generation layers, wherein each of the at least two charge generation layers is disposed independently between one set of two adjacent light-emitting units of the at least three light-emitting units, preferably between different sets of two adjacent light-emitting units.

According to one embodiment, the organic electroluminescent device comprises at least three light-emitting units, and at least two charge generation layers, wherein each of the at least two charge generation layers is disposed independently between one set of two adjacent light-emitting units of the at least three light-emitting units, preferably between different sets of two adjacent light-emitting units, wherein at least one, preferably at least two of the charge generation layers comprise a p-type charge generation layer.

According to one embodiment, the organic electroluminescent device comprises at least three light-emitting units, and at least two charge generation layers, wherein each of the at least two charge generation layers is disposed independently between one set of two adjacent light-emitting units of the at least three light-emitting units, preferably between different sets of two adjacent light-emitting units, wherein each of the at least two charge generation layer comprises a p-type charge generation layer, wherein the p-type charge generation layer comprises a second radialene compound of formula (II) and a second hole transport matrix compound.

According to one embodiment, the organic electroluminescent device comprises at least four light-emitting units, and at least three charge generation layers, wherein each of the at least three charge generation layers is disposed independently between one set of two adjacent light-emitting units of the at least four light-emitting units, preferably between different sets of two adjacent light-emitting units.

According to one embodiment, the organic electroluminescent device comprises at least four light-emitting units, and at least three charge generation layers, wherein each of the at least three charge generation layers is disposed independently between one set of two adjacent light-emitting units of the at least four light-emitting units, preferably between different sets of two adjacent light-emitting units, wherein at least one, preferably at least two, more preferably at least three of the charge generation layers comprise a p-type charge generation layer.

According to one embodiment, the organic electroluminescent device comprises at least four light-emitting units, and at least three charge generation layers, wherein each of the at least three charge generation layers is disposed independently between one set of two adjacent light-emitting units of the at least four light-emitting units, preferably between different sets of two adjacent light-emitting units, wherein each of the at least three charge generation layer comprises a p-type charge generation layer, wherein the p-type charge generation layer comprises a second radialene compound of formula (II) and a second hole transport matrix compound.

According to one embodiment, the organic electroluminescent device comprises at least four light-emitting units, and at least three charge generation layers, wherein each of the at least three charge generation layers is disposed

independently between one set of two adjacent light-emitting units of the at least four light-emitting units, preferably between different sets of two adjacent light-emitting units, wherein at least one, preferably at least two, more preferably at least three of the charge generation layers comprise a p-type charge generation layer, wherein each of the at least three charge generation layer comprises a p-type charge generation layer, wherein the p-type charge generation layer comprises a second radialene compound of formula (II) and a second hole transport matrix compound.

According to one embodiment, the hole transport layer is arranged adjacent to the hole injection layer, and preferably the hole transport layer is arranged between a light-emitting unit and the hole injection layer.

According to one embodiment, the at least one charge generation layer further comprises an n-type charge generation layer.

According to one embodiment, wherein the p-type charge generation layer of the at least one charge generation layer is arranged in direct contact to the n-type charge generation layer of said at least one charge generation layer.

According to one embodiment, wherein at least one, or at least two, or at least three light-emitting unit or all light-emitting units comprises in addition to an emission layer further a hole transport layer, and an electron transport layer.

According to one embodiment, wherein at least one, or at least two, or at least three light-emitting unit or all light-emitting units comprises in addition to an emission layer further a hole transport layer, an electron blocking layer, a hole blocking layer and an electron transport layer.

**First radialene compound of formula** (I)

According to one embodiment, wherein the first radialene compound of formula (I) comprises less than nine cyano moieties.

According to one embodiment, wherein the first radialene compound of formula (I) comprises less than eight cyano moieties.

According to one embodiment, wherein the first radialene compound of formula (I) comprises at least one cyano moiety.

According to one embodiment, wherein the first radialene compound of formula (I) comprises at least two cyano moieties.

According to one embodiment, wherein the first radialene compound of formula (I) comprises at least three cyano moieties.

According to one embodiment, wherein the first radialene compound of formula (I) comprises at least four cyano moieties.

According to one embodiment, wherein the first radialene compound of formula (I) comprises from 3 to 8 cyano moieties.

According to one embodiment, wherein the first radialene compound of formula (I) comprises from 3 to 7 cyano moieties.

According to one embodiment, wherein the first radialene compound of formula (I) comprises from 4 to 7 cyano moieties.

According to one embodiment, wherein the first radialene compound of formula (I) comprises at least 10 fluorine atoms, at least 12 fluorine atoms, at least 13 fluorine atoms, 14 at least fluorine atoms, at least 15 fluorine atoms, at least 16 fluorine atoms, at least 17 fluorine atoms, or at least 18 fluorine atoms.

According to one embodiment, wherein the first radialene compound of formula (I) comprises 10 to 20 fluorine atoms, or 10 to 18 fluorine atoms or 12 to 18 fluorine atoms.

According to one embodiment, wherein the first radialene compound of formula (I) comprises 4 to 7 cyano moieties and 12 to 18 fluorine atoms.

According to one embodiment, wherein the first radialene compound of formula (I) comprises at least one $CF_3$ group.

According to one embodiment, wherein the first radialene compound of formula (I) comprises at least one to three $CF_3$ groups.

According to one embodiment, wherein the first radialene compound of formula (I) is present in an amount of ≤99.9 wt.-% based on the total weight of the hole injection layer, preferably ≤99 wt.-%, more preferably ≤95 wt.-%, more preferably ≤90 wt.-%, more preferably ≤80 wt.-%, more preferably ≤70 wt.-%, more preferably ≤60 wt.-%, more preferably ≤50 wt.-%, more preferably ≤40 wt.-%, more preferably ≤30 wt.-%, more preferably ≤20 wt.-%, more preferably ≤ 10 wt.-%, more preferably ≤ 5 wt.-%, more preferably ≤ 3.0 wt.-%, more preferably ≤ 2.75 wt.-%, more preferably ≤ 2.5 wt.-%, more preferably ≤ 2.25 wt.-%, and most preferably ≤ 2.0 wt.-%, based on the total weight of the hole injection layer.

According to one embodiment, wherein the first radialene compound of formula (I) has a LUMO when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase of ≤ -5.25 eV.

According to one embodiment, wherein the first radialene compound of formula (I), has a calculated LUMO

energy level of ≤ -5.21 eV when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably ≤-5.22 eV; further preferred ≤ -5.25 eV; and in addition preferred ≤ -5.29 eV.

According to one embodiment, wherein the first radialene compound of formula (I), has a calculated LUMO energy level in the range of ≤ -5.20 eV to ≥ -5.75 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably ≤ -5.20 eV to ≥ -5.70 eV; further preferred ≤ -5.20 eV to ≥ - 5.65 eV, also preferred ≤ -5.20 eV to ≥ - 5.60 eV, furthermore preferred ≤ -5.22 eV to ≥ - 5.60 eV, in addition preferred ≤ -5.25 eV to ≥ - 5.55 eV, more preferred ≤ -5.25 eV to ≥ - 5.50 eV, even more preferred ≤ -5.25 eV to ≥ - 5.45 eV.

### Second radialene compound of formula (II)

According to one embodiment, wherein the second radialene compound of formula (II) comprises less than nine cyano moieties.

According to one embodiment, wherein the second radialene compound of formula (II) comprises less than eight cyano moieties.

According to one embodiment, wherein the second radialene compound of formula (II) comprises at least one cyano moiety.

According to one embodiment, wherein the second radialene compound of formula (II) comprises at least two cyano moieties.

According to one embodiment, wherein the second radialene compound of formula (II) comprises at least three cyano moieties.

According to one embodiment, wherein the second radialene compound of formula (II) comprises at least four cyano moieties.

According to one embodiment, wherein the second radialene compound of formula (II) comprises from 3 to 8 cyano moieties.

According to one embodiment, wherein the second radialene compound of formula (II) comprises from 3 to 7 cyano moieties.

According to one embodiment, wherein the second radialene compound of formula (II) comprises from 4 to 7 cyano moieties.

According to one embodiment, wherein the second radialene compound of formula (II) comprises at least 10 fluorine atoms, at least 12 fluorine atoms, at least 13 fluorine atoms, at least 14 fluorine atoms, at least 15 fluorine atoms, at least 16 fluorine atoms, at least 17 fluorine atoms, or at least 18 fluorine atoms.

According to one embodiment, wherein the second radialene compound of formula (II) comprises 10 to 20 fluorine atoms, or 10 to 18 fluorine atoms or 12 to 18 fluorine atoms.

According to one embodiment, wherein the second radialene compound of formula (II) comprises 4 to 7 cyano moieties and 12 to 18 fluorine atoms.

According to one embodiment, wherein the second radialene compound of formula (II) comprises at least one $CF_3$ group.

According to one embodiment, wherein the second radialene compound of formula (II) comprises at least one to three $CF_3$ groups.

According to one embodiment, wherein the second radialene compound of formula (II) has a calculated LUMO energy level, wherein the LUMO energy level is calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

### Substituent R' and R"

According to one embodiment, in the first radialene compound of formula (I), R' is independently selected from halogen, F and CN.

According to one embodiment, in the first radialene compound of formula (I), R' is selected from CN.

According to one embodiment, in the first radialene compound of formula (I) each R' is independently selected from electron-withdrawing group, partially fluorinated $C_1$ to $C_8$ alkyl, perfluorinated $C_1$ to $C_8$ alkyl, halogen, F and CN.

According to one embodiment, in the first radialene compound of formula (I) each R' is independently selected from partially fluorinated $C_1$ to $C_8$ alkyl, perfluorinated $C_1$ to $C_8$ alkyl, halogen, F and CN.

According to one embodiment, in the first radialene compound of formula (I) each R' is independently selected from $CF_3$, F and CN.

According to one embodiment, in the second radialene compound of formula (I), R" is independently selected

from halogen, F and CN.

According to one embodiment, in the second radialene compound of formula (I), R" is selected from CN.

According to one embodiment, in the second radialene compound of formula (II) each R" is independently selected from electron-withdrawing group, partially fluorinated $C_1$ to $C_8$ alkyl, perfluorinated $C_1$ to $C_8$ alkyl, halogen, F and CN.

According to one embodiment, in the second radialene compound of formula (II) each R" is independently selected from partially fluorinated $C_1$ to $C_8$ alkyl, perfluorinated $C_1$ to $C_8$ alkyl, halogen, F and CN.

According to one embodiment, in the second radialene compound of formula (II) each R" is independently selected from $CF_3$, F and CN.

According to one embodiment, wherein in the first radialene compound of formula (I), R' and in the second radialene compound of formula (II), R" the R' and R" are independently selected from halogen, F and CN, and preferably CN.

**Substituents $A^1$, $A^2$, and $A^3$ and $B^1$, $B^2$, and $B^3$**

According to one embodiment, in the first radialene compound of formula (I), at least two of $A^1$, $A^2$, and $A^3$ are selected the same.

According to one embodiment, in the first radialene compound of formula (I), $A^1$, $A^2$, and $A^3$ are selected the same.

According to one embodiment, in the first radialene compound of formula (I), $A^2$ and $A^3$ are selected the same.

According to one embodiment, in the first radialene compound of formula (I), $A^1$ and $A^3$ are selected the same.

According to one embodiment, in the first radialene compound of formula (I), $A^1$ and $A^2$ are selected the same.

According to one embodiment, in the first radialene compound of formula (I), $A^1$ is selected different from $A^2$ and/or $A^3$.

According to one embodiment, in the second radialene compound of formula (II), at least two of $B^1$, $B^2$, and $B^3$ are selected the same.

According to one embodiment, in the second radialene compound of formula (II), $B^1$, $B^2$, and $B^3$ are selected the same.

According to one embodiment, in the second radialene compound of formula (II), $B^2$ and $B^3$ are selected the same.

According to one embodiment, in the second radialene compound of formula (II), $B^1$ and $B^3$ are selected the same.

According to one embodiment, in the second radialene compound of formula (II), $B^1$ and $B^2$ are selected the same.

According to one embodiment, in the second radialene compound of formula (II), $B^1$ is selected different from $B^2$ and/or $B^3$.

According to one embodiment, in the first radialene compound of formula (I), at least two of $A^1$, $A^2$, and $A^3$ are selected the same; and/or in the second radialene compound of formula (II), at least two of $B^1$, $B^2$, and $B^3$ are selected the same.

**Substituents $Ar^1$, $Ar^2$, and $Ar^3$ and $Er^1$, $Er^2$, and $Er^3$**

According to one embodiment, $Ar^1$, $Ar^2$, and $Ar^3$ are independently selected from substituted or unsubstituted $C_6$ to $C_{12}$ aryl and substituted or unsubstituted $C_3$ to $C_{12}$ heteroaryl.

According to one embodiment, $Ar^1$, $Ar^2$, and $Ar^3$ are independently selected from substituted or unsubstituted $C_6$ aryl and substituted or unsubstituted $C_3$ to $C_5$ heteroaryl.

According to one embodiment, the substituents on $Ar^1$, $Ar^2$, and $Ar^3$ are independently selected from the group consisting of an electron-withdrawing group, halogen, Cl, F, CN, partially fluorinated alkyl, and perfluorinated alkyl.

According to one embodiment, the substituents on $Ar^1$, $Ar^2$, and $Ar^3$ are independently selected from the group consisting of Cl, F, CN, and perfluorinated alkyl.

According to one embodiment, the substituents on $Ar^1$, $Ar^2$, and $Ar^3$ are independently selected from the group consisting of F, CN, and perfluorinated alkyl.

According to one embodiment, the substituents on $Ar^1$, $Ar^2$, and $Ar^3$ are independently selected from the group consisting of F, CN, and $CF_3$.

According to one embodiment, the substituents on $Ar^1$, $Ar^2$, and $Ar^3$ are independently selected from the group consisting of CN, and $CF_3$.

According to one embodiment, the substituents on $Ar^1$, $Ar^2$, and $Ar^3$ are independently selected from the group consisting of CN.

According to one embodiment, the substituents on $Ar^1$, $Ar^2$, and $Ar^3$ are independently selected from the group consisting of $CF_3$.

According to one embodiment, $Ar^1$, $Ar^2$, and $Ar^3$ independently each comprise more than one and less than five substituents, preferably more than two and less than four, for example 4.

According to one embodiment, $Er^1$, $Er^2$, and $Er^3$ are independently selected from substituted or unsubstituted $C_6$ to $C_{12}$ aryl and substituted or unsubstituted $C_3$ to $C_{12}$ heteroaryl.

According to one embodiment, $Er^1$, $Er^2$, and $Er^3$ are independently selected from substituted or unsubstituted $C_6$ aryl and substituted or unsubstituted $C_3$ to $C_5$ heteroaryl.

According to one embodiment, the substituents on $Er^1$, $Er^2$, and $Er^3$ are independently selected from the group consisting of an electron-withdrawing group, halogen, Cl, F, CN, partially fluorinated alkyl, and perfluorinated alkyl.

According to one embodiment, the substituents on $Er^1$, $Er^2$, and $Er^3$ are independently selected from the group consisting of Cl, F, CN, and perfluorinated alkyl.

According to one embodiment, the substituents on $Er^1$, $Er^2$, and $Er^3$ are independently selected from the group consisting of F, CN, and perfluorinated alkyl.

According to one embodiment, the substituents on $Er^1$, $Er^2$, and $Er^3$ are independently selected from the group consisting of F, CN, and $CF_3$.

According to one embodiment, the substituents on $Er^1$, $Er^2$, and $Er^3$ are independently selected from the group consisting of CN, and $CF_3$.

According to one embodiment, the substituents on $Er^1$, $Er^2$, and $Er^3$ are independently selected from the group consisting of CN.

According to one embodiment, the substituents on $Er^1$, $Er^2$, and $Er^3$ are independently selected from the group consisting of $CF_3$.

According to one embodiment, $Er^1$, $Er^2$, and $Er^3$ independently each comprise more than one and less than five substituents, preferably more than two and less than four, for example 4.

According to one embodiment, in the first radialene compound of formula (I) $Ar^1$, $Ar^2$, and $Ar^3$ and/or in the second radialene compound of formula (II) $Er^1$, $Er^2$, and $Er^3$ are independently selected from one of the following groups of B1 to B64:

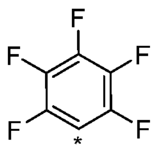
B1,

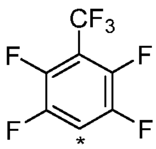
B2,

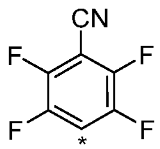
B3,

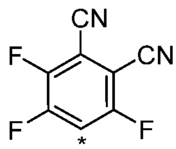
B4,

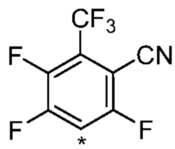
B5,

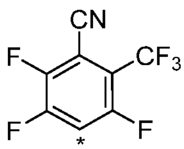
B6,

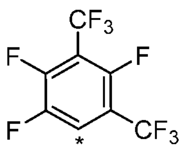
B7,

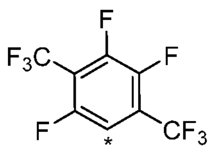
B8,

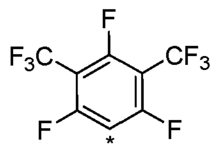
B9,

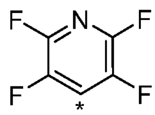
B10,

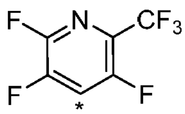
B11,

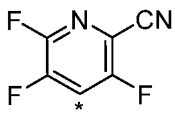
B12,

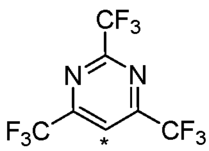
B13,

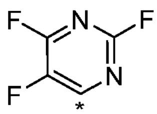
B14,

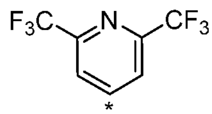
B15,

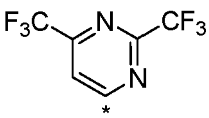
B16,

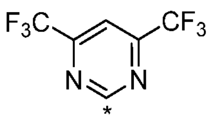
B17,

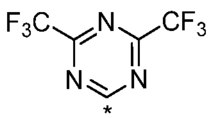
B18,

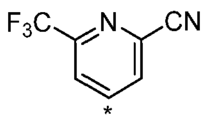
B19,

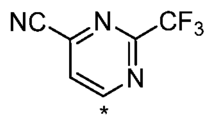
B20,

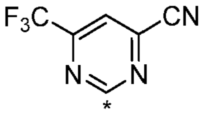 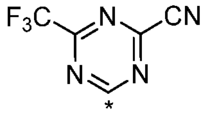 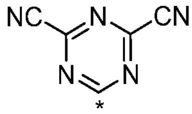 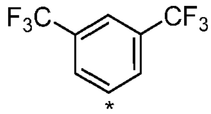 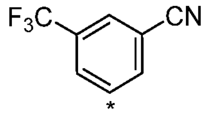

B21, B22, B23, B24, B25,

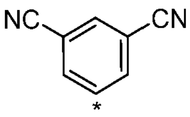 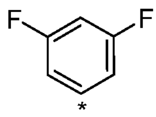 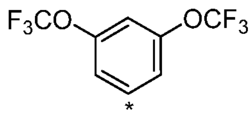 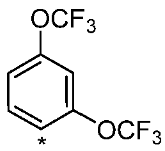 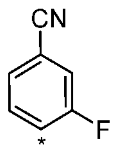

B26, B27, B28, B29, B30,

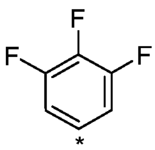 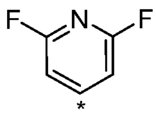 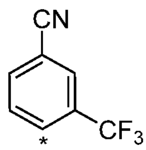 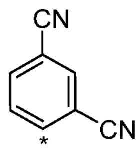 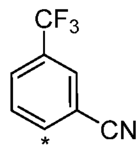

B31, B32, B33, B34, B35,

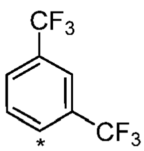 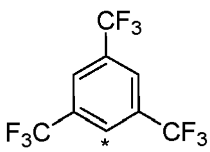 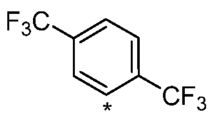 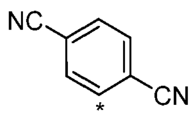 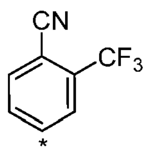

B36, B37, B38, B39, B40,

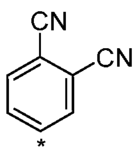 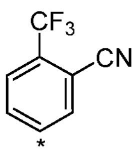 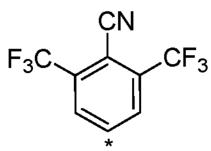 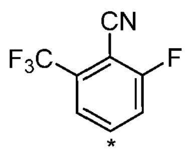 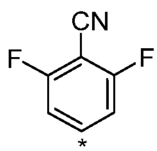

B41, B42, B43, B44, B45,

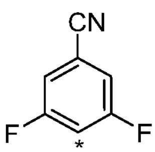 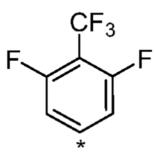 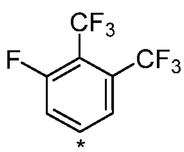 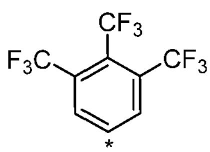 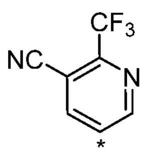

B46, B47, B48, B49, B50,

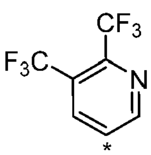 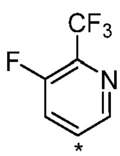 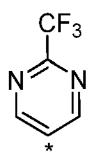 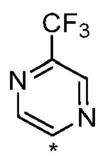 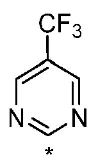

B51, B52, B53, B54, B55,

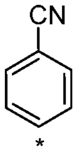
B56,

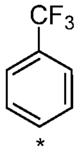
B57,

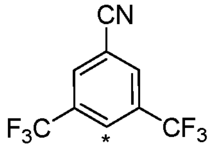
B58,

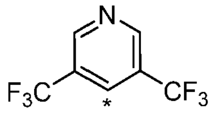
B59,

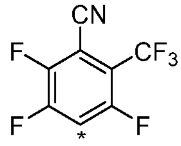
B60,

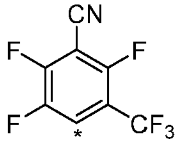
B61,

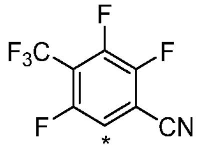
B62,

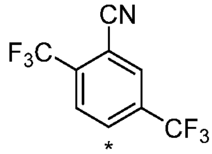
B63,

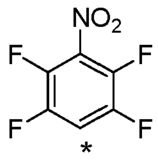
B64,

wherein the asterisk "*" denotes the binding position.

According to one embodiment, in the first radialene compound of formula (I) $Ar^1$, $Ar^2$, and $Ar^3$ and/or in the second radialene compound of formula (II) $Er^1$, $Er^2$, and $Er^3$ are independently selected from one of the following groups of B1 to B8, B10 to B17, B19 to B21, B24 to B26, B33, B34, B37, B40, B43, B58 to B62 and B64, and preferably in the first radialene compound of formula (I) $Ar^1$, Ar2 and Ar3 and/or in the second radialene compound of formula (II) $Er^1$, Er2 and Er3 are independently selected from one of the following groups of B2, B3, B4, B11, B13, B37, B43, B58, B59, B60, B61, B63 and B64.

According to one embodiment, in the first radialene compound of formula (I) $Ar^1$, $Ar^2$, and $Ar^3$ and/or in the second radialene compound of formula (II) $Er^1$, $Er^2$, and $Er^3$ are independently selected from one of the following groups of B1 to B64, and wherein preferably each R' and/or R" are selected from CN, and preferably wherein in the first radialene compound of formula (I) $Ar^1$, $Ar^2$ and $Ar^3$ and/or in the second radialene compound of formula (II) $Er^1$, $Er^2$ and $Er^3$ are independently selected from one of the following groups of B1 to B5, B7, B8, B10 to B13, B15 to B17, B19 to B21, B37, B43, B58 to B61, B63 and B64 and wherein preferably each R' and/or R" are selected from CN.

According to one embodiment, wherein in the first radialene compound of formula (I) $Ar^1$, $Ar^2$ and $Ar^3$ and/or in the second radialene compound of formula (II) $Er^1$, $Er^2$ and $Er^3$ are independently selected from one of the following groups:

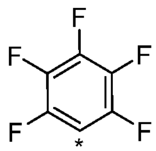
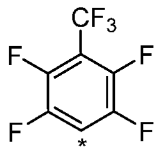
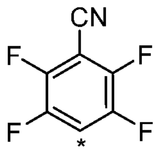
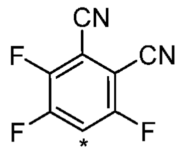
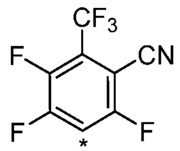
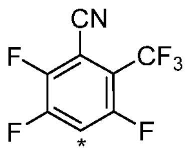
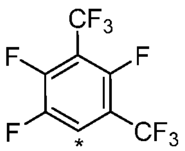
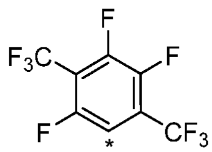
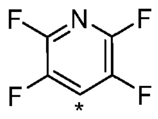
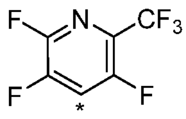
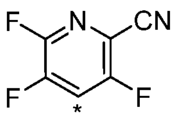
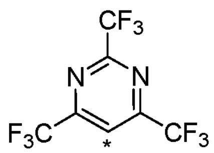
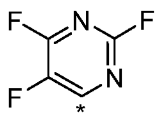
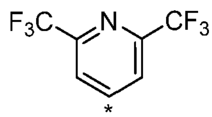
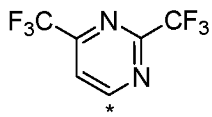
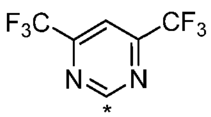
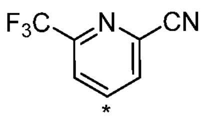
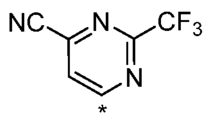
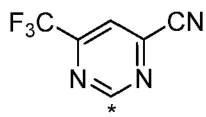
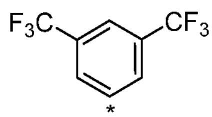

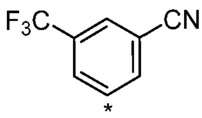 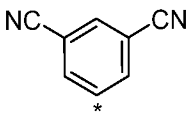 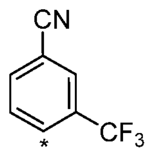 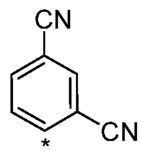 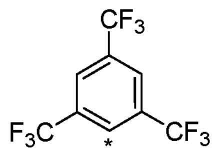

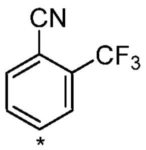 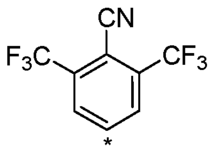 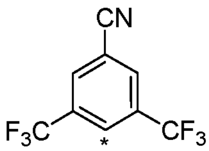 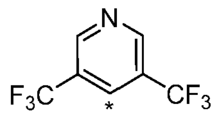 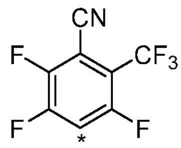

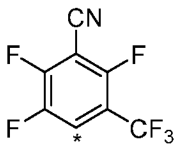 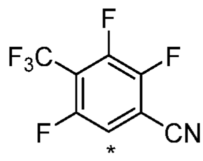 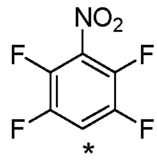 ,

wherein the asterisk "*" denotes the binding position; and wherein preferably each R' and/or R" is selected from CN.

According to one embodiment, wherein in the first radialene compound of formula (I) $Ar^1$, $Ar^2$ and $Ar^3$ and/or in the second radialene compound of formula (II) $Er^1$, $Er^2$ and $Er^3$ are independently selected from one of the following groups:

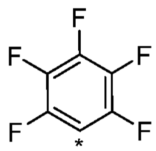 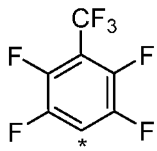 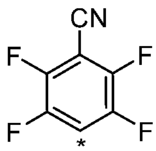 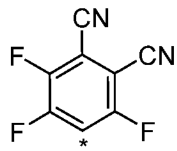 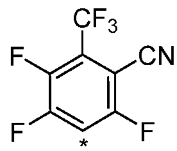

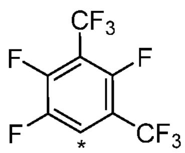 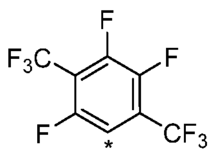 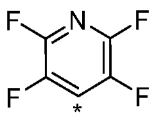 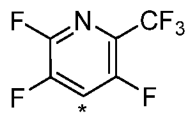 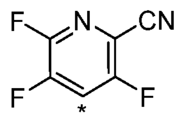

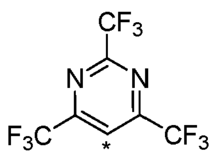 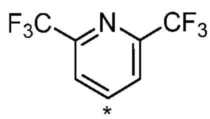 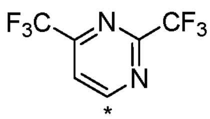 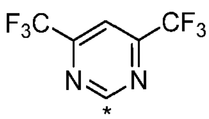 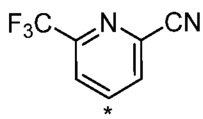

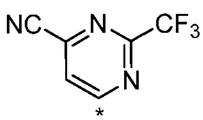 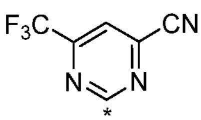 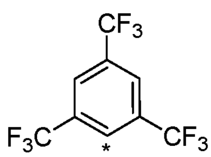 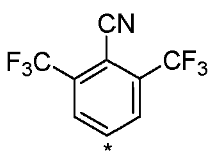 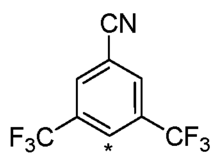

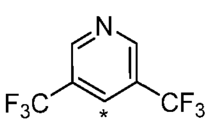 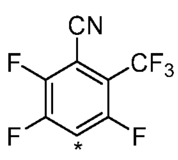 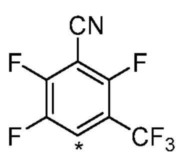 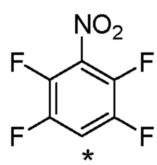

wherein the asterisk "*" denotes the binding position; and wherein preferably each R' and/or R" is selected from CN.

According to one embodiment, wherein in the first radialene compound of formula (I) $Ar^1$, $Ar^2$ and $Ar^3$ and/or in the second radialene compound of formula (II) $Er^1$, $Er^2$ and $Er^3$ are independently selected from one of the following groups:

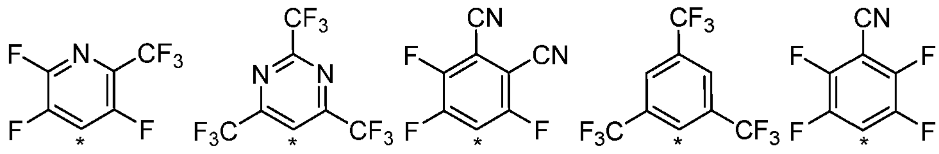

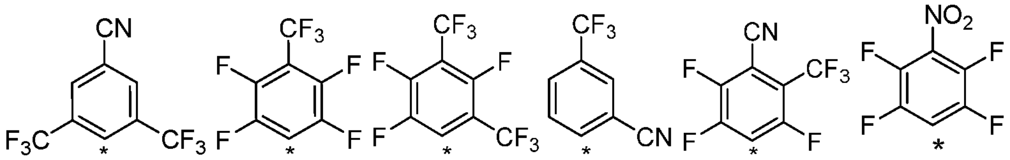

,

wherein the asterisk "*" denotes the binding position.

According to one embodiment, wherein in the first radialene compound of formula (I) $Ar^1$, $Ar^2$ and $Ar^3$ and/or in the second radialene compound of formula (II) $Er^1$, $Er^2$ and $Er^3$ are independently selected from one of the following groups:

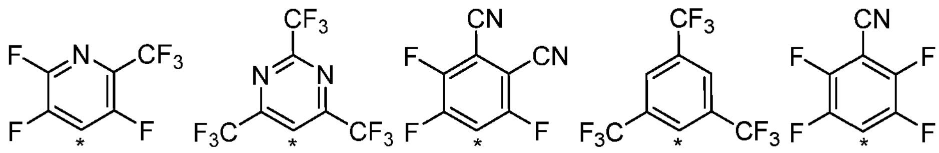

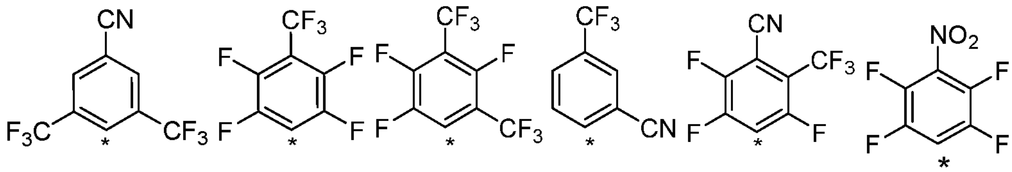

wherein the asterisk "*" denotes the binding position; and wherein each R' is selected from CN.

**First radialene compound of formula (I)**

According to one embodiment, wherein the first radialene compound of formula (I) is selected from one of the following compounds A1 to A8, wherein R' is selected from CN and $Ar^1$ of $A^1$, $Ar^2$ of $A^2$, and $Ar^3$ of $A^3$ are selected according to table 1.

Table 1

| Compound | $Ar^1$ of $A^1$ | $Ar^2$ of $A^2$ | $Ar^3$ of $A^3$ |
|---|---|---|---|
| A1 | 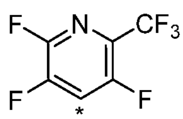 | 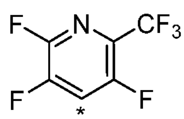 | 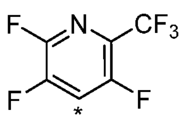 |
| A2 | 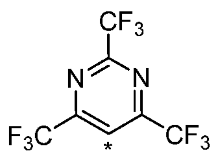 | 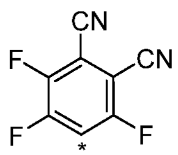 | 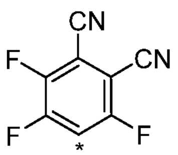 |
| A3 | 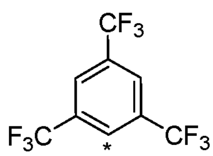 | 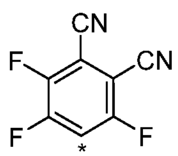 | 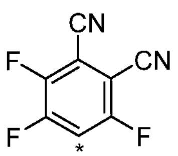 |

(continued)

| Compound | $Ar^1$ of $A^1$ | $Ar^2$ of $A^2$ | $Ar^3$ of $A^3$ |
|---|---|---|---|
| A4 | 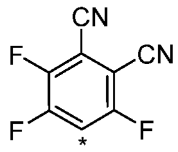 | 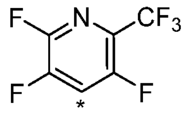 | 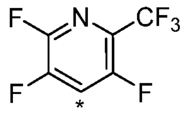 |
| A5 | 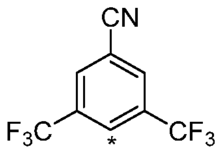 | 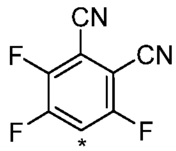 | 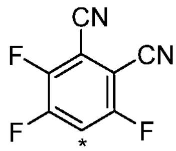 |
| A6 | 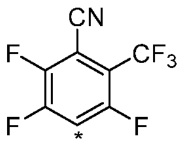 | 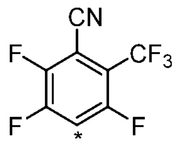 | 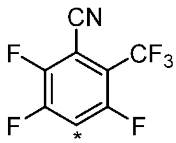 |
| A7 | 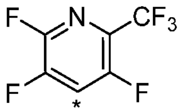 | 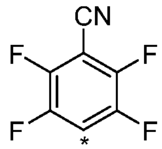 | 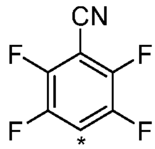 |
| A8 | 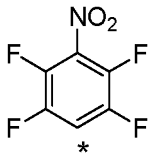 | 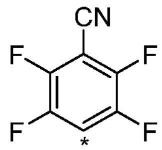 | 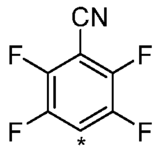 |

wherein the asterisk "*" denotes the binding position.

According to one embodiment, wherein the first radialene compound of formula (I) is preferably selected from one of the following compounds A1 to A4 and A8, wherein R' is selected from CN and $Ar^1$ of $A^1$, $Ar^2$ of $A^2$, and $Ar^3$ of $A^3$ are selected according to table 2.

Table 2

| Compounds | $Ar^1$ of $A^1$ | $Ar^2$ of $A^2$ | $Ar^3$ of $A^3$ |
|---|---|---|---|
| A1 | 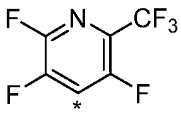 | 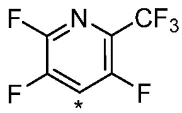 | 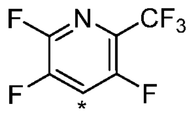 |
| A2 | 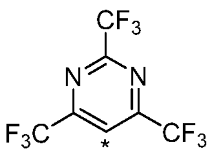 | 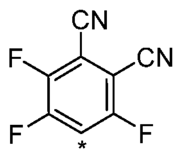 | 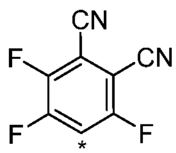 |
| A3 | 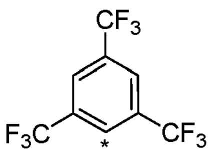 | 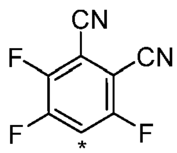 | 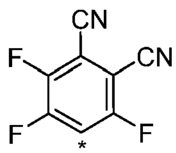 |

(continued)

| Compounds | $Ar^1$ of $A^1$ | $Ar^2$ of $A^2$ | $Ar^3$ of $A^3$ |
|---|---|---|---|
| A4 | 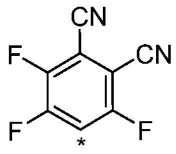 | 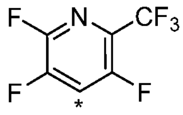 | 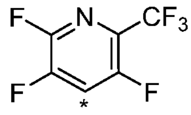 |
| A8 | 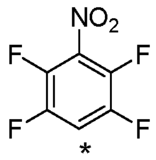 | 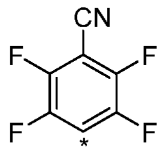 | 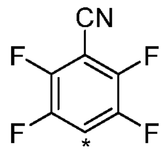 |

wherein the asterisk "*" denotes the binding position.

According to one embodiment, wherein the first radialene compound of formula (I) is preferably selected from one of the following compounds A1 to A4 and A8, wherein R' is selected from CN and $Ar^1$ of $A^1$, $Ar^2$ of $A^2$, and $Ar^3$ of $A^3$ are selected according to table 3.

Table 3

| Compounds | $Ar^1$ of $A^1$ | $Ar^2$ of $A^2$ | $Ar^3$ of $A^3$ |
|---|---|---|---|
| A1 | 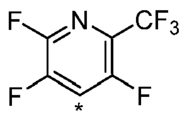 | 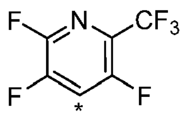 | 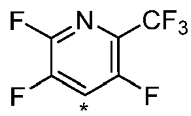 |
| A2 | 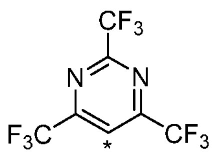 | 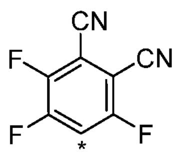 | 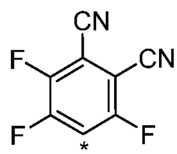 |
| A3 | 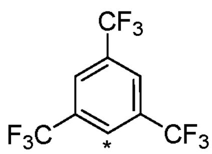 | 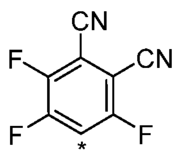 | 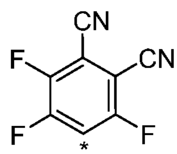 |

wherein the asterisk "*" denotes the binding position.

**Second radialene compound of formula (II)**

According to one embodiment, wherein the second radialene compound of formula (II) is selected from one of the following compounds B1 to B14, wherein R" is selected from CN and $Er^1$ of $B^1$, $Er^2$ of $B^2$, and $Er^3$ of $B^3$ are selected according to table 4.

Table 4

| Compound | $Ar^1$ of $A^1$ | $Ar^2$ of $A^2$ | $Ar^3$ of $A^3$ |
|---|---|---|---|
| B1 | 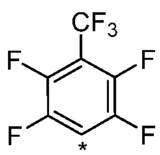 | 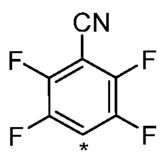 | 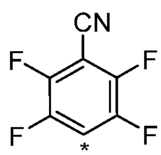 |

(continued)

| Compound | $Ar^1$ of $A^1$ | $Ar^2$ of $A^2$ | $Ar^3$ of $A^3$ |
|---|---|---|---|
| B2 | 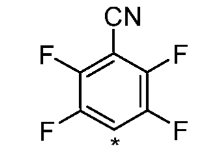 | 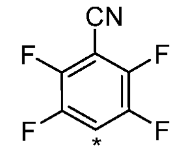 | 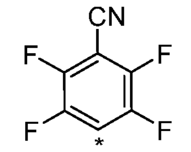 |
| B3 | 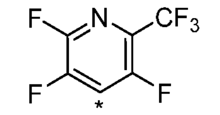 | 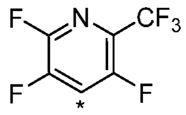 | 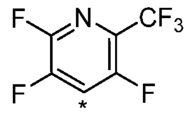 |
| B4 | 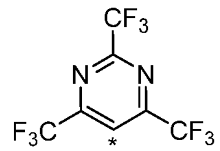 | 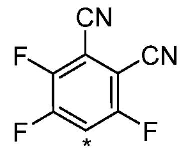 | 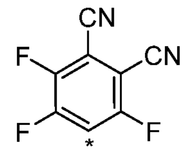 |
| B5 | 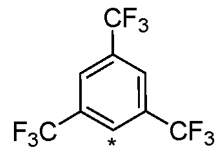 | 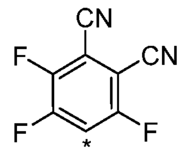 | 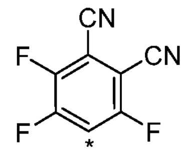 |
| B6 | 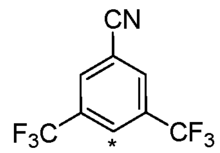 | 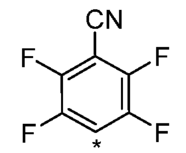 | 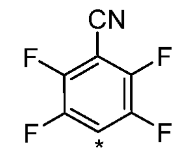 |
| B7 | 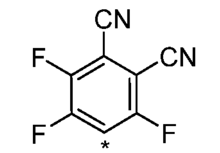 | 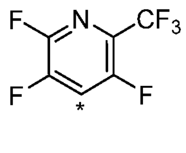 | 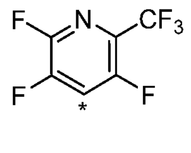 |
| B8 | 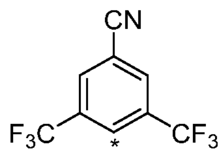 | 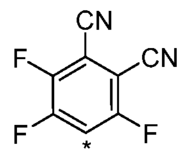 | 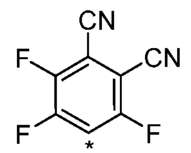 |
| B9 | 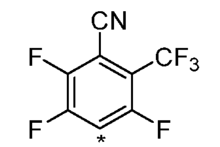 | 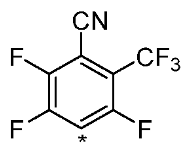 | 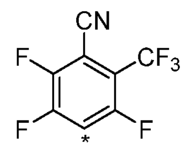 |
| B10 | 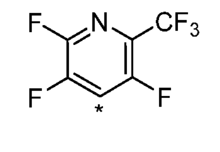 | 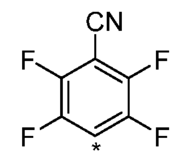 | 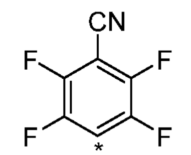 |
| B11 | 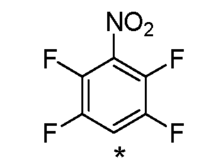 | 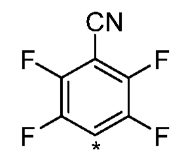 | 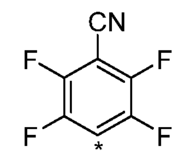 |

(continued)

| Compound | $Ar^1$ of $A^1$ | $Ar^2$ of $A^2$ | $Ar^3$ of $A^3$ |
|---|---|---|---|
| B12 | 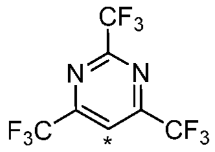 | 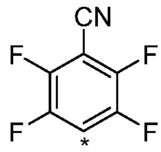 | 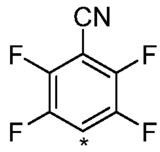 |
| B13 | 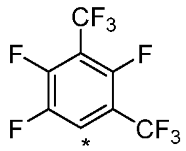 | 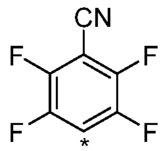 | 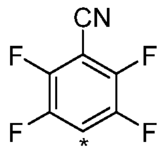 |
| B14 | 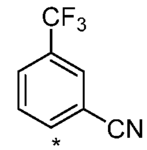 | 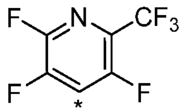 | 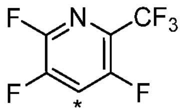 |

wherein the asterisk "*" denotes the binding position.

According to one embodiment, wherein the second radialene compound of formula (II) is preferably selected from one of the following compounds B2 to B5, and B7 to B12, wherein R" is selected from CN and $Er^1$ of $B^1$, $Er^2$ of $B^2$, and $Er^3$ of $B^3$ are selected according to table 5.

Table 5

| Compound | $Ar^1$ of $A^1$ | $Ar^2$ of $A^2$ | $Ar^3$ of $A^3$ |
|---|---|---|---|
| B2 | 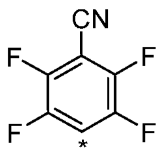 | 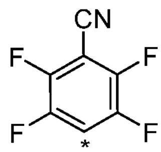 | 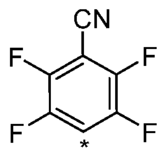 |
| B3 | 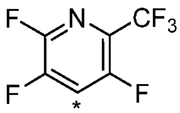 | 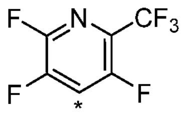 | 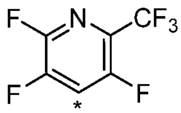 |
| B4 | 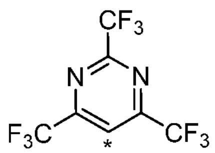 | 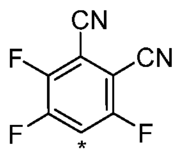 | 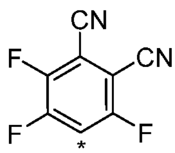 |
| B5 | 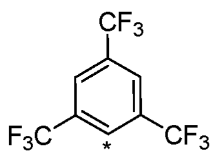 | 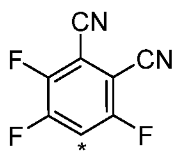 | 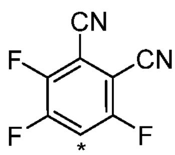 |
| B7 | 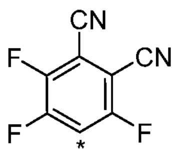 | 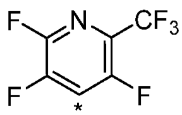 | 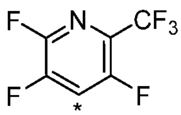 |

(continued)

| Compound | $Ar^1$ of $A^1$ | $Ar^2$ of $A^2$ | $Ar^3$ of $A^3$ |
|---|---|---|---|
| B8 | 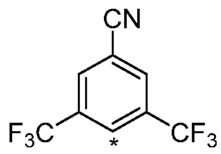 | 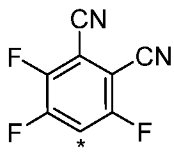 | 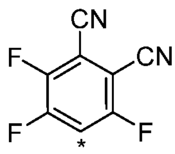 |
| B9 | 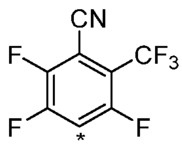 | 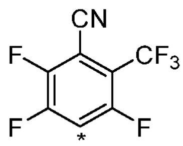 | 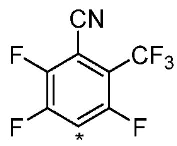 |
| B10 | 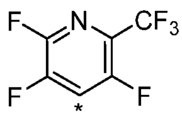 | 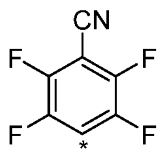 | 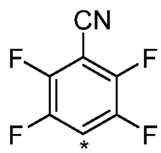 |
| B11 | 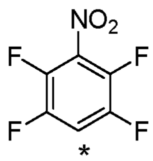 | 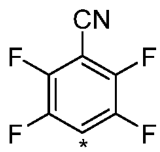 | 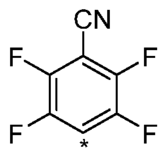 |
| B12 | 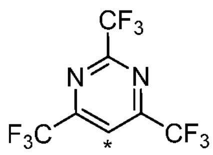 | 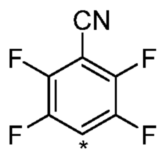 | 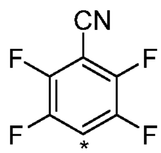 |

wherein the asterisk "*" denotes the binding position.

According to one embodiment, wherein the second radialene compound of formula (II) is preferably selected from one of the following compounds B2 to B5, and B7 to B12, wherein R" is selected from CN and $Er^1$ of $B^1$, $Er^2$ of $B^2$, and $Er^3$ of $B^3$ are selected according to table 6.

Table 6

| Compound | $Ar^1$ of $A^1$ | $Ar^2$ of $A^2$ | $Ar^3$ of $A^3$ |
|---|---|---|---|
| B3 | 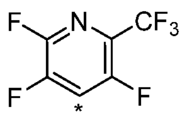 | 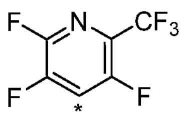 | 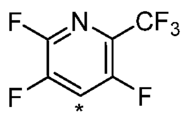 |
| B4 | 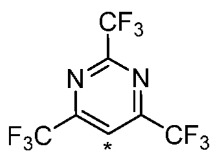 | 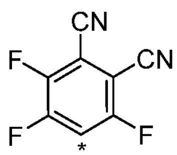 | 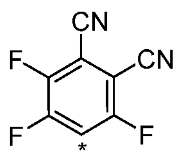 |
| B5 | 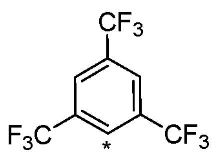 | 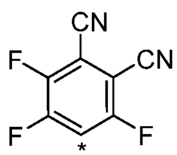 | 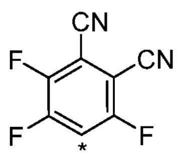 |

wherein the asterisk "*" denotes the binding position.

**Formula (III)**

According to one embodiment, wherein in the first radialene compound of formula (I) $Ar^1$, $Ar^2$ and $Ar^3$ and/or in the second radialene compound of formula (II) $Er^1$, $Er^2$ and $Er^3$ are independently selected from a group according to the following formula (III), and wherein preferably each R' and/or R" is selected from CN:

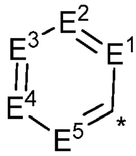

(III)

wherein

$E^1$ is selected from $CW^1$ or N;
$E^2$ is selected from $CW^2$ or N;
$E^3$ is selected from $CW^3$ or N;
$E^4$ is selected from $CW^4$ or N;
$E^5$ is selected from $CW^5$ or N;
$W^1$, $W^2$, $W^3$, $W^4$ and $W^5$ are independently selected from electron-withdrawing group, CN, halogen, Cl, F, $NO_2$, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_6$ alkoxy, $OCF_3$, substituted or unsubstituted $C_6$ to $C_{30}$ aryl, substituted or unsubstituted $C_3$ to $C_{30}$ heteroaryl, D or H,
wherein the one or more substituents of $W^1$, $W^2$, $W^3$, $W^4$ and $W^5$ is independently selected from D, halogen, Cl, F, CN, $NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
wherein the asterisk "*" denotes the binding position.

According to one embodiment, wherein in the first radialene compound of formula (I) $Ar^1$, $Ar^2$ and $Ar^3$ are independently selected from a group according to the following formula (III), and wherein preferably each R' and/or R" is selected from CN:

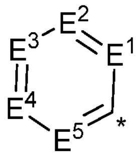

(III)

wherein

$E^1$ is selected from $CW^1$ or N;
$E^2$ is selected from $CW^2$ or N;
$E^3$ is selected from $CW^3$ or N;
$E^4$ is selected from $CW^4$ or N;
$E^5$ is selected from $CW^5$ or N;
$W^1$, $W^2$, $W^3$, $W^4$ and $W^5$ are independently selected from electron-withdrawing group, CN, halogen, Cl, F, $NO_2$, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_6$ alkoxy, $OCF_3$, substituted or unsubstituted $C_6$ to $C_{30}$ aryl, substituted or unsubstituted $C_3$ to $C_{30}$ heteroaryl, D or H,
wherein the one or more substituents of $W^1$, $W^2$, $W^3$, $W^4$ and $W^5$ is independently selected from D, halogen, Cl, F, CN, $NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
wherein the asterisk "*" denotes the binding position.

According to one embodiment, wherein in the second radialene compound of formula (II) $Er^1$, $Er^2$ and $Er^3$ are independently selected from a group according to the following formula (III), and wherein preferably each R' and/or R" is selected from CN:

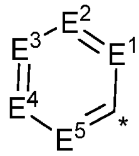

(III)

wherein

$E^1$ is selected from $CW^1$ or N;
$E^2$ is selected from $CW^2$ or N;
$E^3$ is selected from $CW^3$ or N;
$E^4$ is selected from $CW^4$ or N;
$E^5$ is selected from $CW^5$ or N;
$W^1$, $W^2$, $W^3$, $W^4$ and $W^5$ are independently selected from electron-withdrawing group, CN, halogen, Cl, F, $NO_2$, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_6$ alkoxy, $OCF_3$, substituted or unsubstituted $C_6$ to $C_{30}$ aryl, substituted or unsubstituted $C_3$ to $C_{30}$ heteroaryl, D or H,
wherein the one or more substituents of $W^1$, $W^2$, $W^3$, $W^4$ and $W^5$ is independently selected from D, halogen, Cl, F, CN, $NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
wherein the asterisk "*" denotes the binding position.

According to one embodiment, wherein in formula (III) $W^1$, $W^2$, $W^3$, $W^4$ and $W^5$ are independently selected from electron-withdrawing group, CN, halogen, Cl, F, $NO_2$, partially fluorinated or perfluorinated $C_1$ to $C_8$ alkyl, $CF_3$, partially fluorinated or perfluorinated $C_1$ to $C_6$ alkoxy, $OCF_3$, D or H, and preferably each R' and/or R" is CN.

**Formulas (IVa) to (IVh)**

According to one embodiment, wherein the compound of the first radialene compound of formula (I) and the compound of the second radialene compound of formula (II) are independently represented by one of the following formulae (IVa) to (IVh):

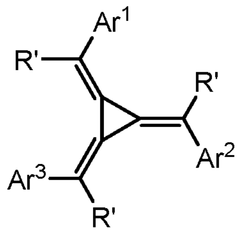

(IVa),

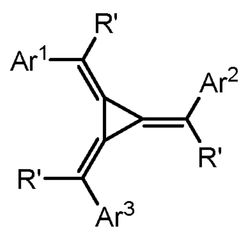

(IVe),

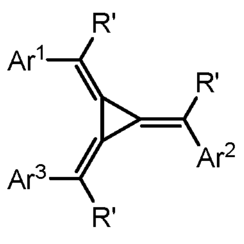

(IVb),

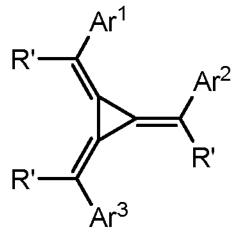

(IVf),

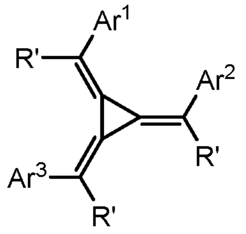

(IVc),

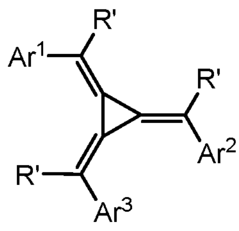

(IVg),

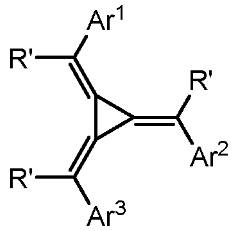

(IVd),

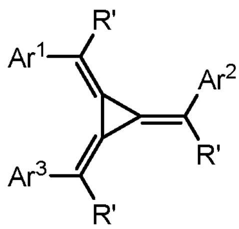

(IVh),

wherein $Ar^1$, $Ar^2$, $Ar^3$, and R' are independently selected from halogen, F and CN, and preferably CN.

According to one embodiment, wherein the compound of the first radialene compound of formula (I) and the compound of the second radialene compound of formula (II) are independently represented by one of the formulae (IVa) to (IVh), wherein $Ar^1$, $Ar^2$, $Ar^3$, and R' are independently selected from halogen, F and CN, and preferably CN; and wherein the first radialene compound of formula (I) and the second radialene compound of formula (II) are selected different from each other.

According to one embodiment, the organic electroluminescent device comprises as compound of formula (I) a mixture of at least two compounds selected from formulae (IVa) to (IVh) as defined above.

According to one embodiment, the organic electroluminescent device comprises as compound of formula (I) a mixture of at least two compounds selected from formulae (IVa) to (IVh) as defined above.

**First hole transport matrix compound**

According to one embodiment, wherein the first hole transport matrix compound is a covalent matrix compound and preferably the first hole transport matrix compound is a substantially covalent matrix compound.

According to one embodiment, the hole injection layer comprises the first hole transport matrix compound.

The first hole transport matrix compound is a covalent matrix compound may be selected from at least one organic compound. The covalent matrix compound and preferably the substantially covalent matrix may consists substantially from covalently bound C, H, O, N, S, which optionally comprise in addition covalently bound B, P, As and/or Se.

According to one embodiment, the covalent matrix compound and preferably the substantially covalent matrix may be selected from organic compounds consisting substantially from covalently bound C, H, O, N, S, which optionally comprise in addition covalently bound B, P, As and/or Se.

Organometallic compounds comprising covalent bonds carbon-metal, metal complexes comprising organic ligands and metal salts of organic acids are further examples of organic compounds that may serve as covalent matrix compounds and preferably as substantially covalent matrix compounds of the hole injection layer.

In one embodiment, the covalent matrix compound and preferably the substantially covalent matrix compound lacks metal atoms and majority of its skeletal atoms may be selected from C, O, S, N. Alternatively, the covalent matrix compound and preferably the substantially covalent matrix compound lacks metal atoms and majority of its skeletal atoms may be selected from C and N.

According to one embodiment, the covalent matrix compound and preferably the substantially covalent matrix compound may have a molecular weight Mw of $\geq 400$ and $\leq 2000$ g/mol, preferably a molecular weight Mw of $\geq 450$ and $\leq 1500$ g/mol, further preferred a molecular weight Mw of $\geq 500$ and $\leq 1000$ g/mol, in addition preferred a molecular weight Mw of $\geq 550$ and $\leq 900$ g/mol, also preferred a molecular weight Mw of $\geq 600$ and $\leq 800$ g/mol.

Preferably, the covalent matrix compound and preferably the substantially covalent matrix compound comprises at least one arylamine moiety, alternatively a diarylamine moiety, alternatively a triarylamine moiety.

Preferably, the covalent matrix compound and preferably the substantially covalent matrix compound is free of metals and/or ionic bonds.

According to one embodiment, wherein the first hole transport matrix compound is present in the hole injection layer in an amount of ≥0.1 wt.-%, preferably ≥1 wt.-%, more preferably ≥5 wt.-%, more preferably ≥10 wt.-%, more preferably ≥20 wt.-%, more preferably ≥30 wt.-%, more preferably ≥40 wt.-%, more preferably ≥50 wt.-%, more preferably ≥60 wt.-%, more preferably ≥70 wt.-%, more preferably ≥80 wt.-%, more preferably ≥90 wt.-%, more preferably ≥95 wt.-%, more preferably ≥97.0 wt.-%, more preferably ≥97.25 wt.-%, more preferably ≥97.5 wt.-%, more preferably ≥97.75 wt.-% and most preferably ≥98.0 wt.-%, based on the total weight of the hole injection layer.

According to one embodiment, wherein the first hole transport matrix compound, preferably of the hole injection layer, has a calculated HOMO energy level in the range of ≤ -4.27 eV to ≥ -5.1 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably in the range of < - 4.3 eV and > -5.0 eV, further preferred in the range of < -4.5 eV and > -5.0 eV, also preferred in the range of < -4.5 eV and > -4.9 eV, an in addition preferred in the range of < -4.6 eV and > -4.9 eV.

According to one embodiment, wherein the first hole transport matrix compound of the hole injection layer and the second hole transport matrix compound of the p-type charge generation layer may be selected the same.

### Second hole transport matrix compound

According to one embodiment, wherein the second hole transport matrix compound is a covalent matrix compound and preferably the second hole transport matrix compound is a substantially covalent matrix compound.

According to one embodiment, the p-type charge generation layer comprises the second hole transport matrix compound.

The second hole transport matrix compound is a covalent matrix compound may be selected from at least one organic compound. The covalent matrix compound and preferably the substantially covalent matrix may consists substantially from covalently bound C, H, O, N, S, which optionally comprise in addition covalently bound B, P, As and/or Se.

According to one embodiment, the covalent matrix compound and preferably the substantially covalent matrix may be selected from organic compounds consisting substantially from covalently bound C, H, O, N, S, which optionally comprise in addition covalently bound B, P, As and/or Se.

Organometallic compounds comprising covalent bonds carbon-metal, metal complexes comprising organic ligands and metal salts of organic acids are further examples of organic compounds that may serve as covalent matrix compounds and preferably as substantially covalent matrix compounds of the hole injection layer.

In one embodiment, the covalent matrix compound and preferably the substantially covalent matrix compound lacks metal atoms and majority of its skeletal atoms may be selected from C, O, S, N. Alternatively, the covalent matrix compound and preferably the substantially covalent matrix compound lacks metal atoms and majority of its skeletal atoms may be selected from C and N.

According to one embodiment, the covalent matrix compound and preferably the substantially covalent matrix compound may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

Preferably, the covalent matrix compound and preferably the substantially covalent matrix compound comprises at least one arylamine moiety, alternatively a diarylamine moiety, alternatively a triarylamine moiety.

Preferably, the covalent matrix compound and preferably the substantially covalent matrix compound is free of metals and/or ionic bonds.

According to one embodiment, wherein the second hole transport matrix compound is present in the p-type charge generation layer in an amount of ≥0.1 wt.-%, based on the total weight of the p-type charge generation layer, preferably ≥1 wt.-%, more preferably ≥5 wt.-%, more preferably ≥10 wt.-%, more preferably ≥20 wt.-%, more preferably ≥30 wt.-%, more preferably ≥40 wt.-%, more preferably ≥50 wt.-%, more preferably ≥60 wt.-%, more preferably ≥70 wt.-%, more preferably ≥80 wt.-%, more preferably ≥90 wt.-%, more preferably ≥95 wt.-%, based on the total weight of the p-type charge generation layer.

According to one embodiment, wherein the second hole transport matrix compound of formula (II) has a calculated LUMO energy level of ≤ -5.21 eV when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to one embodiment, wherein the second hole transport matrix compound of formula (II) has a calculated LUMO energy level in the range of ≤ -4.60 eV when calculated with the program package TURBOMOLE V6.5 (TURBOMOLE GmbH, Litzenhardtstrasse 19, 76135 Karlsruhe, Germany) by applying the hybrid functional B3LYP

with a 6-31G* basis set in the gas phase, more preferably ≤ -4.75 eV; further preferred ≤ -5.00 eV; also preferred ≤ -5.10 eV; in addition preferred ≤ -5.15 eV; more preferred ≤ -5.19 eV.

According to one embodiment, wherein the second hole transport matrix compound has a calculated HOMO energy level in the range of ≤ -4.27 eV to ≥ -5.1 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably in the range of < -4.3 eV and > -5.0 eV, further preferred in the range of < -4.5 eV and > -5.0 eV, also preferred in the range of < -4.5 eV and > -4.9 eV, in addition preferred in the range of < -4.6 eV and > -4.9 eV.

According to one embodiment, wherein the calculated LUMO energy level of the selected second radialene compound of formula (II) may be higher than the LUMO energy level of the first radialene compound of formula (I).

According to one embodiment, wherein the first hole transport matrix compound of the hole injection layer and the second hole transport matrix compound of the p-type charge generation layer may be selected the same.

**Compound of formula (VII) or a compound of formula (VIII)**

According to another aspect of the present invention, the covalent matrix compound or substantially covalent matrix compound, may comprises at least one arylamine compound, diarylamine compound, triarylamine compound, a compound of formula (VII) or a compound of formula (VIII):

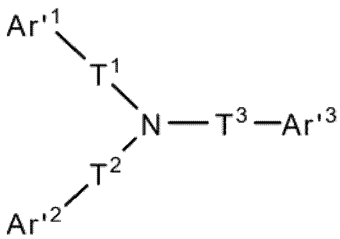 (VII), 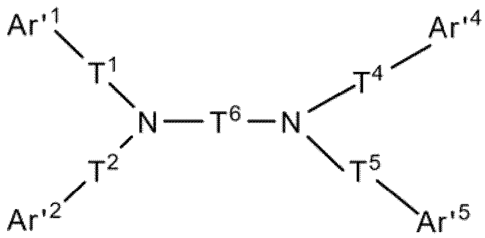 (VIII),

wherein:

$T^1$, $T^2$, $T^3$, $T^4$ and $T^5$ are independently selected from a single bond, phenylene, biphenylene, terphenylene or naphthenylene, preferably a single bond or phenylene;

$T^6$ is phenylene, biphenylene, terphenylene or naphthenylene;

$Ar'^1$, $Ar'^2$, $Ar'^3$, $Ar'^4$ and $Ar'^5$ are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;

wherein the substituents of $Ar'^1$, $Ar'^2$, $Ar'^3$, $Ar'^4$ and $Ar'^5$ are selected the same or different from the group comprising H, D, F, $C(=O)R'^2$, CN, $Si(R'^2)_3$, $P(=O)(R'^2)_2$, $OR'^2$, $S(=O)R'^2$, $S(=O)_2R'^2$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic

heterocycle, unsaturated 5- to 7-member ring of a non-heterocycle, and 6-member ring of an aromatic non-heterocycle,

wherein R'2 may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

According to an embodiment wherein $T^1$, $T^2$, $T^3$, $T^4$ and $T^5$ may be independently selected from a single bond, phenylene, biphenylene or terphenylene. According to an embodiment wherein $T^1$, $T^2$, $T^3$, $T^4$ and $T^5$ may be independently selected from phenylene, biphenylene or terphenylene and one of $T^1$, $T^2$, $T^3$, $T^4$ and $T^5$ are a single bond. According to an embodiment wherein $T^1$, $T^2$, $T^3$, $T^4$ and $T^5$ may be independently selected from phenylene or biphenylene and one of $T^1$, $T^2$, $T^3$, $T^4$ and $T^5$ are a single bond. According to an embodiment wherein $T^1$, $T^2$, $T^3$, $T^4$ and $T^5$ may be independently selected from phenylene or biphenylene and two of $T^1$, $T^2$, $T^3$, $T^4$ and $T^5$ are a single bond.

According to an embodiment wherein $T^1$, $T^2$ and $T^3$ may be independently selected from phenylene and one of $T^1$, $T^2$ and $T^3$ are a single bond. According to an embodiment wherein $T^1$, $T^2$ and $T^3$ may be independently selected from phenylene and two of $T^1$, $T^2$ and $T^3$ are a single bond.

According to an embodiment wherein $T^6$ may be phenylene, biphenylene, terphenylene. According to an embodiment wherein $T^6$ may be phenylene. According to an embodiment wherein $T^6$ may be biphenylene. According to an embodiment wherein $T^6$ may be terphenylene.

According to an embodiment wherein Ar'1, Ar'2, Ar'3, Ar'4 and Ar'5 may be independently selected from D1 to D16:

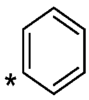 (D1), 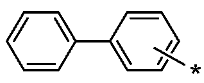 (D2), 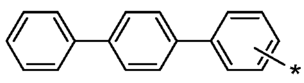 (D3), 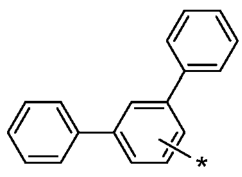 (D4),

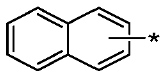 (D5), 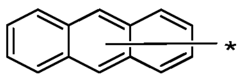 (D6), 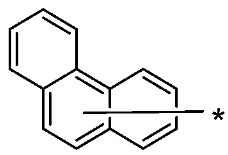 (D7), 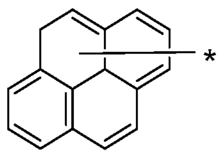 (D8),

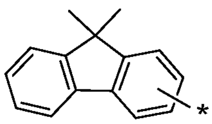 (D9), 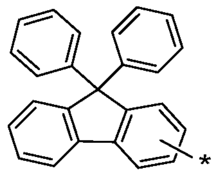 (D10), 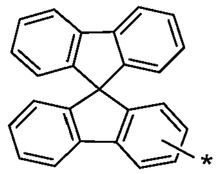 (D11),

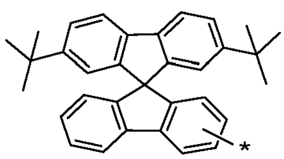 (D12), 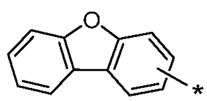 (D13), 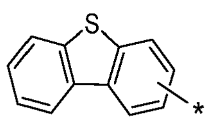 (D14),

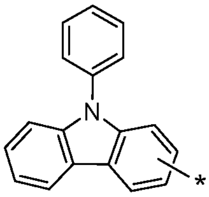 (D15), 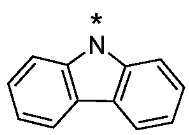 (D16),

wherein the asterix "*" denotes the binding position.

According to an embodiment, wherein Ar'$^1$, Ar'$^2$, Ar'$^3$, Ar'$^4$ and Ar'$^5$ may be independently selected from D1 to D15; alternatively selected from D1 to D10 and D13 to D15.

According to an embodiment, wherein Ar'$^1$, Ar'$^2$, Ar'$^3$, Ar'$^4$ and Ar'$^5$ may be independently selected from the group consisting of D1, D2, D5, D7, D9, D10, D13 to D16.

The rate onset temperature may be in a range particularly suited to mass production, when Ar'$^1$, Ar'$^2$, Ar'$^3$, Ar'$^4$ and Ar'$^5$ are selected in this range.

The "matrix compound of formula (VII) or formula (VIII)" may be also referred to as "hole transport compound".

According to one embodiment, the substantially covalent matrix compound comprises at least one naphthyl group, carbazole group, dibenzofuran group, dibenzothiophene group and/or substituted fluorenyl group, wherein the substituents are independently selected from methyl, phenyl or fluorenyl.

According to an embodiment of the electronic device, wherein the covalent matrix compound or substantially covalent matrix compound of formula (VII) or formula (VIII) are selected from F1 to F19:

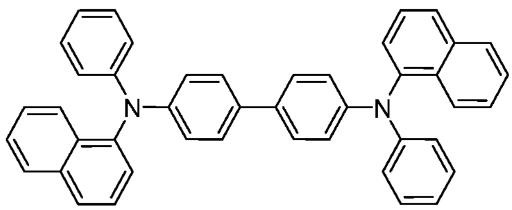
(F1),
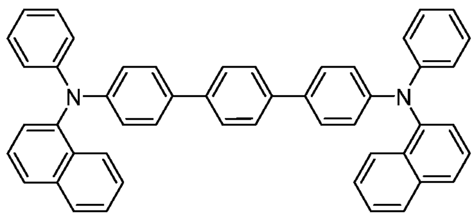
(F2),

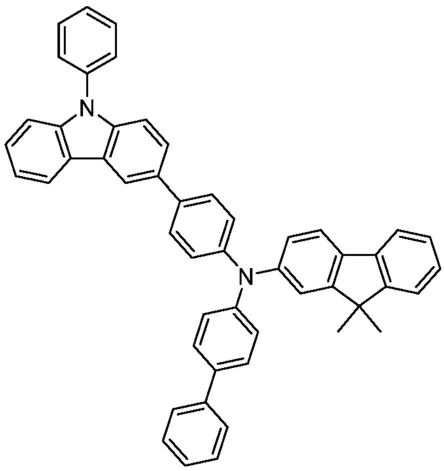
(F3),
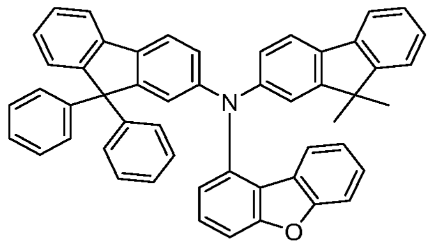
(F4),

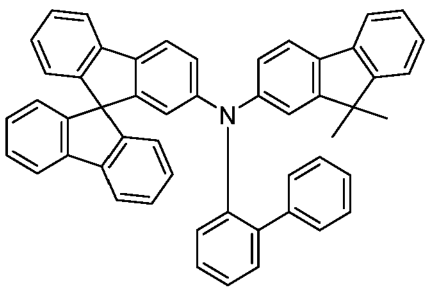
(F5),
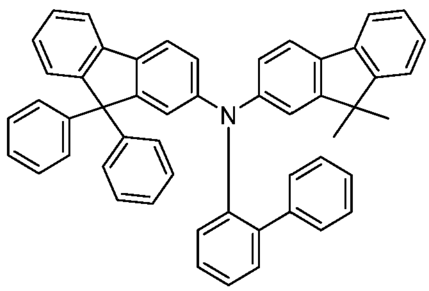
(F6),

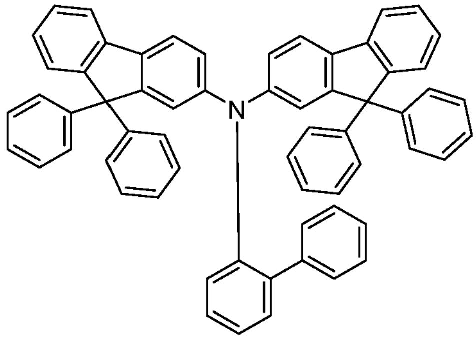 (F7), 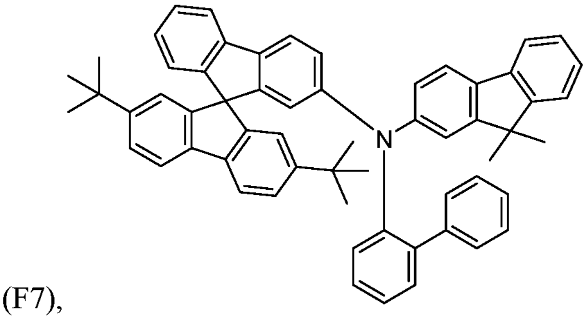 (F8),

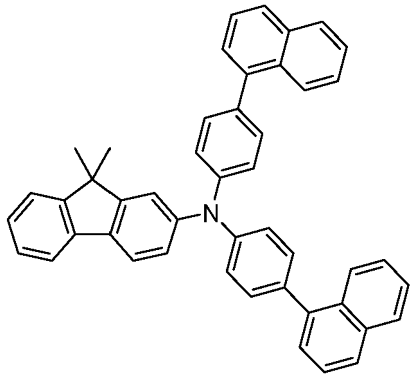 (F9), 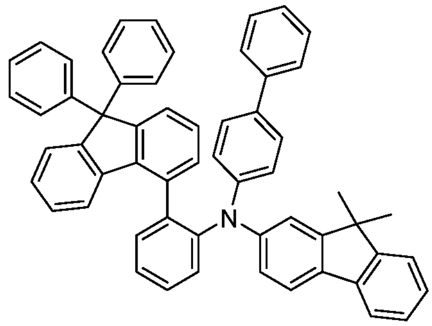 (F10),

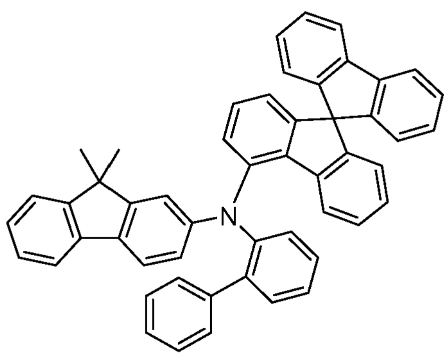 (F11), 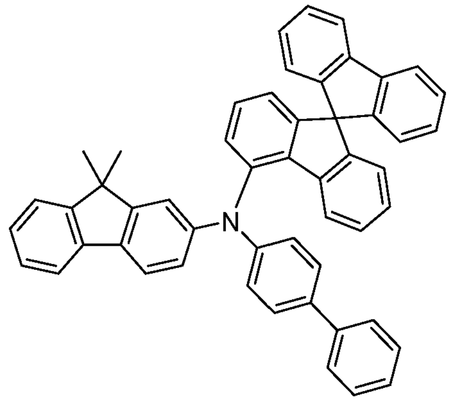 (F12),

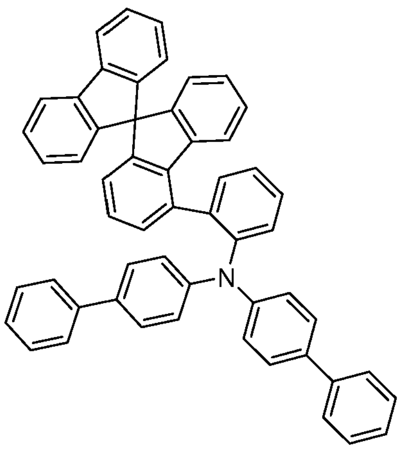 (F13), 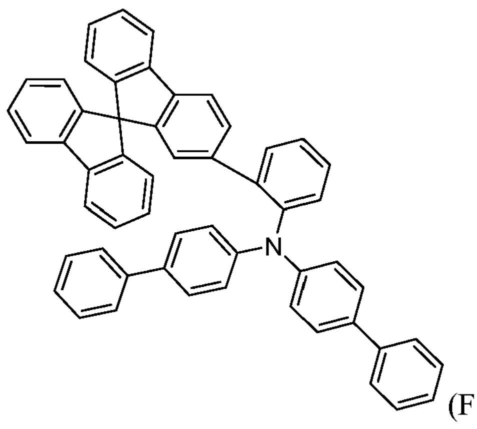 (F14),

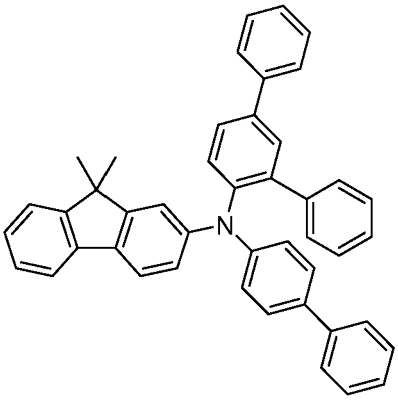 (F15),

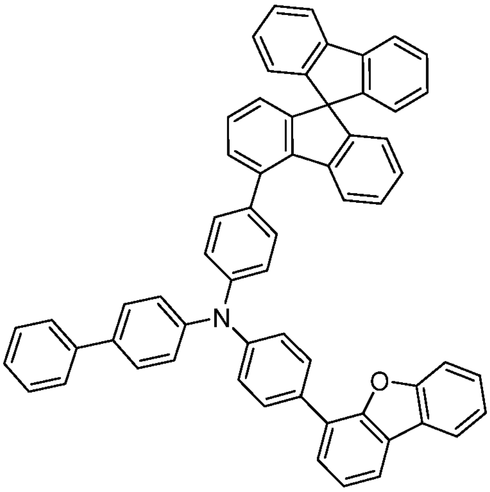 (F16),

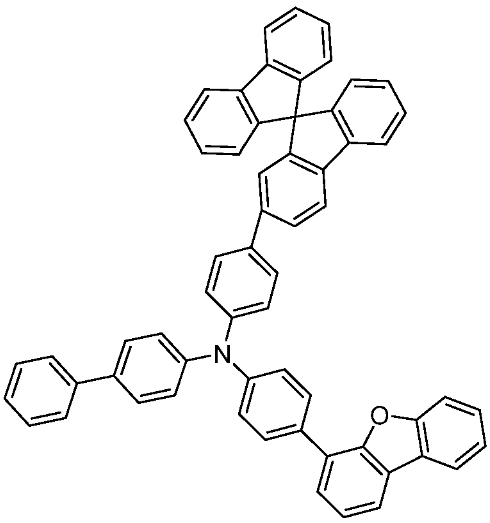 (F17)

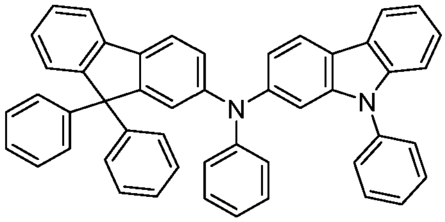 (F18),

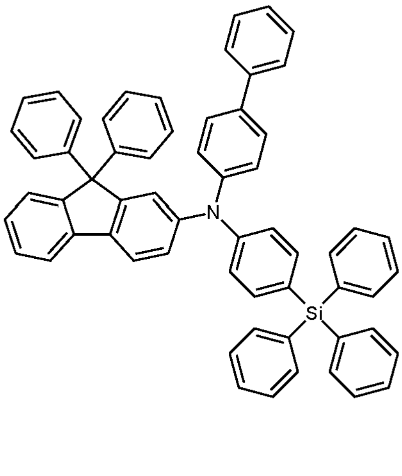 (F19).

Hole injection layer

According to one embodiment, the hole injection layer is also referred to as "organic semiconductor layer".

According to one embodiment, the hole injection layer is adjacent to the anode layer.

According to one embodiment, the hole injection layer is in direct contact to the anode layer.

A hole injection layer (HIL) may be formed on the anode layer by vacuum deposition, spin coating, printing, casting, slot-die coating, Langmuir-Blodgett (LB) deposition, or the like. When the HIL is formed using vacuum deposition,

the deposition conditions may vary according to the compound that is used to form the HIL, and the desired structure and thermal properties of the HIL. In general, however, conditions for vacuum deposition may include a deposition temperature of 100° C to 500° C, a pressure of $10^{-8}$ to $10^{-3}$ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

According to one embodiment, the hole injection layer further comprises an hole transport matrix compound, wherein the hole transport matrix compound can be an organic hole transport material.

According to one embodiment, the hole transport matrix compound can be a substantially covalent matrix compound.

According to one embodiment, the first radialene compound of formula (I) is present in the hole injection layer in an amount of ≤99.9 wt.-% based on the total weight of the hole injection layer, preferably ≤99 wt.-%, more preferably ≤95 wt.-%, more preferably ≤90 wt.-%, more preferably ≤80 wt.-%, more preferably ≤70 wt.-%, more preferably ≤60 wt.-%, more preferably ≤50 wt.-%, more preferably ≤40 wt.-%, more preferably ≤30 wt.-%, more preferably ≤20 wt.-%, more preferably ≤ 10 wt.-%, more preferably ≤ 5 wt.-%, more preferably ≤ 3.0 wt.-%, more preferably ≤ 2.75 wt.-%, more preferably ≤ 2.5 wt.-%, more preferably ≤ 2.25 wt.-%, and most preferably ≤ 2.0 wt.-%.

According to one embodiment, the first radialene compound of formula (I) is present in the hole injection layer in an amount of ≤99.9 wt.-% based on the total weight of the hole injection layer, preferably ≤99 wt.-%, more preferably ≤95 wt.-%, more preferably ≤90 wt.-%, more preferably ≤80 wt.-%, more preferably ≤70 wt.-%, more preferably ≤60 wt.-%, more preferably ≤50 wt.-%, more preferably ≤40 wt.-%, more preferably ≤30 wt.-%, more preferably ≤20 wt.-%, more preferably ≤ 10 wt.-%, more preferably ≤ 5 wt.-%, more preferably ≤ 3.0 wt.-%, more preferably ≤ 2.75 wt.-%, more preferably ≤ 2.5 wt.-%, more preferably ≤ 2.25 wt.-%, and most preferably ≤ 2.0 wt.-%; and the first hole transport matrix compound is present in the hole injection layer in an amount of ≥0.1 wt.-% based on the total weight of the hole injection layer, preferably ≥1 wt.-%, more preferably ≥5wt.-%, more preferably ≥10 wt.-%, more preferably ≥20 wt.-%, more preferably ≥30 wt.-%, more preferably ≥40 wt.-%, more preferably ≥50 wt.-%, more preferably ≥60 wt.-%, more preferably ≥70 wt.-%, more preferably ≥80 wt.-%, more preferably ≥90 wt.-%, more preferably ≥95 wt.-%, more preferably ≥97.0 wt.-%, more preferably ≥97.25 wt.-%, more preferably ≥97.5 wt.-%, more preferably ≥97.75 wt.-% and most preferably ≥98.0 wt.-%.

According to one embodiment, the first hole transport matrix compound is present in the hole injection layer in an amount of ≥0.1 wt.-% based on the total weight of the hole injection layer, preferably ≥1 wt.-%, more preferably ≥5wt.-%, more preferably ≥10 wt.-%, more preferably ≥20 wt.-%, more preferably ≥30 wt.-%, more preferably ≥40 wt.-%, more preferably ≥50 wt.-%, more preferably ≥60 wt.-%, more preferably ≥70 wt.-%, more preferably ≥80 wt.-%, more preferably ≥90 wt.-%, more preferably ≥95 wt.-%, more preferably ≥97.0 wt.-%, more preferably ≥97.25 wt.-%, more preferably ≥97.5 wt.-%, more preferably ≥97.75 wt.-% and most preferably ≥98.0 wt.-%.

**light-emitting unit**

According to one embodiment, at least one light-emitting unit, at least two light-emitting units comprises at least one electron transport layer, preferably each light-emitting unit.

According to one embodiment, at least one light-emitting unit comprises at least one hole transport layer, preferably each light-emitting unit comprises at least one hole transport layer.

According to one embodiment, at least one light-emitting unit comprises at least one electron transport layer and at least one hole transport layer, preferably each light-emitting unit comprises at least one electron transport layer and at least one hole transport layer.

According to one embodiment, at least one light-emitting unit comprises at least one electron transport layer and at least one hole transport layer, preferably each light-emitting unit comprises at least one electron transport layer and at least one hole transport layer, wherein the at least one hole transport layer is arranged closer to the anode than the at least one electron transport layer.

According to one embodiment, at least one light-emitting unit comprises at least one electron transport layer and at least one hole transport layer, preferably each light-emitting unit comprises at least one electron transport layer and at least one hole transport layer, wherein the at least one light-emitting layer is arranged between the at least one hole transport layer and the at least one electron transport layer, wherein preferably, the at least one hole transport layer is arranged closer to the anode than the at least one electron transport layer.

According to one embodiment, at least one light-emitting unit comprises an electron blocking layer and a hole

blocking layer, wherein the electron blocking layer is preferably arranged between the first hole transport layer and the at least one emission layer and the hole blocking layer is arranged between the first electron transport layer and the at least one emission layer.

**charge generation layer**

According to one embodiment, the at least one charge generation layer further comprises an n-type charge generation layer.

According to one embodiment, each of the at least one charge generation layer comprises an n-type charge generation layer

According to one embodiment, the n-type charge generation layer of the at least one charge generation layer is closer to the anode layer than the p-type charge generation layer of said at least one charge generation layer.

According to one embodiment, the n-type charge generation layer of the at least one charge generation layer is adjacent arranged to the p-type charge generation layer of said at least one charge generation layer.

According to one embodiment, the n-type charge generation layer of the at least one charge generation layer is in direct contact to the p-type charge generation layer of said at least one charge generation layer.

According to one embodiment, the n-type charge generation layer of each of the at least one charge generation layer is closer to the anode layer than the p-type charge generation layer of said at least one charge generation layer.

According to one embodiment, the n-type charge generation layer of each of the at least one charge generation layer is adjacent arranged to the p-type charge generation layer of said at least one charge generation layer.

According to one embodiment, the n-type charge generation layer of each of the at least one charge generation layer is in direct contact to the p-type charge generation layer of said at least one charge generation layer.

**n-type charge generation layer**

According to one embodiment, the charge generation layer comprises n-type charge generation layer.

According to one embodiment, the n-type charge generation layer of the at least one charge generation layer is adjacent to the at least one electron transport layer.

According to one embodiment, the n-type charge generation layer of the at least one charge generation layer is adjacent to the at least one electron transport layer and adjacent to the p-type charge generation layer of said at least one charge generation layer.

According to one embodiment, the n-type charge generation layer of the at least one charge generation layer is in direct contact to the at least one electron transport layer.

According to one embodiment, the n-type charge generation layer of the at least one charge generation layer is in direct contact to the at least one electron transport layer and adjacent to the p-type charge generation layer of said at least one charge generation layer.

According to one embodiment, the n-type charge generation layer of the at least one charge generation layer is in direct contact to the at least one electron transport layer and in direct contact to the p-type charge generation layer of said at least one charge generation layer.

According to one embodiment, the n-type charge generation layer of each of the at least one charge generation layer is adjacent to the at least one electron transport layer.

According to one embodiment, the n-type charge generation layer of each of the at least one charge generation layer is adjacent to the at least one electron transport layer and adjacent to the p-type charge generation layer of said at least one charge generation layer.

According to one embodiment, the n-type charge generation layer of each of the at least one charge generation layer is in direct contact to the at least one electron transport layer.

According to one embodiment, the n-type charge generation layer of each of the at least one charge generation layer is in direct contact to the at least one electron transport layer and adjacent to the p-type charge generation layer of said at least one charge generation layer.

According to one embodiment, the n-type charge generation layer is in direct contact to the p-type charge generation layer, wherein the n-type charge generation layer is closer to the anode layer than the p-type charge generation layer.

According to one embodiment, the n-type charge generation layer comprises a metal dopant.

According to one embodiment, the n-type charge generation layer comprises an electron transport matrix compound.

According to one embodiment, the electron transport matrix compound is an organic electron transport matrix compound.

According to one embodiment, the electron transport matrix compound is a substantially covalent matrix

compound.

According to one embodiment, the electron transport matrix compound is a substantially covalent organic matrix compound.

According to one embodiment, the n-type charge generation layer comprises a metal dopant and an electron transport matrix compound.

According to one embodiment, the n-type charge generation layer of each of the at least one charge generation layer is in direct contact to the at least one electron transport layer and in direct contact to the p-type charge generation layer of said at least one charge generation layer.

According to one embodiment, the n-type charge generation layer further comprises an electron transport material.

According to one embodiment, the n-type charge generation layer further comprises an organic electron transport material.

According to one embodiment, the electron transport material comprises at least one $C_2$ to $C_{24}$ N-heteroaryl or P=X group, with X being O, P, Se, with P=O especially preferred.

According to an embodiment of the present invention, the at least one $C_2$ to $C_{24}$ N-heteroaryl may be selected from a compound comprising at least one azine group, preferably at least two azine groups, also preferred three azine groups.

According to an embodiment of the present invention, the electron transport material comprises at least one group selected from the list consisting of pyridine, pyrimidine, triazine, imidazole, benzimidazole, benzoxazole, quinone, benzoquinone, imidazo[1,5-*a*]pyridine, quinoxaline, benzoquinoxaline, acridine, phenanthroline, benzoacridine, dibenzoacridine phosphine oxide, terpyridine.

According to an embodiment of the present invention, the electron transport material comprises at least one phenanthroline group, preferably two phenanthroline groups, one or more pyridine groups, one or more pyrimidine groups, one or more triazine groups, one or more imidazo[1,5-*a*]pyridine groups, or one or more phosphine oxide groups.

According to an embodiment of the present invention, the organic electron transport material comprises at least one phenanthroline group, preferably two phenanthroline groups, one or more pyridine groups, one or more pyrimidine groups, or one or more phosphine oxide groups.

According to an embodiment of the present invention, the electron transport material comprises at least one phenanthroline group, preferably two phenanthroline groups, a pyridine group, a pyrimidine groups, or a phosphine oxide group.

According to an embodiment of the present invention, the electron transport material compound comprises at least one phenanthroline group, preferably two phenanthroline groups, one or more pyridine groups, one or more pyrimidine groups, one or more triazine groups.

According to an embodiment of the present invention, the electron transport material is selected from the group comprising 2,2'-(1,3-Phenylene)bis[9-phenyl-1,10-phenanthroline], (3-(10-(3-(2,6-diphenylpyrimidin-4-yl)phenyl)anthracen-9-yl)phenyl)dimethylphosphine oxide, 3-(3-(9,10-diphenylanthracen-2-yl)phenyl)-1-(pyridin-2-yl)imidazo[1,5-a]pyridine, 7-(3-(1,10-phenanthrolin-2-yl)phenyl)dibenzo[c,h]acridine, 7-(3-([2,2':6',2"-terpyridin]-4'-yl)phenyl)dibenzo [c,h]acridine, 4'-(4'-(4,6-diphenyl-1,3,5-triazin-2-yl)-[1,1'-biphenyl]-4-yl)-2,2':6',2"-terpyridine, 4'-(4-(fluoranthen-3-yl) phenyl)-2,2':6',2"-terpyridine, or 3-(9,10-di-2-naphthalenyl-2-anthracenyl)phenyl]dimethyl phosphine oxide.

According to an embodiment of the present invention, the electron transport material comprises at least one phenanthroline group, preferably two phenanthroline groups.

According to an embodiment of the present invention, the n-type charge generation comprises a metal dopant.

According to one embodiment, the metal dopant is selected from a metal with an electronegativity of ≤ 1.4 eV by Pauling scale or a metal alloy comprising a metal with an electronegativity of ≤ 1.4 eV by Pauling scale.

According to one embodiment, the metal dopant is selected from a metal with an electronegativity of ≤ 1.35 eV by Pauling scale or a metal alloy comprising a metal with an electronegativity of ≤ 1.35 eV by Pauling scale.

According to one embodiment, the metal dopant is a metal selected from the group consisting of Li, Na, K, Rb, Cs, Mg, Ca, Sr, Ba, Sm, Eu and Yb or a metal alloy comprising a metal selected from the group consisting of Li, Na, K, Rb, Cs, Mg, Ca, Sr, Ba, Sm, Eu and Yb.

According to one embodiment, the metal dopant is a metal selected from the group consisting of Li, Na, K, Cs, Mg, Ca, Ba, Sm, Eu and Yb or a metal alloy comprising a metal selected from the group consisting of Li, Na, K, Cs, Mg, Ca, Ba, Sm, Eu and Yb.

According to one embodiment, the metal dopant is a metal selected from the group consisting of Li, Mg and Yb or a metal alloy comprising a metal selected from the group consisting of Li, Mg and Yb.

According to one embodiment, the metal dopant is a metal selected from the group consisting of Li and Yb or a metal alloy comprising a metal selected from the group consisting of Li, and Yb.

According to one embodiment, the metal dopant is Yb or a metal alloy comprising a metal selected from the group consisting of Li and Yb.

According to one embodiment, the metal dopant is Yb.

According to one embodiment, the metal dopant is present in the n-type charge generation layer in an amount of ≤99.9 wt.-% based on the total weight of the hole injection layer, preferably ≤99 wt.-%, more preferably ≤95 wt.-%, more preferably ≤90 wt.-%, more preferably ≤80 wt.-%, more preferably ≤70 wt.-%, more preferably ≤60 wt.-%, more preferably ≤50 wt.-%, more preferably ≤40 wt.-%, more preferably ≤30 wt.-%, more preferably ≤20 wt.-%, more preferably ≤ 10 wt.-%, more preferably ≤ 5 wt.-%, more preferably ≤ 3.0 wt.-%, more preferably ≤ 2.75 wt.-%, more preferably ≤ 2.5 wt.-%, more preferably ≤ 2.25 wt.-%, and most preferably ≤ 2.0 wt.-%.

According to one embodiment, the electron transport material is present in the n-type charge generation layer in an amount of ≥0.1 wt.-% based on the total weight of the hole injection layer, preferably ≥1 wt.-%, more preferably ≥5 wt.-%, more preferably ≥10 wt.-%, more preferably ≥20 wt.-%, more preferably ≥30 wt.-%, more preferably ≥40 wt.-%, more preferably ≥50 wt.-%, more preferably ≥60 wt.-%, more preferably ≥70 wt.-%, more preferably ≥80 wt.-%, more preferably ≥90 wt.-%, more preferably ≥95 wt.-%, more preferably ≥97.0 wt.-%, more preferably ≥97.25 wt.-%, more preferably ≥97.5 wt.-%, more preferably ≥97.75 wt.-% and most preferably ≥98.0 wt.-%.

**p-type charge generation layer**

The p-type charge generation layer may be formed on the n-type charge generation layer by vacuum deposition, spin coating, printing, casting, slot-die coating, Langmuir-Blodgett (LB) deposition, or the like. When the a p-type charge generation layer is formed using vacuum deposition, the deposition conditions may vary according to the compound(s) that are used to form the layer, and the desired structure and thermal properties of the layer. In general, however, conditions for vacuum deposition may include a deposition temperature of 100° C to 350° C, a pressure of $10^{-8}$ to $10^{-3}$ Torr (1 Torr equals 133.322 Pa), and a deposition rate of 0.1 to 10 nm/sec.

When the a p-type charge generation layer is formed using spin coating or printing, coating conditions may vary according to the compound(s) that are used to form the layer, and the desired structure and thermal properties of the p-type charge generation layer. For example, the coating conditions may include a coating speed of about 2000 rpm to about 5000 rpm, and a thermal treatment temperature of about 80° C to about 200° C. Thermal treatment removes a solvent after the coating is performed.

The thickness of the p-type charge generation layer may be in the range from about 1 nm to about 20 nm, and for example, from about 2 nm to about 15 nm, alternatively about 2 nm to about 12 nm.

According to one embodiment, the p-type charge generation layer of each of the at least one charge generation layer is adjacent to the n-type charge generation layer of said at least one charge generation layer.

According to one embodiment, the p-type charge generation layer of each of the at least one charge generation layer is in direct contact to the n-type charge generation layer of said at least one charge generation layer.

According to one embodiment, the p-type charge generation layer of each of the at least one charge generation layer is adjacent to the at least one hole transport layer.

According to one embodiment, the p-type charge generation layer of each of the at least one charge generation layer is in direct contact to the at least one hole transport layer.

According to one embodiment, the p-type charge generation layer of each of the at least one charge generation layer is adjacent to the n-type charge generation layer of said at least one charge generation layer and adjacent to the at least one hole transport layer.

According to one embodiment, the p-type charge generation layer of each of the at least one charge generation layer is in direct contact to the n-type charge generation layer of said at least one charge generation layer and in direct contact to the at least one hole transport layer.

According to one embodiment, the second radialene of formula (II) is present in the p-type charge generation layer in an amount of ≤99.9 wt.-% based on the total weight of the p-type charge generation layer, preferably ≤99 wt.-%, more preferably ≤95 wt.-%, more preferably ≤90 wt.-%, more preferably ≤80 wt.-%, more preferably ≤70 wt.-%, more preferably ≤60 wt.-%, more preferably ≤50 wt.-%, more preferably ≤40 wt.-%, more preferably ≤30 wt.-%, more preferably ≤20 wt.-%, more preferably ≤ 10 wt.-%, more preferably ≤ 5 wt.-%.

According to one embodiment, the second radialene of formula (II) is present in the p-type charge generation layer in an amount of ≤99.9 wt.-% based on the total weight of the p-type charge generation layer, preferably ≤99 wt.-%, more preferably ≤95 wt.-%, more preferably ≤90 wt.-%, more preferably ≤80 wt.-%, more preferably ≤70 wt.-%, more preferably ≤60 wt.-%, more preferably ≤50 wt.-%, more preferably ≤40 wt.-%, more preferably ≤30 wt.-%, more preferably ≤20 wt.-%, more preferably ≤ 10 wt.-%, more preferably ≤ 5 wt.-%, and the second hole transport matrix compound is present in the p-type charge generation layer in an amount of ≥0.1 wt.-% based on the total weight of the p-type charge generation layer, preferably ≥1 wt.-%, more preferably ≥5 wt.-%, more preferably ≥10 wt.-%, more preferably ≥20 wt.-%, more preferably ≥30 wt.-%, more preferably ≥40 wt.-%, more preferably ≥50 wt.-%, more preferably ≥60 wt.-%, more preferably ≥70 wt.-%, more preferably ≥80 wt.-%, more preferably ≥90 wt.-%, more preferably ≥95 wt.-%.

According to one embodiment, the second hole transport matrix compound is present in the p-type charge

generation layer in an amount of ≥0.1 wt.-% based on the total weight of the p-type charge generation layer, preferably ≥1 wt.-%, more preferably ≥5 wt.-%, more preferably ≥10 wt.-%, more preferably ≥20 wt.-%, more preferably ≥30 wt.-%, more preferably ≥40 wt.-%, more preferably ≥50 wt.-%, more preferably ≥60 wt.-%, more preferably ≥70 wt.-%, more preferably ≥80 wt.-%, more preferably ≥90 wt.-%, more preferably ≥95 wt.-%.

According to one embodiment, the p-type charge generation layer of the at least one charge generation layer is adjacent to the n-type charge generation layer of said at least one charge generation layer.

According to one embodiment, the p-type charge generation layer of the at least one charge generation layer is in direct contact to the n-type charge generation layer of said at least one charge generation layer.

According to one embodiment, wherein the second radialene compound of formula (II) in the p-type charge generation layer has a calculated LUMO energy level in the range of ≤ -5.00 eV to ≥ -5.75 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably ≤ -5.10 eV to ≥ - 5.70 eV; further preferred ≤ -5.15 eV to ≥ - 5.65 eV, also preferred ≤ -5.19 eV to ≥ - 5.65 eV, in addition preferred ≤ -5.20 eV to ≥ - 5.60 eV, more preferred ≤ -5.22 eV to ≥ - 5.55 eV, further more preferred ≤ -5.22 eV to ≥ - 5.50 eV, even more preferred ≤ -5.22 eV to ≥ - 5.45 eV.

## Further layers

In accordance with the invention, the organic electroluminescent device may comprise, besides the layers already mentioned above, further layers. Exemplary embodiments of respective layers are described in the following:

## Substrate

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate, a silicon substrate or a backplane.

## Anode layer

The anode layer may be formed by depositing or sputtering a material that is used to form the anode layer. The material used to form the anode layer may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode layer may also be formed using metals, typically silver (Ag), gold (Au), or metal alloys.

## Hole transport layer

The organic electroluminescent device may further comprise at least one hole transport layer (HTL). According to one embodiment, the at least one hole transport layer is comprised in one of the at least two light-emitting units, wherein preferably at least one hole transport layer is comprised in each light-emitting unit.

According to one embodiment, a hole transport layer is comprised in each of the at least two light-emitting units.

According to one embodiment, the p-type charge generation layer of at least one charge generation layer is adjacent to the at least one hole transport layer.

According to one embodiment, the p-type charge generation layer of at least one charge generation layer is in direct contact to the at least one hole transport layer.

According to one embodiment, the p-type charge generation layer of the at least one charge generation layer is adjacent to the n-type charge generation layer of said at least one charge generation layer and adjacent to the at least one hole transport layer.

According to one embodiment, the p-type charge generation layer of the at least one charge generation layer is in direct contact to the n-type charge generation layer of said at least one charge generation layer and in direct contact to the at least one hole transport layer.

A hole transport layer (HTL) may be formed on the HIL or CGL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL or CGL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

According to one embodiment, the hole transport layer may comprise a substantially covalent matrix compound as described above.

According to a preferred embodiment of the present invention, the hole injection layer and the hole transport layer may comprise an identical substantially covalent matrix compound as described above.

According to one embodiment, the hole transport layer may comprise a compound of formula (VII) or (VIII) as described above.

According to a preferred embodiment of the present invention, the hole injection layer and the hole transport layer may comprise an identical compound of formula (VII) or (VIII) as described above.

According to a preferred embodiment of the present invention, the p-type charge generation layer, the hole injection layer and the hole transport layer may comprise an identical substantially covalent matrix compound.

According to a preferred embodiment of the present invention, the p-type charge generation layer, the hole injection layer and the hole transport layer may comprise an identical an identical compound of formula (VII) or (VIII) as described above.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

**Electron blocking layer**

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

**Photoactive layer (PAL)**

According to an embodiment of the present invention, the organic electronic device may further comprise a photoactive layer, wherein the photoactive layer is arranged between the anode layer and the cathode layer.

However, according to a preferred embodiment the organic electronic device is free of a photoactive layer.

The photoactive layer converts an electrical current into photons or photons into an electrical current.

The PAL may be formed on the HTL by vacuum deposition, spin coating, slot-die coating, printing, casting, LB deposition, or the like. When the PAL is formed using vacuum deposition or spin coating, the conditions for deposition and coating may be similar to those for the formation of the HIL. However, the conditions for deposition and coating may vary, according to the compound that is used to form the PAL.

The photoactive layer may be a light-emitting layer or a light-absorbing layer, in particular a light-emitting layer.

Emission layer (EML)

According to an embodiment of the present invention, the organic electronic device may further comprise an emission layer, wherein the emission layer is arranged between the anode layer and the cathode layer.

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp) 3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetratert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

## Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and azine derivatives, preferably triazine or pyrimidine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

## Electron transport layer (ETL)

The organic electroluminescent device may further comprise at least one electron transport layer (ETL). According to one embodiment, the at least one electron transport layer is comprised in one of the at least two light-emitting units, wherein preferably at least one electron transport layer is comprised in each light-emitting unit.

According to one embodiment, each of the at least two light-emitting units comprises an electron transport layer.

According to one embodiment, the electron transport layer is free of metal dopant, particularly free of metal dopant in the oxidation state (0).

According to another embodiment of the present invention, the electron transport layer may further comprise an azine compound, preferably a pyridine, pyrimidine or triazine compound, and most preferably a triazine compound or a pyrimidine compound.

According to another embodiment of the present invention, the electron transport layer may further comprise 2-([1,1'-biphenyl]-4-yl)-4-(9,9-diphenyl-9H-fluoren-4-yl)-6-phenyl-1,3,5-triazine, 2-(3-(2,6-dimethylpyridin-3-yl)-5-(phenanthren-9-yl)phenyl)-4,6-diphenyl-1,3,5-triazine, 3'-(4-phenyl-6-(spiro[fluorene-9,9'-xanthen]-2'-yl)-1,3,5-triazin-2-yl)-[1,1'-biphenyl]-4-carbonitrile, and 4'-(4-(4-(4,6-diphenyl-1,3,5-triazin-2-yl)phenyl)naphthalen-1-yl)-[1,1'-biphenyl]-4-carbonitrile.

In one embodiment, the electron transport layer may further comprise a dopant selected from an alkali organic complex, preferably LiQ.

The thickness of the ETL may be in the range from about 15 nm to about 50 nm, for example, in the range from

about 20 nm to about 40 nm. When the thickness of the ETL is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer comprise an azine compound. Preferably, the azine compound is a pyridine, pyrimidine or triazine compound, and most preferably a triazine compound.

### Electron injection layer (EIL)

An optional EIL, which may facilitates injection of electrons from the cathode, may be formed on the ETL preferably closest to the cathode, and more preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

According to one embodiment, the organic electroluminescent device comprises at least one electron injection layer (EIL).

According to one embodiment, the electron injection layer is disposed on a light-emitting unit.

According to one embodiment, the electron injection layer is disposed on the light-emitting unit closest to the cathode of the organic electroluminescent device.

According to one embodiment, the electron injection layer is disposed between the light-emitting unit and the cathode closest to the cathode.

According to one embodiment, the electron injection layer is adjacent arranged to the light-emitting unit closest to the cathode.

According to one embodiment, the electron injection layer is disposed between the light-emitting unit and the cathode closest to the cathode, and is adjacent to the light-emitting unit closest to the cathode.

According to one embodiment, the electron injection layer is disposed between the light-emitting unit and the cathode closest to the cathode, and is adjacent to the cathode.

According to one embodiment, the electron injection layer is disposed between the light-emitting unit closest to the cathode and the cathode, and is adjacent to the light-emitting unit and the cathode closest to the cathode.

According to one embodiment, the electron injection layer is disposed between the light-emitting unit and the cathode closest to the cathode, and is in contact with the light-emitting unit and the cathode closest to the cathode.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

### Cathode layer

The cathode layer is formed on the ETL or optional EIL. The cathode layer may be formed of a metal, an alloy, an electrically conductive compound, or a mixture thereof. The cathode electrode may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO. According to a preferred embodiment, wherein the cathode layer is transparent.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

In a preferred embodiment, the cathode layer comprises a metal or metal alloy and is transparent.

It is to be understood that the cathode layer is not part of an electron injection layer or the electron transport layer.

### Electronic device

According to one embodiment, wherein an electronic device comprises an organic electroluminescent device.

According to one embodiment, wherein an electronic device comprises an organic electroluminescent device, wherein the electronic device is preferably a display device, a light emitting device, a thin film transistor, a battery, a display device or a photovoltaic device, and preferably a light emitting device, preferably the electronic device is part of a display device or lighting device.

## Description of the Drawings

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

FIG. 1 is a schematic sectional view of an organic electroluminescent device according to an exemplary embodiment.

FIG. 2 is a schematic sectional view of a stacked organic electroluminescent device according to another exemplary embodiment.

FIG. 3 is a schematic sectional view of a stacked organic electroluminescent device according to another exemplary embodiment.

FIG. 4 is a schematic sectional view of an anode layer 120 on a substrate 110.

Hereinafter, the figures are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

Fig. 1 is a schematic sectional view of an organic electroluminescent device 100, according to one exemplary embodiment of the present invention.

Referring to Fig. 1 the organic electroluminescent device 100 includes a substrate 110, an anode layer 120, a hole injection layer (HIL) 130 comprising the first radialene compound of formula (I) and a first hole transport matrix compound, and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145. The organic electroluminescent device 100 further comprising a first charge generation layer (CGL1) 150 comprising a first n-type charge generation layer (n-CGL1) 151 and a first p-type charge generation layer (p-GCL1) 152, wherein the first p-type charge generation layer (p-CGL1) 152 comprises the second radialene compound of formula (II) and a second hole transport matrix compound. The organic electronic device 100 further comprising, a second light-emitting unit 240, comprising a second hole transport layer (HTL2) 241, a second electron blocking layer (EBL2) 242, a second emission layer (EML2) 243, a second hole blocking layer (HBL2) 244, and a second electron transport layer (ETL2) 245. The organic electroluminescent device 100 further comprising and electron injection layer (EIL) 180, a cathode layer (CAT) 190.

Fig. 2 is a schematic sectional view of a stacked organic electroluminescent device 100, according to another exemplary embodiment of the present invention. Fig. 2 differs from Fig. 1 in that the organic electroluminescent device 100 of Fig. 1 further comprises a second charge generation layer (CGL2) 250 disposed on the second light-emitting unit 240, comprising a second n-type charge generation layer (n-CGL2) 251 and a second p-type charge generation layer (p-GCL2) 252, wherein the second p-type charge generation layer (p-CGL2) 252 may optionally also comprises the second radialene compound of formula (II) and a second hole transport matrix compound. Wherein the organic electroluminescent device 100 of Fig. 2 further differs from Fig. 1 in that it further comprises a third light-emitting unit 340 disposed on the second charge generation layer (CGL2) 250, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

Fig. 3 is a schematic sectional view of a stacked organic electroluminescent device 100, according to another exemplary embodiment of the present invention. Fig. 3 differs from Fig. 2 in that the organic electroluminescent device 100 of Fig. 2 further comprises a third charge generation layer (CGL3) 350 disposed on the third light-emitting unit 340, comprising a third n-type charge generation layer (n-CGL3) 351 and a third p-type charge generation layer (p-GCL3) 352, wherein the third p-type charge generation layer (p-CGL3) 352 may optionally also comprise the second radialene compound of formula (II) and a second hole transport matrix compound. Wherein the organic electroluminescent device 100 of Fig. 3 further differs from Fig. 2 in that it further comprises a fourth light-emitting unit 440 disposed on the third charge generation layer (CGL3) 350, comprising a fourth hole transport layer (HTL4) 441, a fourth electron blocking layer (EBL4)

442, a fourth emission layer (EML4) 443, a fourth hole blocking layer (HBL4) 444, and a fourth electron transport layer (ETL4) 445.

While not shown in Fig. 1, 2, and 3 a capping and/or a sealing layer may further be formed on the cathode layer 190, in order to seal the organic electronic device 100. In addition, various other modifications may be applied thereto.

FIG. 4 is a schematic sectional view of an anode layer 120 on a substrate 110.The anode layer 120 that comprises a first anode sub-layer 121, a second anode sub-layer 122 and a third anode sub-layer 123.

Hereinafter, one or more exemplary embodiments of the present invention will be described in detail with, reference to the following examples. However, these examples are not intended to limit the purpose and scope of the one or more exemplary embodiments of the present invention.

## Detailed description

The invention is furthermore illustrated by the following examples which are illustrative only and non-binding.

Compounds of formula (I) may be prepared as described in EP2180029A1 and WO2016097017A1.

Compounds of formula (II) may be prepared as for example described by in EP2180029A1 and WO2016097017A1.

Calculated HOMO and LUMO

The HOMO and LUMO are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.

General procedure for fabrication of OLEDs

Table 7 shows compounds used in the general fabrication of OLEDS.

Table 7

| | | |
|---|---|---|
| F3 | 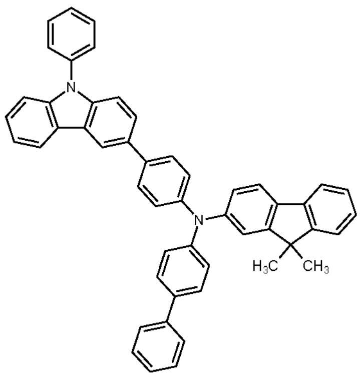 | (N-([1,1'-biphenyl]-4-yl)-9,9-dimethyl-N-(4-(9-phenyl-9H-carbazol-3-yl)phenyl)-9H-fluoren-2-amine) |
| F19 | 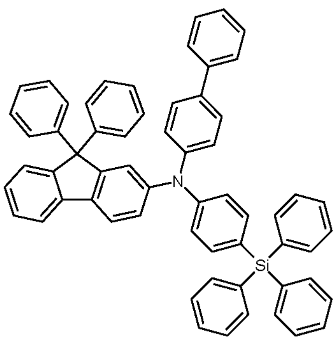 | N-([1,1'-biphenyl]-4-yl)-9,9-diphenyl-N-(4-(triphenylsilyl)phenyl)-9H-fluoren-2-amine |

(continued)

| | | |
|---|---|---|
| F20 | 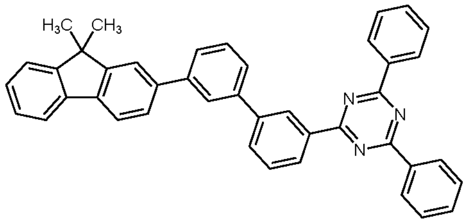 | 2-(3'-(9,9-dimethyl-9H-fluoren-2-yl)-[1,1'-biphenyl]-3-yl)-4,6-diphenyl-1,3,5-triazine |
| F21 | 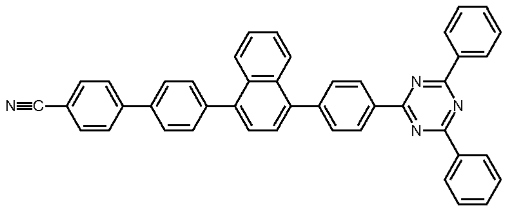 | 4'-(4-(4-(4,6-diphenyl-1,3,5-triazin-2-yl)phenyl)naphthalen-1-yl)-[1,1'-biphenyl]-4-carbonitrile |
| F22 | 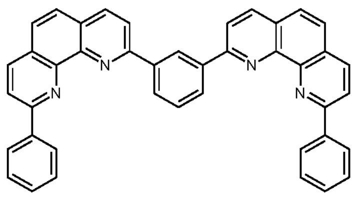 | 2,2'-(1,3-Phenylene)bis[9-phenyl-1,10-phenanthroline] |

For the Examples, a glass substrate with an anode layer comprising a first anode sub-layer of 120 nm Ag, a second anode sub-layer of 8 nm ITO and a third anode sub-layer of 10 nm ITO was cut to a size of 50 mm x 50 mm x 0.7 mm, ultrasonically washed with water for 60 minutes and then with isopropanol for 20 minutes. The liquid film was removed in a nitrogen stream, followed by plasma treatment, to prepare the anode layer. The plasma treatment was performed in nitrogen atmosphere or in an atmosphere comprising 98 vol.-% nitrogen and 2 vol.-% oxygen.

Then, a hole injection layer (HIL) having a thickness of 10 nm is formed on the anode layer by co-depositing 99 wt.-% of compound F3 (N-([1,1'-biphenyl]-4-yl)-9,9-dimethyl-N-(4-(9-phenyl-9H-carbazol-3-yl)phenyl)-9H-fluoren-2-amine) and 1 wt.-% of compound of formula (I) or comparative example according to Table 9.

Then, a first hole transport layer (HTL1) having a thickness of 27 nm is formed on the HIL by depositing compound F3 (N-([1,1'-biphenyl]-4-yl)-9,9-dimethyl-N-(4-(9-phenyl-9H-carbazol-3-yl)phenyl)-9H-fluoren-2-amine).

Then, a first electron blocking layer (EBL1) having a thickness of 5 nm is formed on the HTL1 by depositing compound F19 N-([1,1'-biphenyl]-4-yl)-9,9-diphenyl-N-(4-(triphenylsilyl)phenyl)-9H-fluoren-2-amine.

Then, a first emission layer (EML1) having a thickness of 20 nm is formed on the EBL1 by co-depositing 97 vol.-% H09 (Sun Fine Chemicals, Korea) as EML host and 3 vol.-% BD200 (Sun Fine Chemicals, Korea) as fluorescent blue dopant.

Then, a first hole blocking layer (HBL1) having a thickness of 5 nm is formed on the first emission layer by depositing compound F20 2-(3'-(9,9-dimethyl-9H-fluoren-2-yl)-[1,1'-biphenyl]-3-yl)-4,6-diphenyl-1,3,5-triazine.

Then, a first electron transport layer (ETL1) having a thickness of 20 nm is formed on the first emission layer by co-depositing compound F21 4'-(4-(4-(4,6-diphenyl-1,3,5-triazin-2-yl)phenyl)naphthalen-1-yl)-[1,1'-biphenyl]-4-carbonitrile and LiQ in a ratio of 50:50 wt.-%.

Then, the n-CGL having a thickness of 10 nm is formed on the ETL by co-depositing 99 vol.-% of compound F22 2,2'-(1,3-Phenylene)bis[9-phenyl-1,10-phenanthroline] and 1 vol.-% Yb.

Then, the p-CGL having a thickness of 10 nm is formed on the n-CGL by co-depositing 93 wt.-% of compound F3 (N-([1,1'-biphenyl]-4-yl)-9,9-dimethyl-N-(4-(9-phenyl-9H-carbazol-3-yl)phenyl)-9H-fluoren-2-amine) as a matrix compound and 7 wt.-% of a compound of formula (II) or comparative example according to Table 9. The composition of the p-CGL can be seen in Tables 8 and 9.

Then, a second hole transport layer (HTL2) having a thickness of 24 nm is formed on the p-CGL by depositing F3 (N-([1,1'-biphenyl]-4-yl)-9,9-dimethyl-N-(4-(9-phenyl-9H-carbazol-3-yl)phenyl)-9H-fluoren-2-amine).

Then, a second electron blocking layer (EBL2) having a thickness of 5 nm is formed on the HTL2 by depositing compound F19 N-([1,1'-biphenyl]-4-yl)-9,9-diphenyl-N-(4-(triphenylsilyl)phenyl)-9H-fluoren-2-amine.

Then, a second emission layer (EML2) having a thickness of 20 nm is formed on the EBL2 by co-depositing 97 vol.-% H09 (Sun Fine Chemicals, Korea) as EML host and 3 vol.-% BD200 (Sun Fine Chemicals, Korea) as fluorescent blue dopant.

Then, a second hole blocking layer (HBL2) having a thickness of 5 nm is formed on the EML2 by depositing compound 20 2-(3'-(9,9-dimethyl-9H-fluoren-2-yl)-[1,1'-biphenyl]-3-yl)-4,6-diphenyl-1,3,5-triazine.

Then, a second electron transport layer (ETL2) having a thickness of 30 nm is formed on the HBL by co-depositing compound 21 4'-(4-(4-(4,6-diphenyl-1,3,5-triazin-2-yl)phenyl)-naphthalen-1-yl)-[1,1'-biphenyl]-4-carbonitrile and LiQ in a ratio of 50:50 wt.-%.

Then, an electron injection layer (EIL) having a thickness of 2 nm is formed on the ETL2 by depositing Yb.

Then, the cathode layer having a thickness of 13 nm is formed on the EIL by co-depositing Ag:Mg (90:10 vol.-%) at a rate of 0.01 to 1 Å/s at $10^{-7}$ mbar.

Then, a capping layer having a thickness of 75 nm is formed on the cathode layer by depositing compound F3 (N-([1,1'-biphenyl]-4-yl)-9,9-dimethyl-N-(4-(9-phenyl-9H-carbazol-3-yl)phenyl)-9H-fluoren-2-amine).

The OLED stack is protected from ambient conditions by encapsulation of the device with a glass slide. Thereby, a cavity is formed, which includes a getter material for further protection.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/$m^2$ using an Instrument Systems CAS-140CT array spectrometer (calibrated by Deutsche Akkreditierungsstelle (DAkkS)) for each of the voltage values. The cd/A efficiency at 15 mA/cm2 is determined by interpolating the luminance-voltage and current-voltage characteristics, respectively.

In bottom emission devices, the emission is predominately Lambertian and quantified in percent external quantum efficiency (EQE). To determine the efficiency EQE in % the light output of the device is measured using a calibrated photodiode at 15 mA/cm2.

In top emission devices, the emission is forward directed, non-Lambertian and also highly dependent on the mirco-cavity. Therefore, the efficiency EQE will be higher compared to bottom emission devices. To determine the efficiency EQE in % the light output of the device is measured using a calibrated photodiode at 15 mA/$cm^2$.

Lifetime LT of the device is measured at ambient conditions (20°C) and 30 mA/$cm^2$, using a Keithley 2400 source meter, and recorded in hours.

The brightness of the device is measured using a calibrated photo diode. The lifetime LT is defined as the time till the brightness of the device is reduced to 97 % of its initial value.

The increase in operating voltage ΔU is used as a measure of the operational voltage stability of the device.

This increase is also determined during the LT measurement and by subtracting the operating voltage after 1 hour after the start of operation of the device from the operating voltage after 100 hours.

$$\Delta U=[U100\ h)-\ U(1h)]$$

The smaller the value of ΔU the better is the operating voltage stability.

Technical Effect of the invention

Table 1: Calculated LUMO of compounds

The LUMO energies are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.

Compound of formula (I) or formula (II), selected from one of the following compounds P1 to P15
wherein R' is selected from CN and $Ar^1$ of $A^1$, $Ar^2$ of $A^2$, and $Ar^3$ of $A^3$ are selected according to the following Table 8:

Table 8

| Compounds used in the examples with respective LUMO level. | | | | |
|---|---|---|---|---|
| Compound | $Ar^1$ of $A^1$ | $Ar^2$ of $A^2$ | $Ar^3$ of $A^3$ | LUMO [eV] DFT |
| P-1 | 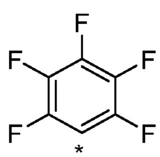 | 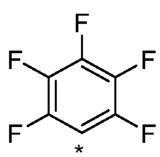 | 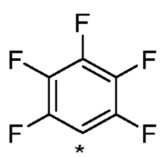 | -4.57 |

(continued)

| Compounds used in the examples with respective LUMO level. | | | | |
|---|---|---|---|---|
| Compound | $Ar^1$ of $A^1$ | $Ar^2$ of $A^2$ | $Ar^3$ of $A^3$ | LUMO [eV] DFT |
| P-2 | 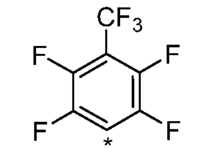 | 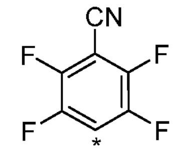 | 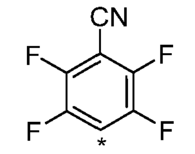 | -5.10 |
| P-3 | 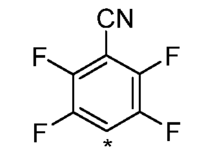 | 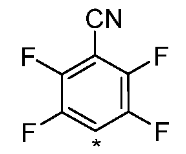 | 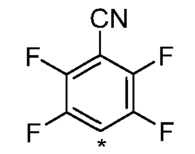 | -5.19 |
| P-4 | 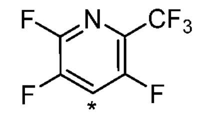 | 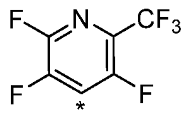 | 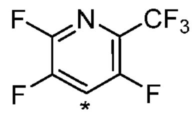 | -5.29 |
| P-5 | 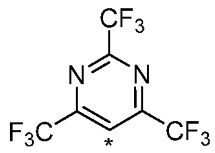 | 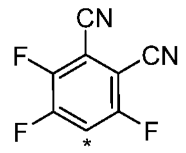 | 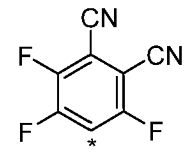 | -5.44 |
| P-6 | 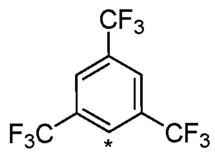 | 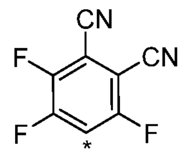 | 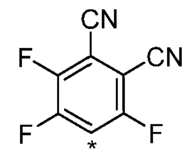 | -5.22 |
| P-7 | 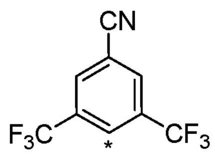 | 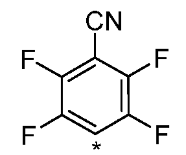 | 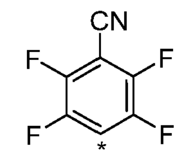 | -5.07 |
| P-8 | 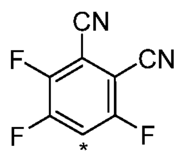 | 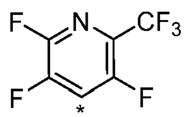 | 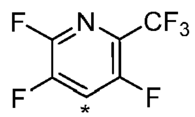 | -5.34 |
| P-9 | 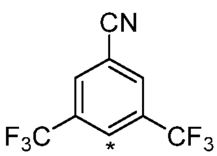 | 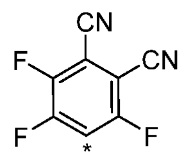 | 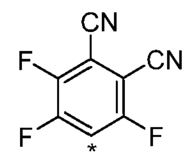 | -5.32 |
| P-10 | 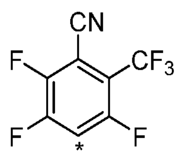 | 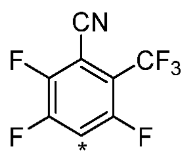 | 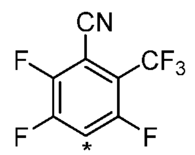 | -5.32 |
| P-11 | 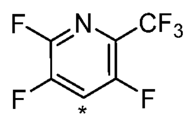 | 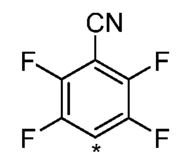 | 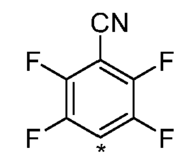 | -5.23 |

(continued)

| Compounds used in the examples with respective LUMO level. | | | | |
|---|---|---|---|---|
| Compound | $Ar^1$ of $A^1$ | $Ar^2$ of $A^2$ | $Ar^3$ of $A^3$ | LUMO [eV] DFT |
| P-12 | 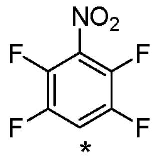 | 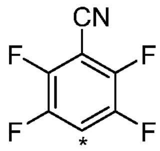 | 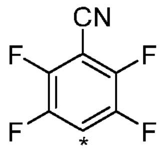 | -5.21 |
| P-13 | 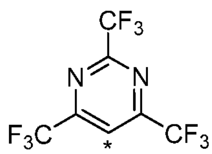 | 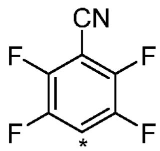 | 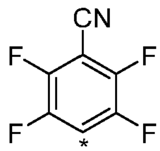 | -5.19 |
| P-14 | 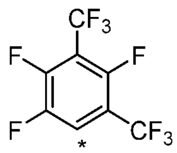 | 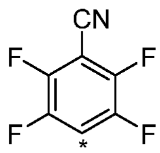 | 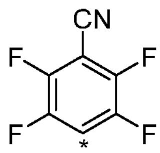 | -5.10 |
| P-15 | 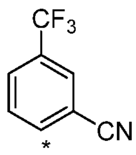 | 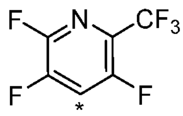 | 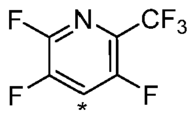 | -5.12 |

wherein the asterisk "*" denotes the binding position.

Table 9: Experimental data.

| | Hole injection layer | p-Type charge generation layer | Voltage at $15mA/cm^2$ [V] | Ceff at $15mA/cm^2$ [cd/A] | Vrise (1-100h) at $30mA/cm^2$ [V] |
|---|---|---|---|---|---|
| Comp. ex. 1 | P-2 | P-2 | 7.72 | 12.2 | 0.454 |
| Comp. ex. 2 | P-1 | P-2 | 7.88 | 12.1 | 1.422 |
| Comp. ex. 3 | P-2 | P-4 | 7.62 | 12.2 | 0.429 |
| Inv. ex. 1 | P-6 | P-4 | 7.62 | 12.2 | 0.178 |
| Inv. ex. 2 | P-5 | P-4 | 7.61 | 12.1 | 0.168 |
| Inv. ex. 3 | P-6 | P-2 | 7.63 | 12.3 | 0.157 |
| Inv. ex. 4 | P-5 | P-2 | 7.62 | 12.7 | 0.122 |
| Inv. ex. 5 | P-4 | P-2 | 7.63 | 12.4 | 0.124 |
| Inv. ex. 6 | P-4 | P-6 | 7.60 | 12.4 | 0.135 |
| Inv. ex. 7 | P-4 | P-5 | 7.56 | 12.8 | 0.117 |

The inventive examples 1 to 7 of Table 9 exhibit a lower operational voltage than the comparative examples 1 to 2 of Table 9.

The use of the same dopant in the hole injection layer and p-type charge generation layer (comparative example 1) exhibit a higher operational voltage than the inventive examples 1 to 7, wherein the hole transport layer and the p-type charge generation do not contain the same p-dopant.

When the LUMO energy level of the p-dopant in the hole injection layer (comparative example 2) is increased compared to comparative example 1, the operational voltage even increases compared to comparative example 1.

A lower operating voltage may be important for reduced power consumption and improved battery life, in particular in mobile devices.

The inventive examples 1 to 7 exhibit a lower voltage rise over time than the comparative examples 1 to 3.
The use of the same dopant in the hole injection layer and in the p-type charge generation layer (comparative example 1) exhibit a higher voltage rise over time than the inventive examples 1 to 7, wherein the hole transport layer and the p-type charge generation do not contain the same p-dopant.
When the LUMO energy level of the p-dopant in the hole injection layer (comparative example 2) is increased compared to comparative example 2, the voltage rise over time also increases.
Moreover, when the LUMO energy level of the p-dopant in the p-type charge generation layer is reduced, the voltage rise over time even increases compared to comparative example 1.
However, when the LUMO energy level of the radialene in the hole injection layer is lower than the LUMO energy level of the radialene of the comparative example 1 to 3, the voltage rise over time can be lowered, and thus improved remarkably.
It is known by the skilled person in the art that the stability is decreased at layers with more interfaces, the voltage rise is determined by the layers with more interfaces. Since the CGL contains a n-CGL and p-CGL, it is assumed by the skilled person in the art that the CGL is the important factor for influencing the voltage rise over time.
Thus, it could surprisingly be demonstrated that a radialene having a lower LUMO as p-dopant in the hole injection layer has an effect on the voltage rise over time which is even higher than the use of a radialene having a lower LUMO in the p-type charge generation layer.
A low voltage rise over time may result in improved long-term stability of electronic devices.

## Claims

**1.** An organic electroluminescent device comprising an anode layer, a cathode layer, a hole injection layer, at least two light-emitting units, and at least one charge generation layer, wherein at least one charge generation layer comprises a p-type charge generation layer;

wherein each light-emitting unit comprises at least one light-emitting layer,
wherein each of the at least one charge generation layer is disposed independently between a set of two adjacent light-emitting units of the at least two light-emitting units;
wherein the hole injection layer is arranged closer to the anode layer than the p-type charge generation layer;
wherein the hole injection layer comprises a first radialene compound of formula (I) and a first hole transport matrix compound, wherein the first radialene compound of formula (I) is represented by:

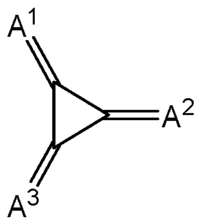
(I),

wherein in the first radialene compound of formula (I):

$A^1$ is independently selected from a group of formula (Ia):

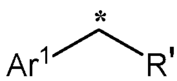
(Ia),

wherein
$Ar^1$ is independently selected from substituted or unsubstituted $C_6$ to $C_{36}$ aryl, and substituted or unsubstituted $C_2$ to $C_{36}$ heteroaryl; wherein
one or more of the substituents of $Ar^1$ are independently selected from the group comprising D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl; wherein

the one or more substituents of the $C_6$ to $C_{30}$ aryl, $C_6$ to $C_{30}$ heteroaryl, $C_1$ to $C_8$ alkyl, and $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$A^2$ is independently selected from a group of formula (Ib):

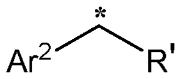 (Ib),

wherein

$Ar^2$ is independently selected from substituted or unsubstituted $C_6$ to $C_{36}$ aryl, and substituted or unsubstituted $C_2$ to $C_{36}$ heteroaryl; wherein

one or more of the substituents of $Ar^2$ are independently selected from the group comprising D, an electron-withdrawing group, halogen, Cl, F, CN, $NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl; wherein

the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$A^3$ is independently selected from a group of formula (Ic):

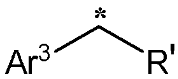 (Ic),

wherein

$Ar^3$ is independently selected from substituted or unsubstituted $C_6$ to $C_{36}$ aryl, and substituted or unsubstituted $C_2$ to $C_{36}$ heteroaryl; wherein

one or more of the substituents of $Ar^3$ are independently selected from the group comprising D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl, wherein

the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

in $A^1$, $A^2$, and $A^3$ each R' is independently selected from substituted or unsubstituted $C_6$ to $C_{18}$ aryl, substituted or unsubstituted $C_3$ to $C_{18}$ heteroaryl, electron-withdrawing group, substituted or unsubstituted $C_1$ to $C_8$ alkyl, partially fluorinated $C_1$ to $C_8$ alkyl, perfluorinated $C_1$ to $C_8$ alkyl, halogen, F and CN; wherein

one or more of the substituents of $C_6$ to $C_{18}$ aryl, $C_6$ to $C_{18}$ heteroaryl, $C_1$ to $C_8$ alkyl, are independently selected from D, an electron-withdrawing group, halogen, Cl, F, CN, $-NO_2$, partially fluorinated $C_1$ to $C_6$ alkyl, perfluorinated $C_1$ to $C_6$ alkyl, partially fluorinated $C_1$ to $C_6$ alkoxy, perfluorinated $C_1$ to $C_6$ alkoxy;

wherein

the first radialene compound of formula (I) has a LUMO energy level of ≤ -5.20 eV when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase;

wherein

the p-type charge generation layer comprises a second radialene compound of formula (II) and a second hole transport matrix compound; and

wherein the second radialene compound of formula (II) is represented by:

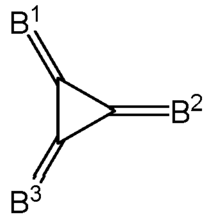
(II),

wherein in the second radialene compound of formula (II):

$B^1$ is independently selected from a group of formula (IIa):

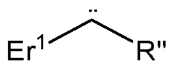
(IIa),

wherein
$Er^1$ is independently selected from substituted or unsubstituted $C_6$ to $C_{36}$ aryl, and substituted or unsubstituted $C_2$ to $C_{36}$ heteroaryl; wherein
one or more of the substituents of $Er^1$ are independently selected from the group comprising D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
$B^2$ is independently selected from a group of formula (IIb):

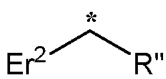
(IIb),

wherein
$Er^2$ is independently selected from substituted or unsubstituted $C_6$ to $C_{36}$ aryl, and substituted or unsubstituted $C_2$ to $C_{36}$ heteroaryl; wherein
one or more of the substituents of $Er^2$ are independently selected from the group comprising D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and; wherein
the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
$B^3$ is independently selected from a group of formula (Ic):

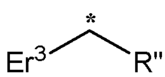
(IIc),

wherein
$Er^3$ is independently selected from substituted or unsubstituted $C_6$ to $C_{36}$ aryl, and substituted or unsubstituted $C_2$ to $C_{36}$ heteroaryl; wherein
one or more of the substituents of $Er^3$ are independently selected from the group comprising D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

in $B^1$, $B^2$, and $B^3$ each R" is independently selected from substituted or unsubstituted $C_6$ to $C_{18}$ aryl, substituted or unsubstituted $C_3$ to $C_{18}$ heteroaryl, electron-withdrawing group, substituted or unsubstituted $C_1$ to $C_8$ alkyl, partially fluorinated $C_1$ to $C_8$ alkyl, perfluorinated $C_1$ to $C_8$ alkyl, halogen, F and CN;
wherein the one or more substituents of $C_6$ to $C_{18}$ aryl, $C_6$ to $C_{18}$ heteroaryl, $C_1$ to $C_8$ alkyl, are independently selected from D, an electron-withdrawing group, halogen, Cl, F, CN, $-NO_2$, partially fluorinated $C_1$ to $C_6$ alkyl, perfluorinated $C_1$ to $C_6$ alkyl, partially fluorinated $C_1$ to $C_6$ alkoxy, perfluorinated $C_1$ to $C_6$ alkoxy;
wherein
the first radialene compound of formula (I) and the second radialene compound of formula (II) are selected different from each other; and

wherein the asterisk "*" denotes the binding position.

**2.** The organic electroluminescent device according to claim 1, wherein the organic electroluminescent device comprises at least three light-emitting units, and at least two charge generation layers, wherein each of the at least two charge generation layers are disposed independently between one set of two adjacent light-emitting units of the at least three light-emitting units; or the organic electroluminescent device comprises at least four light-emitting units, and at least three charge generation layers, wherein each of the at least three charge generation layers are disposed independently between one set of two adjacent light-emitting units of the at least four light-emitting units.

**3.** The organic electroluminescent device according to any one of claim 1 to 2, wherein the hole injection layer is in direct contact to the anode layer.

**4.** The organic electroluminescent device according to any one of claims 1 to 3, wherein the organic electroluminescent device comprises further a hole transport layer, wherein the hole transport layer is arranged adjacent to the hole injection layer, and preferably the hole transport layer is arranged between a light-emitting unit and the hole injection layer.

**5.** The organic electroluminescent device according to any one of claims 1 to 4, wherein the at least one charge generation layer further comprises an n-type charge generation layer.

**6.** The organic electroluminescent device according to any one of claims 1 to 5 wherein the p-type charge generation layer of the at least one charge generation layer is arranged in direct contact to the n-type charge generation layer of the at least one charge generation layer.

**7.** The organic electroluminescent device according to any one of claims 1 to 6, wherein at least one light-emitting unit or all light-emitting units comprises in addition to an emission layer further a hole transport layer, an electron blocking layer, a hole blocking layer and an electron transport layer.

**8.** The organic electroluminescent device according to any one of claims 1 to 7, wherein in the first radialene compound of formula (I) and formula (II), R' and R" are independently selected from halogen, F and CN, and preferably CN.

**9.** The organic electroluminescent device according to any one of claims 1 to 8, wherein in the first radialene compound of formula (I), at least two of $A^1$, $A^{2,}$ and $A^3$ are selected the same; and/or in the second radialene compound of formula (II), at least two of $B^1$, $B^{2,}$ and $B^3$ are selected the same.

**10.** The organic electroluminescent device according to any one of claims 1 to 9, wherein in the first radialene compound of formula (I) $Ar^1$, $Ar^2$ and $Ar^3$ and/or in the second radialene compound of formula (II) $Er^1$, $Er^2$ and $Er^3$ are independently selected from one of the following groups of B1 to B64:

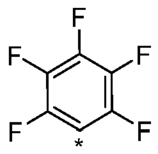 (B1), 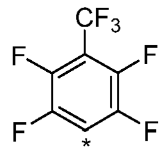 (B2), 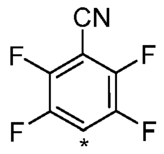 (B3), 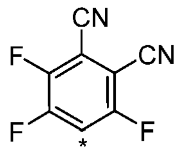 (B4), 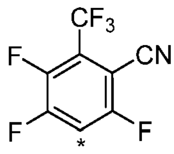 (B5),

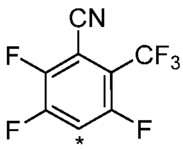 (B6), 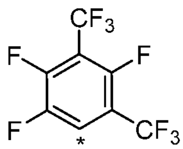 (B7), 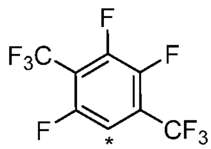 (B8), 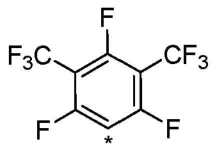 (B9), 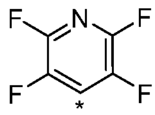 (B10),

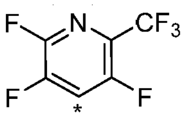 (B11), 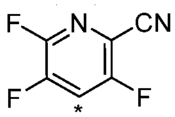 (B12), 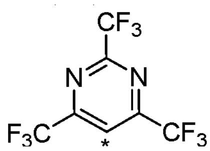 (B13), 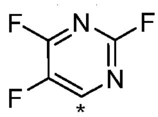 (B14), 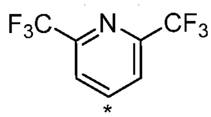 (B15),

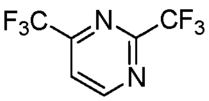 (B16), 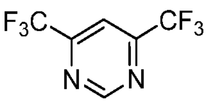 (B17), 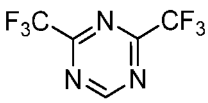 (B18), 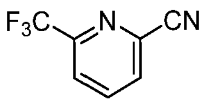 (B19), 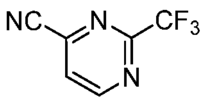 (B20),

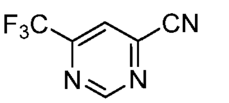 (B21), 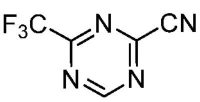 (B22), 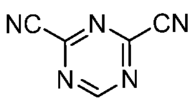 (B23), 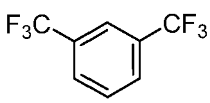 (B24), 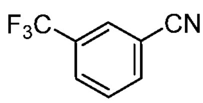 (B25),

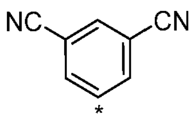 (B26), 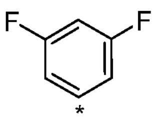 (B27), 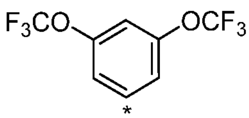 (B28), 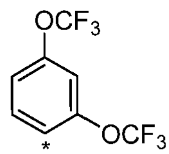 (B29), 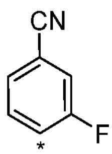 (B30),

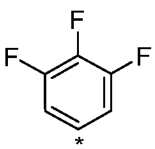 (B31), 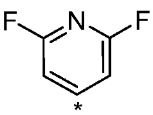 (B32), 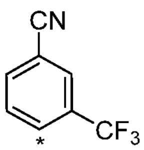 (B33), 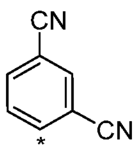 (B34), 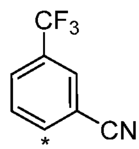 (B35),

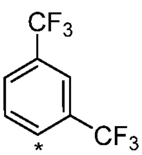 (B36), 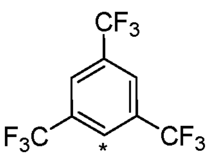 (B37), 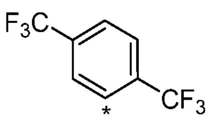 (B38), 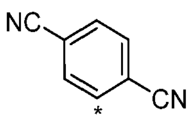 (B39), 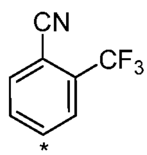 (B40),

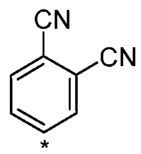
(B41),
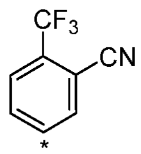
(B42),
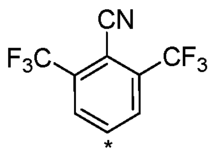
(B43),
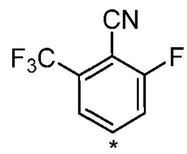
(B44),
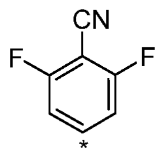
(B45),

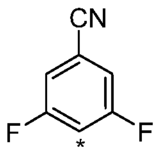
(B46),
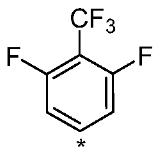
(B47),
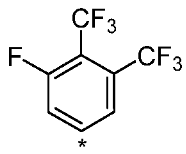
(B48),
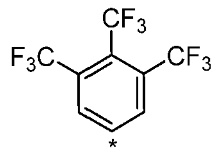
(B49),
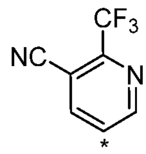
(B50),

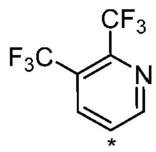
(B51),
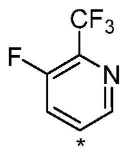
(B52),
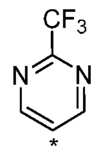
(B53),
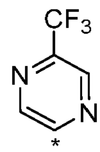
(B54),
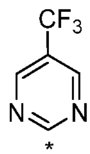
(B55),

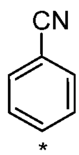
(B56),
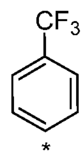
(B57),
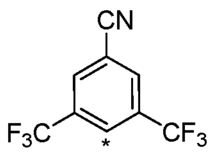
(B58),
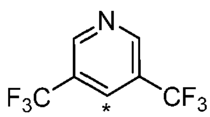
(B59),
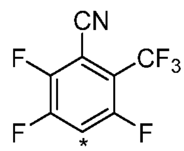
(B60),

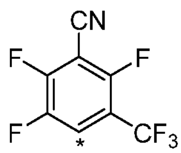
(B61),
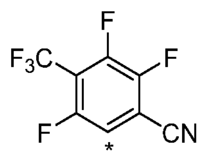
(B62),
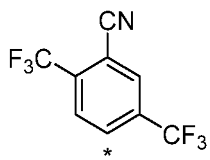
(B63),
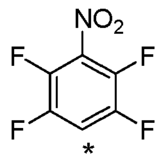
(B64),

wherein the asterisk "*" denotes the binding position.

**11.** The organic electroluminescent device according to claim 10, wherein in the first radialene compound of formula (I) $Ar^1$, $Ar^2$ and $Ar^3$ and/or in the second radialene compound of formula (II) $Er^1$, $Er^2$ and $Er^3$ are independently selected from one of the following groups of B1 to B8, B10 to B17, B19 to B21, B24 to B26, B33, B34, B37, B40, B43, B58 to B62, and B64, and preferably in the first radialene compound of formula (I) $Ar^1$, $Ar^2$ and $Ar^3$ and/or in the second radialene compound of formula (II) $Er^1$, $Er^2$ and $Er^3$ are independently selected from one of the following groups of B2, B3, B4, B11, B13, B37, B43, B58, B59, B60, B61, B63 and B64.

**12.** The organic electroluminescent device according to claim 11, wherein in the first radialene compound of formula (I) $Ar^1$, $Ar^2$ and $Ar^3$ are independently selected from one of the following groups of B1 to B64, and wherein preferably each R' and/or R" are selected from CN, and preferably wherein in the first radialene compound of formula (I) $Ar^1$, $Ar^2$ and $Ar^3$ and/or in the second radialene compound of formula (II) $Er^1$, $Er^2$ and $Er^3$ are independently selected from one of the following groups of B1 to B5, B7, B8, B10 to B13, B15 to B17, B19 to B21, B37, B43, B58 to B61, B63 and B64 and wherein preferably each R' and/or R" are selected from CN.

**13.** The organic electroluminescent device according to any one of claims 1 to 12, wherein in the first radialene compound of formula (I) $Ar^1$, $Ar^2$ and $Ar^3$ and/or in the second radialene compound of formula (II) $Er^1$, $Er^2$ and $Er^3$ are

independently selected from a group according to the following formula (III), and wherein preferably each R' and/or R" is selected from CN:

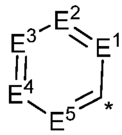

(III)

wherein

$E^1$ is selected from $CW^1$ or N;
$E^2$ is selected from $CW^2$ or N;
$E^3$ is selected from $CW^3$ or N;
$E^4$ is selected from $CW^4$ or N;
$E^5$ is selected from $CW^5$ or N;
$W^1$, $W^2$, $W^3$, $W^4$ and $W^5$ are independently selected from electron-withdrawing group, CN, halogen, Cl, F, $NO_2$, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_6$ alkoxy, $OCF_3$, substituted or unsubstituted $C_6$ to $C_{30}$ aryl, substituted or unsubstituted $C_3$ to $C_{30}$ heteroaryl, D or H,
wherein the one or more substituents of $W^1$, $W^2$, $W^3$, $W^4$ and $W^5$ is independently selected from D, halogen, Cl, F, CN, $NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
wherein the asterisk "*" denotes the binding position.

**14.** The organic electroluminescent device according to claim 13, wherein in formula (III) $W^1$, $W^2$, $W^3$, $W^4$ and $W^5$ are independently selected from electron-withdrawing group, CN, halogen, Cl, F, $NO_2$, partially fluorinated or perfluorinated $C_1$ to $C_8$ alkyl, $CF_3$, partially fluorinated or perfluorinated $C_1$ to $C_6$ alkoxy, $OCF_3$, D or H, and preferably each R' and/or R" is CN.

**15.** The organic electroluminescent device according to any of claims 1 to 14, wherein the second radialene of formula (II) has a calculated LUMO energy being calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

**16.** The organic electroluminescent device according to any one of claims 1 to 15, wherein

- the first radialene compound of formula (I) has a calculated LUMO energy level of $\leq$ - 5.21 eV, preferably $\leq$ -5.22 eV; further preferred $\leq$ -5.25 eV; and in addition preferred $\leq$ -5.29 eV; or
- the first radialene compound of formula (I) has a calculated LUMO energy level in the range of $\leq$ -5.20 eV to $\geq$ -5.75 eV, preferably $\leq$ -5.20 eV to $\geq$ -5.70 eV; further preferred $\leq$ -5.20 eV to $\geq$ - 5.65 eV, also preferred $\leq$ -5.20 eV to $\geq$ - 5.60 eV, furthermore preferred $\leq$ -5.22 eV to $\geq$ - 5.60 eV, in addition preferred $\leq$ -5.25 eV to $\geq$ - 5.55 eV, more preferred $\leq$ -5.25 eV to $\geq$ - 5.50 eV, even more preferred $\leq$ -5.25 eV to $\geq$ - 5.45 eV.

**17.** The organic electroluminescent device according to any one of claims 1 to 16, wherein the first hole transport matrix compound has a calculated HOMO energy level in the range of $\leq$ - 4.27 eV to $\geq$ -5.1 eV, preferably in the range of < -4.3 eV and > -5.0 eV, further preferred in the range of < -4.5 eV and > -5.0 eV, also preferred in the range of < -4.5 eV and > -4.9 eV, an in addition preferred in the range of < - 4.6 eV and > -4.9 eV.

**18.** The organic electroluminescent device according to any one of claims 1 to 17, wherein

- the second radialene compound of formula (II) has a calculated LUMO energy level of $\leq$ - 5.21 eV when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase; or
- the second radialene compound of formula (II) has a calculated LUMO energy level in the range of $\leq$ -4.60 eV when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase,

more preferably ≤ - 4.75 eV; further preferred ≤ -5.00 eV; also preferred ≤ -5.10 eV; in addition preferred ≤ - 5.15 eV; more preferred ≤ -5.19 eV.

**19.** The organic electroluminescent device according to any one of claims 1 to 18, wherein the calculated LUMO energy level of the selected second radialene compound of formula (II) is higher than the LUMO energy level of the first radialene compound of formula (I).

**20.** The organic electroluminescent device according to any one of claims 1 to 19, wherein the second radialene compound of formula (II) in the p-type charge generation layer has a calculated LUMO energy level in the range of ≤ -5.00 eV to ≥ -5.75 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably ≤ -5.10 eV to ≥ -5.70 eV; further preferred ≤ -5.15 eV to ≥ - 5.65 eV, also preferred ≤ -5.19 eV to ≥ - 5.65 eV, in addition preferred ≤ -5.20 eV to ≥ - 5.60 eV, more preferred ≤ -5.22 eV to ≥ - 5.55 eV, further more preferred ≤ -5.22 eV to ≥ - 5.50 eV, even more preferred ≤ -5.22 eV to ≥ - 5.45 eV.

**21.** The organic electroluminescent device according to any one of claims 1 to 20, wherein the second hole transport matrix compound has a calculated HOMO energy level in the range of ≤ -4.27 eV to ≥ -5.1 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably in the range of < -4.3 eV and > -5.0 eV, further preferred in the range of < -4.5 eV and > -5.0 eV, also preferred in the range of < -4.5 eV and > -4.9 eV, in addition preferred in the range of < -4.6 eV and > -4.9 eV.

**22.** The organic electroluminescent device according to any one of claims 1 to 21, wherein the compound of the first radialene compound of formula (I) and the compound of the second radialene compound of formula (II) are independently represented by one of the following formulas (IVa) to (IVh):

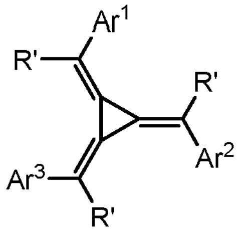
(IVa),

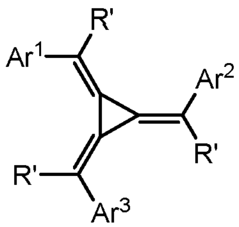
(IVe),

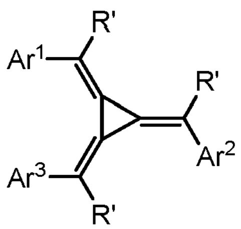
(IVb),

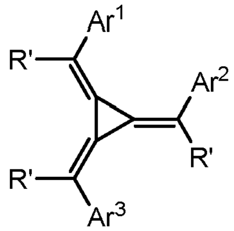
(IVf),

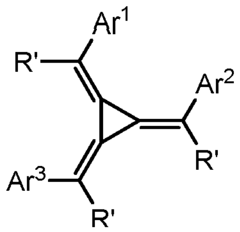
(IVc),

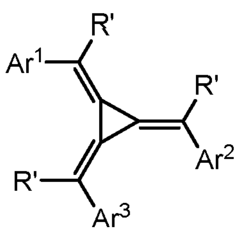
(IVg),

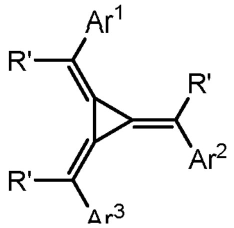
(IVd),

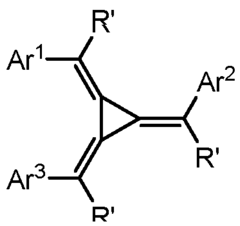
(IVh).

wherein $Ar^1$, $Ar^2$, $Ar^3$, and R' are independently selected from halogen, F and CN, and preferably CN; wherein the first radialene compound of formula (I) and the second radialene compound of formula (II) are selected different from each other.

**23.** An electronic device comprising an organic electroluminescent device according to any of the claims 1 to 22, wherein the electronic device is preferably a display device, a light emitting device, a thin film transistor, a battery, a display device or a photovoltaic device, and preferably a light emitting device, preferably the electronic device is part of a display device or lighting device.

**Patentansprüche**

**1.** Organische Elektrolumineszenzvorrichtung, umfassend eine Anodenschicht, eine Kathodenschicht, eine Lochinjektionsschicht, mindestens zwei lichtemittierende Einheiten und mindestens eine Ladungserzeugungsschicht, wobei mindestens eine Ladungserzeugungsschicht eine Ladungserzeugungsschicht vom p-Typ umfasst;

wobei jede lichtemittierende Einheit mindestens eine lichtemittierende Schicht umfasst,
wobei jede der mindestens einen Ladungserzeugungsschicht unabhängig zwischen einem Satz von zwei benachbarten lichtemittierenden Einheiten der mindestens zwei Lichtemissionseinheiten angeordnet ist;
wobei die Lochinjektionsschicht näher an der Anodenschicht angeordnet ist als die Ladungserzeugungsschicht vom p-Typ;
wobei die Lochinjektionsschicht eine erste Radialenverbindung der Formel (I) und eine erste Lochtransportmatrixverbindung umfasst, wobei die erste Radialenverbindung der Formel (I) wiedergegeben wird durch:

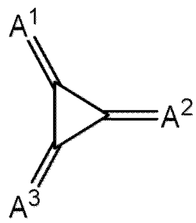
(I),

wobei in der ersten Radialenverbindung der Formel (I):

$A^1$ unabhängig aus einer Gruppe der Formel (Ia) ausgewählt ist:

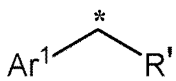
(Ia),

wobei
$Ar^1$ unabhängig aus substituiertem oder unsubstituiertem $C_6$- bis $C_{36}$-Aryl und substituiertem oder unsubstituiertem $C_2$- bis $C_{36}$-Heteroaryl ausgewählt ist; wobei
einer oder mehrere der Substituenten von $Ar^1$ unabhängig aus der Gruppe umfassend D, eine elektronenziehende Gruppe, Halogen, Cl, F, CN, $-NO_2$, substituiertes oder unsubstituiertes $C_1$- bis $C_8$-Alkyl, teilfluoriertes $C_1$- bis $C_8$-Alkyl, perfluoriertes $C_1$- bis $C_8$-Alkyl, substituiertes oder unsubstituiertes $C_1$- bis $C_8$-Alkoxy, teilfluoriertes $C_1$- bis $C_8$-Alkoxy, perfluoriertes $C_1$- bis $C_8$-Alkoxy, substituiertes oder unsubsti-

tuiertes $C_6$- bis $C_{30}$-Aryl und substituiertes oder unsubstituiertes $C_6$- bis $C_{30}$-Heteroaryl ausgewählt sind; wobei

der eine oder die mehreren Substituenten des $C_6$- bis $C_{30}$-Aryls, $C_6$- bis $C_{30}$-Heteroaryls, $C_1$- bis $C_8$-Alkyls und $C_1$-bis $C_8$-Alkoxys unabhängig aus D, einer elektronenziehenden Gruppe, Halogen, Cl, F, CN, $-NO_2$, teilfluoriertem $C_1$- bis $C_8$-Alkyl, perfluoriertem $C_1$- bis $C_8$-Alkyl, teilfluoriertem $C_1$- bis $C_8$-Alkoxy, perfluoriertem $C_1$- bis $C_8$-Alkoxy ausgewählt sind;

$A^2$ unabhängig einer Gruppe der Formel (Ib) ausgewählt ist:

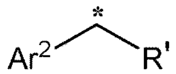 (Ib),

wobei

$Ar^2$ unabhängig aus substituiertem oder unsubstituiertem $C_6$- bis $C_{36}$-Aryl und substituiertem oder unsubstituiertem $C_2$- bis $C_{36}$-Heteroaryl ausgewählt ist; wobei

einer oder mehrere der Substituenten von $Ar^2$ unabhängig aus der Gruppe umfassend D, eine elektronenziehende Gruppe, Halogen, Cl, F, CN, $-NO_2$, substituiertes oder unsubstituiertes $C_1$- bis $C_8$-Alkyl, teilfluoriertes $C_1$- bis $C_8$-Alkyl, perfluoriertes $C_1$- bis $C_8$-Alkyl, substituiertes oder unsubstituiertes $C_1$- bis $C_8$-Alkoxy, teilfluoriertes $C_1$- bis $C_8$-Alkoxy, perfluoriertes $C_1$- bis $C_8$-Alkoxy, substituiertes oder unsubstituiertes $C_6$- bis $C_{30}$-Aryl und substituiertes oder unsubstituiertes $C_6$- bis $C_{30}$-Heteroaryl ausgewählt sind; wobei

der eine oder die mehreren Substituenten von $C_6$- bis $C_{30}$-Aryl, $C_6$- bis $C_{30}$-Heteroaryl, $C_1$- bis $C_8$-Alkyl, $C_1$- bis $C_8$-Alkoxy unabhängig aus D, einer elektronenziehenden Gruppe, Halogen, Cl, F, CN, $-NO_2$, teilfluoriertem $C_1$- bis $C_8$-Alkyl, perfluoriertem $C_1$- bis $C_8$-Alkyl, teilfluoriertem $C_1$- bis $C_8$-Alkoxy, perfluoriertem $C_1$- bis $C_8$-Alkoxy ausgewählt sind;

$A^3$ unabhängig aus einer Gruppe der Formel (Ic) ausgewählt ist:

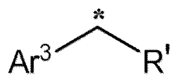 (Ic),

wobei

$Ar^3$ unabhängig aus substituiertem oder unsubstituiertem $C_6$- bis $C_{36}$-Aryl und substituiertem oder unsubstituiertem $C_2$- bis $C_{36}$-Heteroaryl ausgewählt ist; wobei

einer oder mehrere der Substituenten von $Ar^3$ unabhängig aus der Gruppe umfassend D, eine elektronenziehende Gruppe, Halogen, Cl, F, CN, $-NO_2$, substituiertes oder unsubstituiertes $C_1$- bis $C_8$-Alkyl, teilfluoriertes $C_1$- bis $C_8$-Alkyl, perfluoriertes $C_1$- bis $C_8$-Alkyl, substituiertes oder unsubstituiertes $C_1$- bis $C_8$-Alkoxy, teilfluoriertes $C_1$- bis $C_8$-Alkoxy, perfluoriertes $C_1$- bis $C_8$-Alkoxy, substituiertes oder unsubstituiertes $C_6$- bis $C_{30}$-Aryl und substituiertes oder unsubstituiertes $C_6$- bis $C_{30}$-Heteroaryl ausgewählt sind, wobei

der eine oder die mehreren Substituenten von $C_6$- bis $C_{30}$-Aryl, $C_6$- bis $C_{30}$-Heteroaryl, $C_1$- bis $C_8$-Alkyl, $C_1$- bis $C_8$-Alkoxy unabhängig aus D, einer elektronenziehenden Gruppe, Halogen, Cl, F, CN, $-NO_2$, teilfluoriertem $C_1$- bis $C_8$-Alkyl, perfluoriertem $C_1$- bis $C_8$-Alkyl, teilfluoriertem $C_1$- bis $C_8$-Alkoxy, perfluoriertem $C_1$- bis $C_8$-Alkoxy ausgewählt sind;

wobei

in $A^1$, $A^2$ und $A^3$ jedes R' unabhängig aus substituiertem oder unsubstituiertem $C_6$- bis $C_{18}$-Aryl, substituiertem oder unsubstituiertem $C_3$- bis $C_{18}$-Heteroaryl, einer elektronenziehenden Gruppe, substituiertem oder unsubstituiertem $C_1$- bis $C_8$-Alkyl, teilfluoriertem $C_1$- bis $C_8$-Alkyl, perfluoriertem $C_1$- bis $C_8$-Alkyl, Halogen, F und CN ausgewählt ist; wobei

einer oder mehrere der Substituenten von $C_6$- bis $C_{18}$-Aryl, $C_6$- bis $C_{18}$-Heteroaryl, $C_1$- bis $C_8$-Alkyl unabhängig aus D, einer elektronenziehenden Gruppe, Halogen, Cl, F, CN, $- NO_2$, teilfluoriertem $C_1$- bis $C_6$-Alkyl, perfluoriertem $C_1$-bis $C_6$-Alkyl, teilfluoriertem $C_1$- bis $C_6$-Alkoxy, perfluoriertem $C_1$- bis $C_6$-Alkoxy ausgewählt sind;

wobei

die erste Radialenverbindung der Formel (I) bei Berechnung mit dem Programmpaket TURBOMOLE V6.5 (TURBOMOLE GmbH, Litzenhardtstraße 19, 76135 Karlsruhe, Deutschland) durch Anwenden des Hybridfunktionals B3LYP mit einem 6-31G*-Basissatz in der Gasphase ein LUMO-Energieniveau von $\leq$ -5,20 eV aufweist;

wobei
die Ladungserzeugungsschicht vom p-Typ eine zweite Radialenverbindung der Formel (II) und eine zweite Lochtransportmatrixverbindung umfasst; und
wobei die zweite Radialenverbindung der Formel (II) wiedergegeben wird durch:

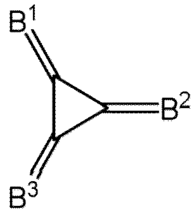
(II),

wobei in der zweiten Radialenverbindung der Formel (II):

$B^1$ unabhängig aus einer Gruppe der Formel (IIa) ausgewählt ist:

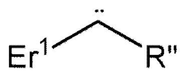
(IIa),

wobei
$Er^1$ unabhängig aus substituiertem oder unsubstituiertem $C_6$- bis $C_{36}$-Aryl und substituiertem oder unsubstituiertem $C_2$- bis $C_{36}$-Heteroaryl ausgewählt ist; wobei
einer oder mehrere der Substituenten von $Er^1$ unabhängig aus der Gruppe umfassend D, eine elektronenziehende Gruppe, Halogen, Cl, F, CN, -$NO_2$, substituiertes oder unsubstituiertes $C_1$- bis $C_8$-Alkyl, teilfluoriertes $C_1$- bis $C_8$-Alkyl, perfluoriertes $C_1$- bis $C_8$-Alkyl, substituiertes oder unsubstituiertes $C_1$- bis $C_8$-Alkoxy, teilfluoriertes $C_1$- bis $C_8$-Alkoxy, perfluoriertes $C_1$- bis $C_8$-Alkoxy, substituiertes oder unsubstituiertes $C_6$- bis $C_{30}$-Aryl und substituiertes oder unsubstituiertes $C_6$- bis $C_{30}$-Heteroaryl ausgewählt sind und
wobei der eine oder die mehreren Substituenten von $C_6$-bis $C_{30}$-Aryl, $C_6$- bis $C_{30}$-Heteroaryl, $C_1$- bis $C_8$-Alkyl, $C_1$-bis $C_8$-Alkoxy unabhängig aus D, einer elektronenziehenden Gruppe, Halogen, Cl, F, CN, -$NO_2$, teilfluoriertem $C_1$- bis $C_8$-Alkyl, perfluoriertem $C_1$- bis $C_8$-Alkyl, teilfluoriertem $C_1$- bis $C_8$-Alkoxy, perfluoriertem $C_1$- bis $C_8$-Alkoxy ausgewählt sind;
$B^2$ unabhängig aus einer Gruppe der Formel (IIb) ausgewählt ist:

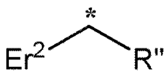
(IIb),

wobei
$Er^2$ unabhängig aus substituiertem oder unsubstituiertem $C_6$- bis $C_{36}$-Aryl und substituiertem oder unsubstituiertem $C_2$- bis $C_{36}$-Heteroaryl ausgewählt ist; wobei
einer oder mehrere der Substituenten von $Er^2$ unabhängig aus der Gruppe umfassend D, eine elektronenziehende Gruppe, Halogen, Cl, F, CN, -$NO_2$, substituiertes oder unsubstituiertes $C_1$- bis $C_8$-Alkyl, teilfluoriertes $C_1$- bis $C_8$-Alkyl, perfluoriertes $C_1$- bis $C_8$-Alkyl, substituiertes oder unsubstituiertes $C_1$- bis $C_8$-Alkoxy, teilfluoriertes $C_1$- bis $C_8$-Alkoxy, perfluoriertes $C_1$- bis $C_8$-Alkoxy, substituiertes oder unsubstituiertes $C_6$- bis $C_{30}$-Aryl und substituiertes oder unsubstituiertes $C_6$- bis $C_{30}$-Heteroaryl ausgewählt sind; und wobei
der eine oder die mehreren Substituenten von $C_6$- bis $C_{30}$-Aryl, $C_6$- bis $C_{30}$-Heteroaryl, $C_1$- bis $C_8$-Alkyl, $C_1$- bis $C_8$-Alkoxy unabhängig aus D, einer elektronenziehenden Gruppe, Halogen, Cl, F, CN, -$NO_2$, teilfluoriertem $C_1$- bis $C_8$-Alkyl, perfluoriertem $C_1$- bis $C_8$-Alkyl, teilfluoriertem $C_1$- bis $C_8$-Alkoxy, perfluoriertem $C_1$- bis $C_8$-Alkoxy ausgewählt sind;
$B^3$ unabhängig aus einer Gruppe der Formel (Ic) ausgewählt ist:

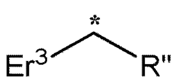
(IIc),

wobei
$Er^3$ unabhängig aus substituiertem oder unsubstituiertem $C_6$- bis $C_{36}$-Aryl und substituiertem oder unsubstituiertem $C_2$- bis $C_{36}$-Heteroaryl ausgewählt ist; wobei
einer oder mehrere der Substituenten von $Er^3$ unabhängig aus der Gruppe umfassend D, eine elektronenziehende Gruppe, Halogen, Cl, F, CN, $-NO_2$, substituiertes oder unsubstituiertes $C_1$- bis $C_8$-Alkyl, teilfluoriertes $C_1$- bis $C_8$-Alkyl, perfluoriertes $C_1$- bis $C_8$-Alkyl, substituiertes oder unsubstituiertes $C_1$- bis $C_8$-Alkoxy, teilfluoriertes $C_1$- bis $C_8$-Alkoxy, perfluoriertes $C_1$- bis $C_8$-Alkoxy, substituiertes oder unsubstituiertes $C_6$- bis $C_{30}$-Aryl und substituiertes oder unsubstituiertes $C_6$- bis $C_{30}$-Heteroaryl ausgewählt sind und
wobei der eine oder die mehreren Substituenten von $C_6$-bis $C_{30}$-Aryl, $C_6$- bis $C_{30}$-Heteroaryl, $C_1$- bis $C_8$-Alkyl, $C_1$-bis $C_8$-Alkoxy unabhängig aus D, einer elektronenziehenden Gruppe, Halogen, Cl, F, CN, $-NO_2$, teilfluoriertem $C_1$- bis $C_8$-Alkyl, perfluoriertem $C_1$- bis $C_8$-Alkyl, teilfluoriertem $C_1$- bis $C_8$-Alkoxy, perfluoriertem $C_1$- bis $C_8$-Alkoxy ausgewählt sind;
wobei
in $B^1$, $B^2$ und $B^3$ jedes R" unabhängig aus substituiertem oder unsubstituiertem $C_6$- bis $C_{18}$-Aryl, substituiertem oder unsubstituiertem $C_3$- bis $C_{18}$-Heteroaryl, einer elektronenziehenden Gruppe, substituiertem oder unsubstituiertem $C_1$- bis $C_8$-Alkyl, teilfluoriertem $C_1$- bis $C_8$-Alkyl, perfluoriertem $C_1$- bis $C_8$-Alkyl, Halogen, F und CN ausgewählt ist;
wobei der eine oder die mehreren Substituenten von $C_6$-bis $C_{18}$-Aryl, $C_6$- bis $C_{18}$-Heteroaryl, $C_1$- bis $C_8$-Alkyl unabhängig aus D, einer elektronenziehenden Gruppe, Halogen, Cl, F, CN, $-NO_2$, teilfluoriertem $C_1$- bis $C_6$-Alkyl, perfluoriertem $C_1$- bis $C_6$-Alkyl, teilfluoriertem $C_1$- bis $C_6$-Alkoxy, perfluoriertem $C_1$- bis $C_6$-Alkoxy ausgewählt sind;
wobei
die erste Radialenverbindung der Formel (I) und die zweite Radialenverbindung der Formel (II) voneinander verschieden ausgewählt sind; und
wobei das Sternchen **"*"** die Bindungsposition bezeichnet.

**2.** Organische Elektrolumineszenzvorrichtung nach Anspruch 1, wobei die organische Elektrolumineszenzvorrichtung mindestens drei lichtemittierende Einheiten und mindestens zwei Ladungserzeugungsschichten umfasst, wobei jede der mindestens zwei Ladungserzeugungsschichten unabhängig zwischen einem Satz von zwei benachbarten lichtemittierenden Einheiten der mindestens drei lichtemittierenden Einheiten angeordnet ist; oder die organische Elektrolumineszenzvorrichtung mindestens vier lichtemittierende Einheiten und mindestens drei Ladungserzeugungsschichten umfasst, wobei jede der mindestens drei Ladungserzeugungsschichten unabhängig zwischen einem Satz von zwei benachbarten lichtemittierenden Einheiten der mindestens vier lichtemittierenden Einheiten angeordnet ist.

**3.** Organische Elektrolumineszenzvorrichtung nach einem der vorhergehenden Ansprüche 1 bis 2, wobei die Lochinjektionsschicht in direktem Kontakt mit der Anodenschicht steht.

**4.** Organische Elektrolumineszenzvorrichtung nach einem der Ansprüche 1 bis 3, wobei die organische Elektrolumineszenzvorrichtung ferner eine Lochtransportschicht umfasst, wobei die Lochtransportschicht benachbart zur Lochinjektionsschicht angeordnet ist und vorzugsweise die Lochtransportschicht zwischen einer lichtemittierenden Einheit und der Lochinjektionsschicht angeordnet ist.

**5.** Organische Elektrolumineszenzvorrichtung nach einem der Ansprüche 1 bis 4, wobei die mindestens eine Ladungserzeugungsschicht ferner eine Ladungserzeugungsschicht vom n-Typ umfasst.

**6.** Organische Elektrolumineszenzvorrichtung nach einem der Ansprüche 1 bis 5, wobei die Ladungserzeugungsschicht vom p-Typ der mindestens einen Ladungserzeugungsschicht in direktem Kontakt mit der Ladungserzeugungsschicht vom n-Typ der mindestens einen Ladungserzeugungsschicht angeordnet ist.

**7.** Organische Elektrolumineszenzvorrichtung nach einem der Ansprüche 1 bis 6, wobei mindestens eine lichtemittierende Einheit oder alle lichtemittierenden Einheiten zusätzlich zu einer Emissionsschicht ferner eine Lochtransportschicht, eine Elektronenblockierschicht, eine Lochblockierschicht und eine Elektronentransportschicht umfassen.

**8.** Organische Elektrolumineszenzvorrichtung nach einem der Ansprüche 1 bis 7, wobei in der ersten Radialenverbindung der Formel (I) und Formel (II) R' und R" unabhängig aus Halogen, F und CN und vorzugsweise CN ausgewählt sind.

**9.** Organische Elektrolumineszenzvorrichtung nach einem der Ansprüche 1 bis 8, wobei in der ersten Radialenverbindung der Formel (I) mindestens zwei von $A^1$, $A^2$ und $A^3$ gleich ausgewählt sind und/oder in der zweiten Radialenverbindung der Formel (II) mindestens zwei von $B^1$, $B^2$ und $B^3$ gleich ausgewählt sind.

**10.** Organische Elektrolumineszenzvorrichtung nach einem der Ansprüche 1 bis 9, wobei in der ersten Radialenverbindung der Formel (I) $Ar^1$, $Ar^2$ und $Ar^3$ und/oder in der zweiten Radialenverbindung der Formel (II) $Er^1$, $Er^2$ und $Er^3$ unabhängig aus einer der folgenden Gruppen von B1 bis B64 ausgewählt sind:

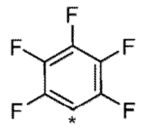 (B1), 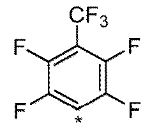 (B2), 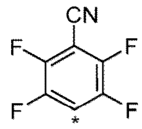 (B3), 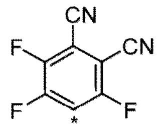 (B4), 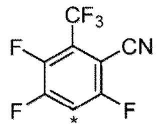 (B5),

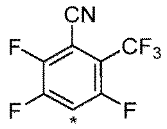 (B6), 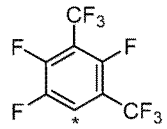 (B7), 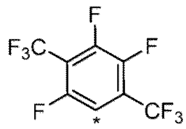 (B8), 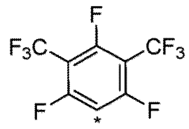 (B9), 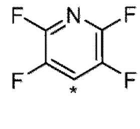 (B10),

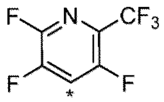 (B11), 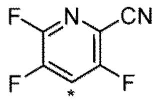 (B12), 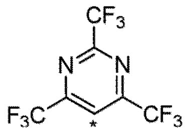 (B13), 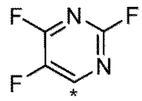 (B14), 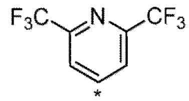 (B15),

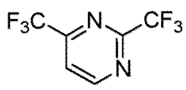 (B16), 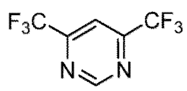 (B17), 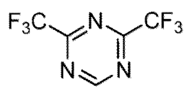 (B18), 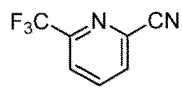 (B19), 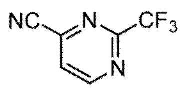 (B20),

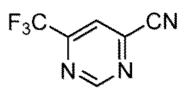 (B21), 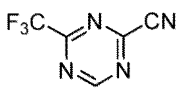 (B22), 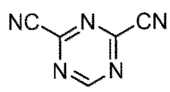 (B23), 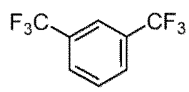 (B24), 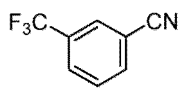 (B25),

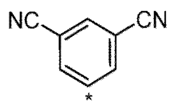 (B26), 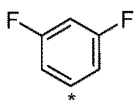 (B27), 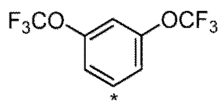 (B28), 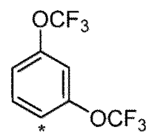 (B29), 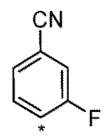 (B30),

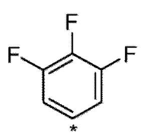 (B31), 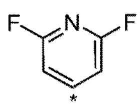 (B32), 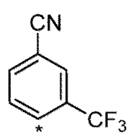 (B33), 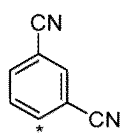 (B34), 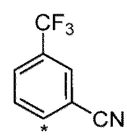 (B35),

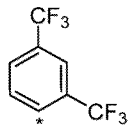 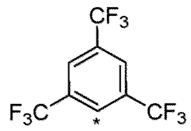 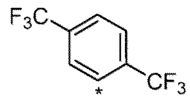 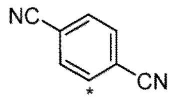 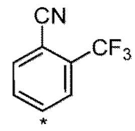

(B36), (B37), (B38), (B39), (B40),

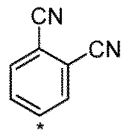 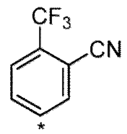 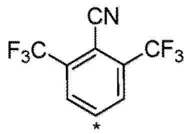 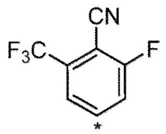 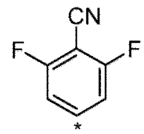

(B41), (B42), (B43), (B44), (B45),

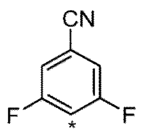 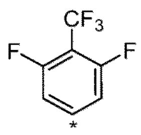 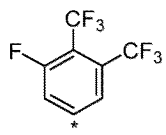 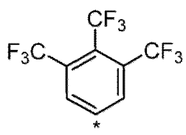 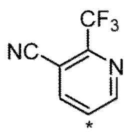

(B46), (B47), (B48), (B49), (B50),

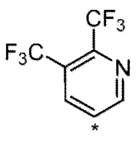 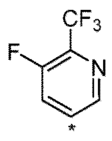 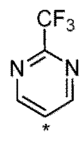 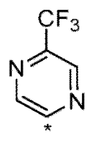 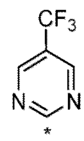

(B51), (B52), (B53), (B54), (B55),

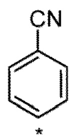 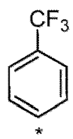 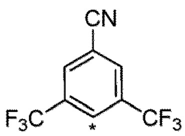 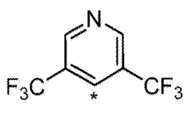 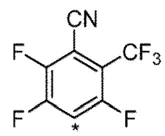

(B56), (B57), (B58), (B59), (B60),

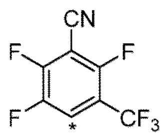 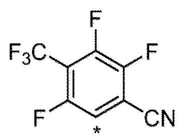 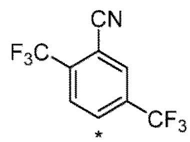 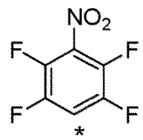

(B61), (B62), (B63), (B64),

wobei das Sternchen "*" die Bindungsposition bezeichnet.

**11.** Organische Elektrolumineszenzvorrichtung nach Anspruch 10, wobei in der ersten Radialenverbindung der Formel (I) $Ar^1$, $Ar^2$ und $Ar^3$ und/oder in der zweiten Radialenverbindung der Formel (II) $Er^1$, $Er^2$ und $Er^3$ unabhängig aus einer der folgenden Gruppen von B1 bis B8, B10 bis B17, B19 bis B21, B24 bis B26, B33, B34, B37, B40, B43, B58 bis B62 und B64 ausgewählt sind und vorzugsweise in der ersten Radialenverbindung der Formel (I) $Ar^1$, $Ar^2$ und $Ar^3$ und/oder in der zweiten Radialenverbindung der Formel (II) $Er^1$, $Er^2$ und $Er^3$ unabhängig aus einer der folgenden Gruppen von B2, B3, B4, B11, B13, B37, B43, B58, B59, B60, B61, B63 und B64 ausgewählt sind.

**12.** Organische Elektrolumineszenzvorrichtung nach Anspruch 11, wobei in der ersten Radialenverbindung der Formel (I) $Ar^1$, $Ar^2$ und $Ar^3$ unabhängig aus einer der folgenden Gruppen von B1 bis B64 ausgewählt sind und wobei vorzugsweise jedes R' und/oder R" aus CN ausgewählt ist, und wobei vorzugsweise in der ersten Radialenverbindung der Formel (I) $Ar^1$, $Ar^2$ und $Ar^3$ und/oder in der zweiten Radialenverbindung der Formel (II) $Er^1$, $Er^2$ und $Er^3$ unabhängig ausgewählt sind aus einer der folgenden Gruppen von B1 bis B5, B7, B8, B10 bis B13, B15 bis B17, B19 bis B21, B37, B43, B58 bis B61, B63 und B64, und wobei vorzugsweise jedes R' und/oder R" aus CN ausgewählt ist.

**13.** Organische Elektrolumineszenzvorrichtung nach einem der Ansprüche 1 bis 12, wobei in der ersten Radialenverbindung der Formel (I) $Ar^1$, $Ar^2$ und $Ar^3$ und/oder in der zweiten Radialenverbindung der Formel (II) $Er^1$, $Er^2$ und $Er^3$ unabhängig aus einer Gruppe gemäß der folgenden Formel (III) ausgewählt sind und wobei vorzugsweise jedes R' und/oder R" aus CN ausgewählt ist:

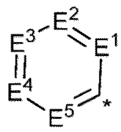

(III)

wobei

$E^1$ aus $CW^1$ oder N ausgewählt ist;
$E^2$ aus $CW^2$ oder N ausgewählt ist;
$E^3$ aus $CW^3$ oder N ausgewählt ist;
$E^4$ aus $CW^4$ oder N ausgewählt ist;
$E^5$ aus $CW^5$ oder N ausgewählt ist;
$W^1$, $W^2$, $W^3$, $W^4$ und $W^5$ unabhängig aus einer elektronenziehenden Gruppe, CN, Halogen, Cl, F, $NO_2$, substituiertem oder unsubstituiertem $C_1$- bis $C_8$-Alkyl, teilfluoriertem $C_1$- bis $C_8$-Alkyl, perfluoriertem $C_1$- bis $C_8$-Alkyl, $CF_3$, substituiertem oder unsubstituiertem $C_1$-bis $C_8$-Alkoxy, teilfluoriertem $C_1$- bis $C_8$-Alkoxy, perfluoriertem $C_1$- bis $C_6$-Alkoxy, $OCF_3$, substituiertem oder unsubstituiertem $C_6$- bis $C_{30}$-Aryl, substituiertem oder unsubstituiertem $C_3$- bis $C_{30}$-Heteroaryl, D oder H ausgewählt sind,
wobei der eine oder die mehreren Substituenten von $W^1$, $W^2$, $W^3$, $W^4$ und $W^5$ unabhängig aus D, Halogen, Cl, F, CN, $NO_2$, teilfluoriertem $C_1$- bis $C_8$-Alkyl, perfluoriertem $C_1$-bis $C_8$-Alkyl, teilfluoriertem $C_1$- bis $C_8$-Alkoxy, perfluoriertem $C_1$- bis $C_8$-Alkoxy ausgewählt sind;
wobei das Sternchen "*" die Bindungsposition bezeichnet.

**14.** Organische Elektrolumineszenzvorrichtung nach Anspruch 13, wobei in Formel (III) $W^1$, $W^2$, $W^3$, $W^4$ und $W^5$ unabhängig aus einer elektronenziehenden Gruppe, CN, Halogen, Cl, F, $NO_2$, teilfluoriertem oder perfluoriertem $C_1$- bis $C_8$-Alkyl, $CF_3$, teilfluoriertem oder perfluoriertem $C_1$- bis $C_6$-Alkoxy, $OCF_3$, D oder H ausgewählt sind und vorzugsweise jedes R' und/oder R" für CN steht.

**15.** Organische Elektrolumineszenzvorrichtung nach einem der Ansprüche 1 bis 14, wobei das zweite Radialen der Formel (II) eine berechnete LUMO-Energie aufweist, die mit dem Programmpaket TURBOMOLE V6.5 (TURBOMOLE GmbH, Litzenhardtstraße 19, 76135 Karlsruhe, Deutschland) durch Anwenden des Hybridfunktionals B3LYP mit einem 6-31G*-Basissatz in der Gasphase berechnet wird.

**16.** Organische Elektrolumineszenzvorrichtung nach einem der vorhergehenden Ansprüche 1 bis 15, wobei

- die erste Radialenverbindung der Formel (I) ein berechnetes LUMO-Energieniveau von ≤ -5,21 eV, vorzugsweise ≤ -5,22 eV, weiter bevorzugt ≤ -5,25 eV und zusätzlich bevorzugt ≤ -5,29 eV aufweist oder
- die erste Radialenverbindung der Formel (I) ein berechnetes LUMO-Energieniveau im Bereich von ≤ -5,20 eV bis ≥ -5,75 eV, vorzugsweise ≤ -5,20 eV bis ≥ -5,70 eV, weiter bevorzugt ≤ -5,20 eV bis ≥ -5,65 eV, auch bevorzugt ≤ -5,20 eV bis ≥ -5,60 eV, weiter bevorzugt ≤ -5,22 eV bis ≥ -5,60 eV, zusätzlich bevorzugt ≤ -5,25 eV bis ≥ - 5,55 eV, weiter bevorzugt ≤ -5,25 eV bis ≥ -5,50 eV, noch weiter bevorzugt ≤ -5,25 eV bis ≥ -5,45 eV, aufweist.

**17.** Organische Elektrolumineszenzvorrichtung nach einem der Ansprüche 1 bis 16, wobei die erste Lochtransportmatrixverbindung ein berechnetes HOMO-Energieniveau im Bereich von ≤ -4,27 eV bis ≥ -5,1 eV, vorzugsweise im Bereich von < -4,3 eV und > -5,0 eV, weiter bevorzugt im Bereich von < -4,5 eV und > -5,0 eV, auch bevorzugt im Bereich von < -4,5 eV und > -4,9 eV und zusätzlich bevorzugt im Bereich < -4,6 eV und > -4,9 eV aufweist.

**18.** Organische Elektrolumineszenzvorrichtung nach einem der vorhergehenden Ansprüche 1 bis 17, wobei

- die zweite Radialenverbindung der Formel (II) bei Berechnung mit dem Programmpaket TURBOMOLE V6.5 (TURBOMOLE GmbH, Litzenhardtstraße 19, 76135 Karlsruhe, Deutschland) durch Anwenden des Hybridfunktionals B3LYP mit einem 6-31G*-Basissatz in der Gasphase ein berechnetes LUMO-Energieniveau von ≤ -5,21

eV aufweist; oder

- die zweite Radialenverbindung der Formel (II) bei Berechnung mit dem Programmpaket TURBOMOLE V6.5 (TURBOMOLE GmbH, Litzenhardtstraße 19, 76135 Karlsruhe, Deutschland) durch Anwenden des Hybridfunktionals B3LYP mit einem 6-31G*-Basissatz in der Gasphase ein berechnetes LUMO-Energieniveau im Bereich von ≤ -4,60 eV, weiter bevorzugt ≤ -4,75 eV; weiter bevorzugt ≤ -5,00 eV; auch bevorzugt ≤ -5,10 eV; zusätzlich bevorzugt ≤ -5,15 eV; weiter bevorzugt ≤ -5,19 eV, aufweist.

**19.** Organische Elektrolumineszenzvorrichtung nach einem der Ansprüche 1 bis 18, wobei das berechnete LUMO-Energieniveau der ausgewählten zweiten Radialenverbindung der Formel (II) höher ist als das LUMO-Energieniveau der ersten Radialenverbindung der Formel (I).

**20.** Organische Elektrolumineszenzvorrichtung nach einem der Ansprüche 1 bis 19, wobei die zweite Radialenverbindung der Formel (II) in der Ladungserzeugungsschicht vom p-Typ bei Berechnung mit dem Programmpaket TURBOMOLE V6.5 (TURBOMOLE GmbH, Litzenhardtstraße 19, 76135 Karlsruhe, Deutschland) durch Anwenden des Hybridfunktionals B3LYP mit einem 6-31G*-Basissatz in der Gasphase ein berechnetes LUMO-Energieniveau im Bereich von ≤ -5,00 eV bis ≥ -5,75 eV, vorzugsweise ≤ -5,10 eV bis ≥ -5,70 eV; weiter bevorzugt ≤ -5,15 eV bis ≥ -5,65 eV, auch bevorzugt ≤ -5,19 eV bis ≥ -5,65 eV, zusätzlich bevorzugt ≤ -5,20 eV bis ≥ -5,60 eV, weiter bevorzugt ≤ -5,22 eV bis ≥ -5,55 eV, weiter bevorzugt ≤ -5,22 eV bis ≥ -5,50 eV, noch weiter bevorzugt ≤ -5,22 eV bis ≥ -5,45 eV, aufweist.

**21.** Organische Elektrolumineszenzvorrichtung nach einem der Ansprüche 1 bis 20, wobei die zweite Lochtransportmatrixverbindung bei Berechnung mit dem Programmpaket TURBOMOLE V6.5 (TURBOMOLE GmbH, Litzenhardtstraße 19, 76135 Karlsruhe, Deutschland) durch Anwenden des Hybridfunktionals B3LYP mit einem 6-31G*-Basissatz in der Gasphase ein berechnetes HOMO-Energieniveau im Bereich von ≤ -4,27 eV bis ≥ -5,1 eV, vorzugsweise im Bereich von < -4,3 eV und > -5,0 eV, weiter bevorzugt im Bereich von < -4,5 eV und > -5,0 eV, auch bevorzugt im Bereich von < -4,5 eV und > -4,9 eV, zusätzlich bevorzugt im Bereich von < -4,6 eV und > -4,9 eV, aufweist.

**22.** Organische Elektrolumineszenzvorrichtung nach einem der Ansprüche 1 bis 21, wobei die Verbindung der ersten Radialenverbindung der Formel (I) und die Verbindung der zweiten Radialenverbindung der Formel (II) unabhängig durch eine der folgenden Formeln (IVa) bis (IVh) wiedergegeben werden:

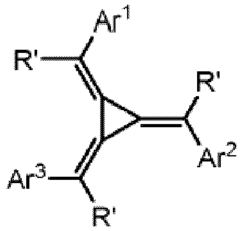

(IVa),

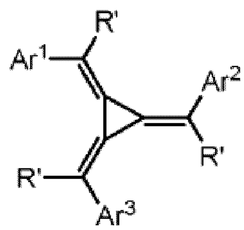

(IVe),

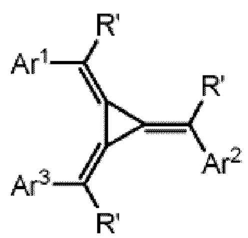

(IVb),

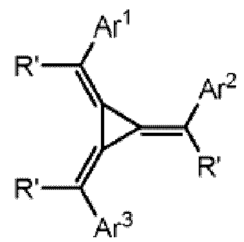

(IVf),

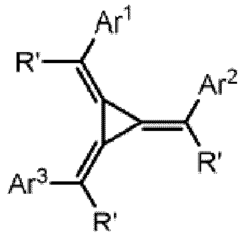

(IVc),

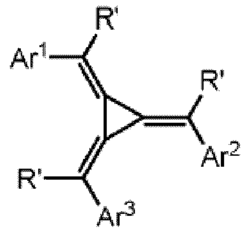

(IVg),

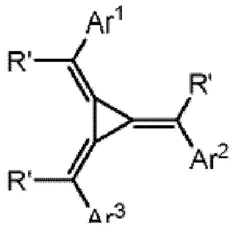

(IVd),

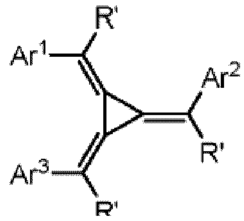

(IVh),

wobei $Ar^1$, $Ar^2$, $Ar^3$ und R' unabhängig aus Halogen, F und CN und vorzugsweise CN ausgewählt sind; wobei die erste Radialenverbindung der Formel (I) und die zweite Radialenverbindung der Formel (II) voneinander verschieden ausgewählt sind.

**23.** Elektronische Vorrichtung, umfassend eine organische Elektrolumineszenzvorrichtung nach einem der Ansprüche 1 bis 22, wobei es sich bei der elektronischen Vorrichtung vorzugsweise um eine Anzeigevorrichtung, eine lichtemittierende Vorrichtung, einen Dünnschichttransistor, eine Batterie, eine Anzeigevorrichtung oder eine Photovoltaikvorrichtung und vorzugsweise eine lichtemittierende Vorrichtung handelt, wobei die elektronische Vorrichtung vorzugsweise Teil einer Anzeigevorrichtung oder Beleuchtungsvorrichtung ist.

## Revendications

**1.** Dispositif électroluminescent organique comprenant une couche d'anode, une couche de cathode, une couche d'injection de trous, au moins deux unités émettrices de lumière, et au moins une couche de génération de charge, au moins une couche de génération de charge comprenant une couche de génération de charge de type p ;

chaque unité émettrice de lumière comprenant au moins une couche émettrice de lumière,
chacune parmi l'au moins une couche de génération de charge étant disposée indépendamment entre un ensemble de deux unités émettrices de lumière adjacentes des au moins deux unités émettrices de lumière ;
la couche d'injection de trous étant agencée plus proche de la couche d'anode que la couche de génération de charge de type p ;
la couche d'injection de trous comprenant un premier composé de radialène de formule (I) et un premier composé de matrice de transport de trous, le premier composé de radialène de formule (I) étant représenté par :

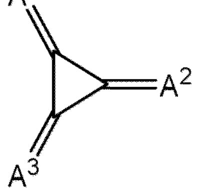

(I),

dans le premier composé de radialène de formule (I) :

$A^1$ étant indépendamment choisi parmi un groupe de formule (Ia) :

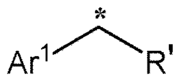 (Ia),

$Ar^1$ étant indépendamment choisi parmi $C_6$ à $C_{36}$ aryle substitué ou non substitué, et $C_2$ à $C_{36}$ hétéroaryle substitué ou non substitué ;
un ou plusieurs des substituants de $Ar^1$ étant indépendamment choisis dans le groupe comprenant D, un groupe électroattracteur, halogène, Cl, F, CN, $-NO_2$, $C_1$ à $C_8$ alkyle substitué ou non substitué, $C_1$ à $C_8$ alkyle partiellement fluoré, $C_1$ à $C_8$ alkyle perfluoré, $C_1$ à $C_8$ alcoxy substitué ou non substitué, $C_1$ à $C_8$ alcoxy partiellement fluoré, $C_1$ à $C_8$ alcoxy perfluoré, $C_6$ à $C_{30}$ aryle substitué ou non substitué, et $C_6$ à $C_{30}$ hétéroaryle substitué ou non substitué ;
le ou les substituants des $C_6$ à $C_{30}$ aryle, $C_6$ à $C_{30}$ hétéroaryle, $C_1$ à $C_8$ alkyle, et $C_1$ à $C_8$ alcoxy étant indépendamment choisis parmi D, un groupe électroattracteur, halogène, Cl, F, CN, $-NO_2$, $C_1$ à $C_8$ alkyle partiellement fluoré, $C_1$ à $C_8$ alkyle perfluoré, $C_1$ à $C_8$ alcoxy partiellement fluoré, $C_1$ à $C_8$ alcoxy perfluoré ;
$A^2$ étant indépendamment choisi parmi un groupe de formule (Ib) :

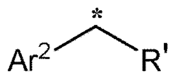 (Ib),

$Ar^2$ étant indépendamment choisi parmi $C_6$ à $C_{36}$ aryle substitué ou non substitué, et $C_2$ à $C_{36}$ hétéroaryle substitué ou non substitué ;
un ou plusieurs des substituants de $Ar^2$ étant indépendamment choisis dans le groupe comprenant D, un groupe électroattracteur, halogène, Cl, F, CN, $NO_2$, $C_1$ à $C_8$ alkyle substitué ou non substitué, $C_1$ à $C_8$ alkyle partiellement fluoré, $C_1$ à $C_8$ alkyle perfluoré, $C_1$ à $C_8$ alcoxy substitué ou non substitué, $C_1$ à $C_8$ alcoxy partiellement fluoré, $C_1$ à $C_8$ alcoxy perfluoré, $C_6$ à $C_{30}$ aryle substitué ou non substitué, et $C_6$ à $C_{30}$ hétéroaryle substitué ou non substitué ;
le ou les substituants de $C_6$ à $C_{30}$ aryle, $C_6$ à $C_{30}$ hétéroaryle, $C_1$ à $C_8$ alkyle, $C_1$ à $C_8$ alcoxy étant indépendamment choisis parmi D, un groupe électroattracteur, halogène, Cl, F, CN, $-NO_2$, $C_1$ à $C_8$ alkyle partiellement fluoré, $C_1$ à $C_8$ alkyle perfluoré, $C_1$ à $C_8$ alcoxy partiellement fluoré, $C_1$ à $C_8$ alcoxy perfluoré ;
$A^3$ étant indépendamment choisi parmi un groupe de formule (Ic) :

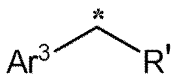 (Ic),

$Ar^3$ étant indépendamment choisi parmi $C_6$ à $C_{36}$ aryle substitué ou non substitué, et $C_2$ à $C_{36}$ hétéroaryle substitué ou non substitué ;
un ou plusieurs des substituants de $Ar^3$ étant indépendamment choisis dans le groupe comprenant D, un groupe électroattracteur, halogène, Cl, F, CN, $-NO_2$, $C_1$ à $C_8$ alkyle substitué ou non substitué, $C_1$ à $C_8$ alkyle partiellement fluoré, $C_1$ à $C_8$ alkyle perfluoré, $C_1$ à $C_8$ alcoxy substitué ou non substitué, $C_1$ à $C_8$ alcoxy partiellement fluoré, $C_1$ à $C_8$ alcoxy perfluoré, $C_6$ à $C_{30}$ aryle substitué ou non substitué, et $C_6$ à $C_{30}$ hétéroaryle substitué ou non substitué,
le ou les substituants de $C_6$ à $C_{30}$ aryle, $C_6$ à $C_{30}$ hétéroaryle, $C_1$ à $C_8$ alkyle, $C_1$ à $C_8$ alcoxy étant indépendamment choisis parmi D, un groupe électroattracteur, halogène, Cl, F, CN, $-NO_2$, $C_1$ à $C_8$ alkyle partiellement fluoré, $C_1$ à $C_8$ alkyle perfluoré, $C_1$ à $C_8$ alcoxy partiellement fluoré, $C_1$ à $C_8$ alcoxy perfluoré ;
dans $A^1$, $A^2$, et $A^3$ chaque R' étant indépendamment choisi parmi $C_6$ à $C_{18}$ aryle substitué ou non substitué, $C_3$ à $C_{18}$ hétéroaryle substitué ou non substitué, un groupe électroattracteur, $C_1$ à $C_8$ alkyle substitué ou non substitué, $C_1$ à $C_8$ alkyle partiellement fluoré, $C_1$ à $C_8$ alkyle perfluoré, halogène, F et CN ;
un ou plusieurs des substituants de $C_6$ à $C_{18}$ aryle, $C_6$ à $C_{18}$ hétéroaryle, $C_1$ à $C_8$ alkyle, étant indépendamment choisis parmi D, un groupe électroattracteur, halogène, Cl, F, CN, $-NO_2$, $C_1$ à $C_6$ alkyle partiellement fluoré, $C_1$ à $C_6$ alkyle perfluoré, $C_1$ à $C_6$ alcoxy partiellement fluoré, $C_1$ à $C_6$ alcoxy perfluoré ;
le premier composé de radialène de formule (I) ayant un niveau d'énergie de LUMO de $\leq$ -5,20 eV lorsqu'il est calculé avec le package de programme TURBOMOLE V6.5 (TURBOMOLE GmbH, Litzenhardtstrasse 19, 76135 Karlsruhe, Allemagne) en appliquant le B3LYP fonctionnel hybride avec un ensemble de base 6-31G* dans la phase gazeuse ;
la couche de génération de charge de type p comprenant un deuxième composé de radialène de formule (II) et un deuxième composé de matrice de transport de trous ; et

le deuxième composé de radialène de formule (II) étant représenté par :

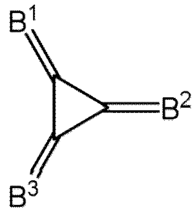

(II),

dans le deuxième composé de radialène de formule (II) :

$B^1$ étant indépendamment choisi parmi un groupe de formule (IIa) :

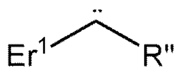

(IIa),

$Er^1$ étant indépendamment choisi parmi $C_6$ à $C_{36}$ aryle substitué ou non substitué, et $C_2$ à $C_{36}$ hétéroaryle substitué ou non substitué ;
un ou plusieurs des substituants de $Er^1$ étant indépendamment choisis dans le groupe comprenant D, un groupe électroattracteur, halogène, Cl, F, CN, $-NO_2$, $C_1$ à $C_8$ alkyle substitué ou non substitué, $C_1$ à $C_8$ alkyle partiellement fluoré, $C_1$ à $C_8$ alkyle perfluoré, $C_1$ à $C_8$ alcoxy substitué ou non substitué, $C_1$ à $C_8$ alcoxy partiellement fluoré, $C_1$ à $C_8$ alcoxy perfluoré, $C_6$ à $C_{30}$ aryle substitué ou non substitué, et $C_6$ à $C_{30}$ hétéroaryle substitué ou non substitué et ;
le ou les substituants de $C_6$ à $C_{30}$ aryle, $C_6$ à $C_{30}$ hétéroaryle, $C_1$ à $C_8$ alkyle, $C_1$ à $C_8$ alcoxy étant indépendamment choisis parmi D, un groupe électroattracteur, halogène, Cl, F, CN, $-NO_2$, $C_1$ à $C_8$ alkyle partiellement fluoré, $C_1$ à $C_8$ alkyle perfluoré, $C_1$ à $C_8$ alcoxy partiellement fluoré, $C_1$ à $C_8$ alcoxy perfluoré ;
$B^2$ étant indépendamment choisi parmi un groupe de formule (IIb) :

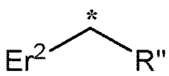

(IIb),

$Er^2$ étant indépendamment choisi parmi $C_6$ à $C_{36}$ aryle substitué ou non substitué, et $C_2$ à $C_{36}$ hétéroaryle substitué ou non substitué ;
un ou plusieurs des substituants de $Er^2$ étant indépendamment choisis dans le groupe comprenant D, un groupe électroattracteur, halogène, Cl, F, CN, $-NO_2$, $C_1$ à $C_8$ alkyle substitué ou non substitué, $C_1$ à $C_8$ alkyle partiellement fluoré, $C_1$ à $C_8$ alkyle perfluoré, $C_1$ à $C_8$ alcoxy substitué ou non substitué, $C_1$ à $C_8$ alcoxy partiellement fluoré, $C_1$ à $C_8$ alcoxy perfluoré, $C_6$ à $C_{30}$ aryle substitué ou non substitué, et $C_6$ à $C_{30}$ hétéroaryle substitué ou non substitué et ;
le ou les substituants de $C_6$ à $C_{30}$ aryle, $C_6$ à $C_{30}$ hétéroaryle, $C_1$ à $C_8$ alkyle, $C_1$ à $C_8$ alcoxy étant indépendamment choisis parmi D, un groupe électroattracteur, halogène, Cl, F, CN, $-NO_2$, $C_1$ à $C_8$ alkyle partiellement fluoré, $C_1$ à $C_8$ alkyle perfluoré, $C_1$ à $C_8$ alcoxy partiellement fluoré, $C_1$ à $C_8$ alcoxy perfluoré ;
$B^3$ étant indépendamment choisi parmi un groupe de formule (Ic) :

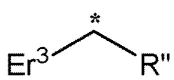

(IIc),

$Er^3$ étant indépendamment choisi parmi $C_6$ à $C_{36}$ aryle substitué ou non substitué, et $C_2$ à $C_{36}$ hétéroaryle substitué ou non substitué ;
un ou plusieurs des substituants de $Er^3$ étant indépendamment choisis dans le groupe comprenant D, un groupe électroattracteur, halogène, Cl, F, CN, $-NO_2$, $C_1$ à $C_8$ alkyle substitué ou non substitué, $C_1$ à $C_8$ alkyle partiellement fluoré, $C_1$ à $C_8$ alkyle perfluoré, $C_1$ à $C_8$ alcoxy substitué ou non substitué, $C_1$ à $C_8$ alcoxy partiellement fluoré, $C_1$ à $C_8$ alcoxy perfluoré, $C_6$ à $C_{30}$ aryle substitué ou non substitué, et $C_6$ à $C_{30}$ hétéroaryle substitué ou non substitué et ;

le ou les substituants de $C_6$ à $C_{30}$ aryle, $C_6$ à $C_{30}$ hétéroaryle, $C_1$ à $C_8$ alkyle, $C_1$ à $C_8$ alcoxy étant indépendamment choisis parmi D, un groupe électroattracteur, halogène, Cl, F, CN, $-NO_2$, $C_1$ à $C_8$ alkyle partiellement fluoré, $C_1$ à $C_8$ alkyle perfluoré, $C_1$ à $C_8$ alcoxy partiellement fluoré, $C_1$ à $C_8$ alcoxy perfluoré ;

dans $B^1$, $B^2$, et $B^3$ chaque R" étant indépendamment choisi parmi $C_6$ à $C_{18}$ aryle substitué ou non substitué, $C_3$ à $C_{18}$ hétéroaryle substitué ou non substitué, un groupe électroattracteur, $C_1$ à $C_8$ alkyle substitué ou non substitué, $C_1$ à $C_8$ alkyle partiellement fluoré, $C_1$ à $C_8$ alkyle perfluoré, halogène, F et CN ;

le ou les substituants de $C_6$ à $C_{18}$ aryle, $C_6$ à $C_{18}$ hétéroaryle, $C_1$ à $C_8$ alkyle, étant indépendamment choisis parmi D, un groupe électroattracteur, halogène, Cl, F, CN, $-NO_2$, $C_1$ à $C_6$ alkyle partiellement fluoré, $C_1$ à $C_6$ alkyle perfluoré, $C_1$ à $C_6$ alcoxy partiellement fluoré, $C_1$ à $C_6$ alcoxy perfluoré ;

le premier composé de radialène de formule (I) et le deuxième composé de radialène de formule (II) étant choisis de sorte à être différents l'un de l'autre ; et l'astérisque « * » désignant la position de liaison.

**2.** Dispositif électroluminescent organique selon la revendication 1, le dispositif électroluminescent organique comprenant au moins trois unités émettrices de lumière, et au moins deux couches de génération de charge, chacune des au moins deux couches de génération de charge étant disposée indépendamment entre un ensemble de deux unités émettrices de lumière adjacentes des au moins trois unités émettrices de lumière ; ou le dispositif électroluminescent organique comprenant au moins quatre unités émettrices de lumière, et au moins trois couches de génération de charge, chacune des au moins trois couches de génération de charge étant disposée indépendamment entre un ensemble de deux unités émettrices de lumière adjacentes des au moins quatre unités émettrices de lumière.

**3.** Dispositif électroluminescent organique selon l'une quelconque des revendications 1 à 2, la couche d'injection de trous étant en contact direct avec la couche d'anode.

**4.** Dispositif électroluminescent organique selon l'une quelconque des revendications 1 à 3, le dispositif électroluminescent organique comprenant en outre une couche de transport de trous, la couche de transport de trous étant agencée adjacente à la couche d'injection de trous, et de préférence la couche de transport de trous étant agencée entre une unité émettrice de lumière et la couche d'injection de trous.

**5.** Dispositif électroluminescent organique selon l'une quelconque des revendications 1 à 4, l'au moins une couche de génération de charge comprenant en outre une couche de génération de charge de type n.

**6.** Dispositif électroluminescent organique selon l'une quelconque des revendications 1 à 5, la couche de génération de charge de type p de l'au moins une couche de génération de charge étant agencée en contact direct avec la couche de génération de charge de type n de l'au moins une couche de génération de charge.

**7.** Dispositif électroluminescent organique selon l'une quelconque des revendications 1 à 6, au moins une unité émettrice de lumière ou toutes les unités émettrices de lumière comprenant, en plus d'une couche d'émission, une couche de transport de trous, une couche de blocage d'électrons, une couche de blocage de trous et une couche de transport d'électrons.

**8.** Dispositif électroluminescent organique selon l'une quelconque des revendications 1 à 7, dans le premier composé de radialène de formule (I) et de formule (II), R' et R" étant indépendamment choisis parmi halogène, F et CN, et de préférence CN.

**9.** Dispositif électroluminescent organique selon l'une quelconque des revendications 1 à 8, dans le premier composé de radialène de formule (I), au moins deux des composés $A^1$, $A^2$ et $A^3$ étant choisis de sorte à être les mêmes ; et/ou dans le deuxième composé de radialène de formule (II), au moins deux des composés $B^1$, $B^2$ et $B^3$ étant choisis de sorte à être les mêmes.

**10.** Dispositif électroluminescent organique selon l'une quelconque des revendications 1 à 9, dans le premier composé de radialène de formule (I), $Ar^1$, $Ar^2$ et $Ar^3$ et/ou dans le deuxième composé de radialène de formule (II) $Er^1$, $Er^2$ et $Er^3$ étant indépendamment choisis parmi l'un des groupes suivants parmi B1 à B64 :

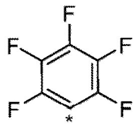 (B1), 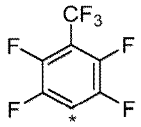 (B2), 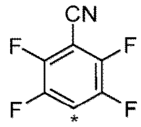 (B3), 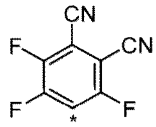 (B4), 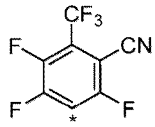 (B5),

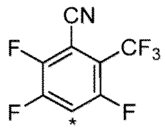 (B6), 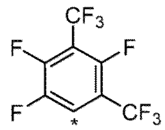 (B7), 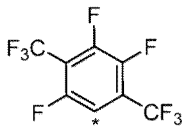 (B8), 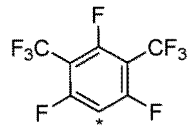 (B9), 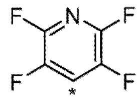 (B10),

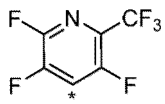 (B11), 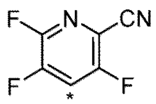 (B12), 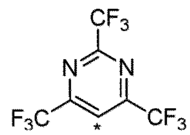 (B13), 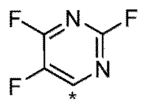 (B14), 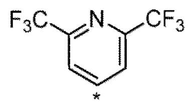 (B15),

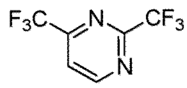 (B16), 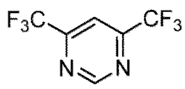 (B17), 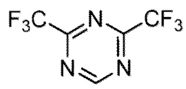 (B18), 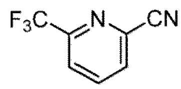 (B19), 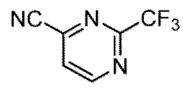 (B20),

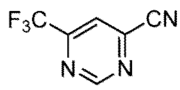 (B21), 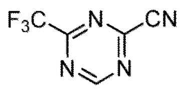 (B22), 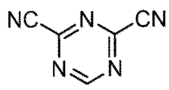 (B23), 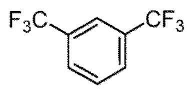 (B24), 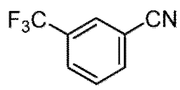 (B25),

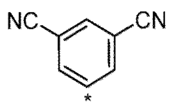 (B26), 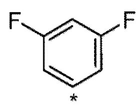 (B27), 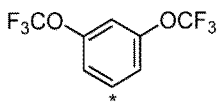 (B28), 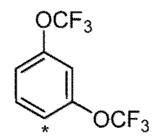 (B29), 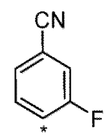 (B30),

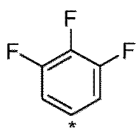 (B31), 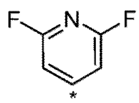 (B32), 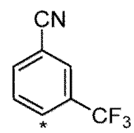 (B33), 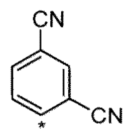 (B34), 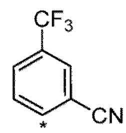 (B35),

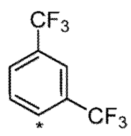 (B36), 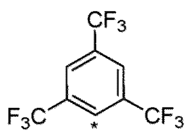 (B37), 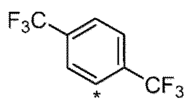 (B38), 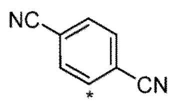 (B39), 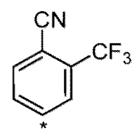 (B40),

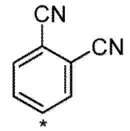 (B41), 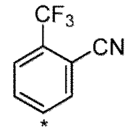 (B42), 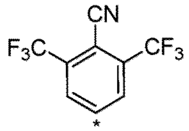 (B43), 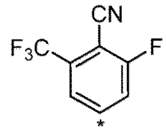 (B44), 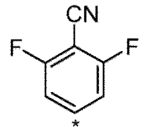 (B45),

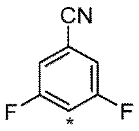 (B46), 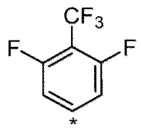 (B47), 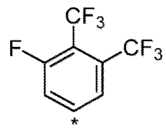 (B48), 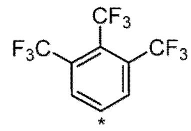 (B49), 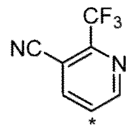 (B50),

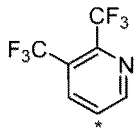 (B51), 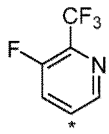 (B52), 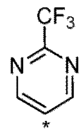 (B53), 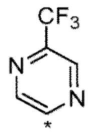 (B54), 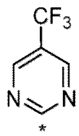 (B55),

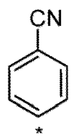 (B56), 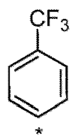 (B57), 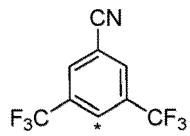 (B58), 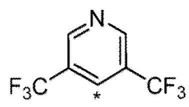 (B59), 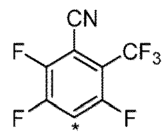 (B60),

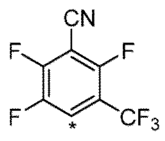 (B61), 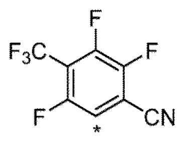 (B62), 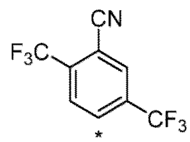 (B63), 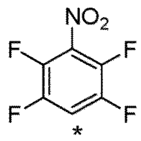 (B64),

l'astérisque « * » désignant la position de liaison.

**11.** Dispositif électroluminescent organique selon la revendication 10, dans le premier composé de radialène de formule (I), $Ar^1$, $Ar^2$ et $Ar^3$ et/ou dans le deuxième composé de radialène de formule (II), $Er^1$, $Er^2$ et $Er^3$ étant indépendamment choisis parmi l'un des groupes suivants parmi B1 à B8, B10 à B17, B19 à B21, B24 à B26, B33, B34, B37, B40, B43, B58 à B62 et B64, et de préférence dans le premier composé de radialène de formule (I), $Ar^1$, $Ar^2$ et $Ar^3$ et/ou dans le deuxième composé de radialène de formule (II), $Er^1$, $Er^2$ et $Er^3$ étant indépendamment choisis parmi l'un des groupes suivants parmi B2, B3, B4, B11, B13, B37, B43, B58, B59, B60, B61, B63 et B64.

**12.** Dispositif électroluminescent organique selon la revendication 11, dans le premier composé de radialène de formule (I), $Ar^1$, $Ar^2$ et $Ar^3$ étant choisis indépendamment parmi l'un des groupes suivants parmi B1 à B64, et de préférence chaque R' et/ou R" étant choisis parmi CN, et de préférence dans le premier composé de radialène de formule (I), $Ar^1$, $Ar^2$ et $Ar^3$ et/ou dans le deuxième composé de radialène de formule (II), $Er^1$, $Er^2$ et $Er^3$ étant indépendamment choisis parmi l'un des groupes suivants parmi B1 à B5, B7, B8, B10 à B13, B15 à B17, B19 à B21, B37, B43, B58 à B61, B63 et B64, et de préférence chaque R' et/ou R" étant choisis parmi CN.

**13.** Dispositif électroluminescent organique selon l'une quelconque des revendications 1 à 12, dans le premier composé de radialène de formule (I), $Ar^1$, $Ar^2$ et $Ar^3$ et/ou dans le deuxième composé de radialène de formule (II), $Er^1$, $Er^2$ et $Er^3$ étant indépendamment choisis parmi un groupe selon la formule (III) suivante, et de préférence chaque R' et/ou R" étant choisis parmi CN :

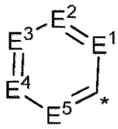

(III)

$E^1$ étant choisi parmi $CW^1$ ou N ;
$E^2$ étant choisi parmi $CW^2$ ou N ;
$E^3$ étant choisi parmi $CW^3$ ou N ;
$E^4$ étant choisi parmi $CW^4$ ou N ;
$E^5$ étant choisi parmi $CW^5$ ou N ;
$W^1$, $W^2$, $W^3$, $W^4$ et $W^5$ étant indépendamment choisis parmi un groupe électroattracteur, CN, halogène, Cl, F, $NO_2$, $C_1$ à $C_8$ alkyle substitué ou non substitué, $C_1$ à $C_8$ alkyle partiellement fluoré, $C_1$ à $C_8$ alkyle perfluoré, $CF_3$, $C_1$ à $C_8$ alcoxy substitué ou non substitué, $C_1$ à $C_8$ alcoxy partiellement fluoré, $C_1$ à $C_6$ alcoxy perfluoré, $OCF_3$, $C_6$ à $C_{30}$ aryle substitué ou non substitué, $C_3$ à $C_{30}$ hétéroaryle substitué ou non substitué, D ou H,
le ou les substituants de $W^1$, $W^2$, $W^3$, $W^4$ et $W^5$ étant indépendamment choisis parmi D, halogène, Cl, F, CN, $NO_2$, $C_1$ à $C_8$ alkyle partiellement fluoré, $C_1$ à $C_8$ alkyle perfluoré, $C_1$ à $C_8$ alcoxy partiellement fluoré, $C_1$ à $C_8$ alcoxy perfluoré ;
l'astérisque « * » désignant la position de liaison.

**14.** Dispositif électroluminescent organique selon la revendication 13, dans la formule (III) $W^1$, $W^2$, $W^3$, $W^4$ et $W^5$ étant indépendamment choisis parmi un groupe électroattracteur, CN, halogène, Cl, F, $NO_2$, $C_1$ à $C_8$ alkyle partiellement fluoré ou perfluoré, $CF_3$, $C_1$ à $C_6$ alcoxy partiellement fluoré ou perfluoré, $OCF_3$, D ou H, et préférablement chaque R' et/or R" étant CN.

**15.** Dispositif électroluminescent organique selon l'une quelconque des revendications 1 à 14, le second radialène de formule (II) ayant une énergie de LUMO calculée qui est calculée avec le package de programme TURBOMOLE V6.5 (TURBOMOLE GmbH, Litzenhardtstrasse 19, 76135 Karlsruhe, Allemagne) en appliquant le B3LYP fonctionnel hybride avec un ensemble de base 6-31G* dans la phase gazeuse.

**16.** Dispositif électroluminescent organique selon l'une quelconque des revendications 1 à 15,

- le premier composé de radialène de formule (I) ayant un niveau d'énergie de LUMO calculé de ≤ -5,21 eV, de préférence ≤ -5,22 eV ; en outre de manière préférée ≤ - 5,25 eV ; et de plus de manière préférée ≤ -5,29 eV ; ou
- le premier composé de radialène de formule (I) ayant un niveau d'énergie de LUMO calculé dans la plage de ≤ - 5,20 eV à ≥ -5,75 eV, de préférence de ≤ -5,20 eV à ≥ - 5,70 eV ; en outre de manière préférée de ≤ -5,20 eV à ≥ -5,65 eV, de manière également préférée de ≤ -5,20 eV à ≥ -5,60 eV, de préférence en outre de ≤ -5,22 eV à ≥ - 5,60 eV, de plus de manière préférée de ≤ -5,25 eV à ≥ - 5,55 eV, de manière plus préférée de ≤ -5,25 eV à ≥ -5,50 eV, de manière encore plus préférée de ≤ -5,25 eV à ≥ - 5,45 eV.

**17.** Dispositif électroluminescent organique selon l'une quelconque des revendications 1 à 16, le premier composé de matrice de transport de trous ayant un niveau d'énergie de HOMO calculé dans la plage de ≤ -4,27 eV à ≥ -5,1 eV, de préférence dans la plage de < -4,3 eV à > -5,0 eV, de préférence en outre dans la plage de < -4,5 eV à > -5,0 eV, de manière également préférée dans la plage de < -4,5 eV à > -4,9 eV, et de préférence encore dans la plage de < -4,6 eV à > -4,9 eV.

**18.** Dispositif électroluminescent organique selon l'une quelconque des revendications 1 à 17,

- le deuxième composé de radialène de formule (II) ayant un niveau d'énergie de LUMO calculé de ≤ -5,21 eV lorsqu'il est calculé avec le package de programme TURBOMOLE V6.5 (TURBOMOLE GmbH, Litzenhardtstrasse 19, 76135 Karlsruhe, Allemagne) en appliquant le B3LYP fonctionnel hybride avec un ensemble de base 6-31G* dans la phase gazeuse ; ou
- le deuxième composé de radialène de formule (II) ayant un niveau d'énergie de LUMO calculé dans la plage de ≤ - 4,60 eV lorsqu'il est calculé avec le package de programme TURBOMOLE V6.5 (TURBOMOLE GmbH, Litzenhardtstrasse 19, 76135 Karlsruhe, Allemagne) en appliquant le B3LYP fonctionnel hybride avec un ensemble de base 6-31G* dans la phase gazeuse, plus préférablement ≤ -4,75 eV ; de préférence en outre ≤ -5,00 eV ; de manière également préférée ≤ -5,10 eV ; de préférence encore ≤ -5,15 eV ; de manière plus

préférée ≤ -5,19 eV.

**19.** Dispositif électroluminescent organique selon l'une quelconque des revendications 1 à 18, le niveau d'énergie de LUMO calculé du deuxième composé de radialène sélectionné de formule (II) étant supérieur au niveau d'énergie de LUMO du premier composé de radialène de formule (I).

**20.** Dispositif électroluminescent organique selon l'une quelconque des revendications 1 à 19, le deuxième composé de radialène de formule (II) dans la couche de génération de charge de type p ayant un niveau d'énergie de LUMO calculé dans la plage de ≤ -5,00 eV à ≥ -5,75 eV, lorsqu'il est calculé avec le package de programme TURBOMOLE V6.5 (TURBOMOLE GmbH, Litzenhardtstrasse 19, 76135 Karlsruhe, Allemagne) en appliquant le B3LYP fonctionnel hybride avec un ensemble de base 6-31G* dans la phase gazeuse, de préférence ≤ -5,10 eV à ≥ -5,70 eV ; de préférence en outre ≤ -5,15 eV à ≥ -5,65 eV, de manière également préférée ≤ -5,19 eV à ≥ -5,65 eV, de préférence encore ≤ -5,20 eV à ≥ -5,60 eV, de manière plus préférée ≤ -5,22 eV à ≥ -5,55 eV, de manière encore plus préférée ≤ -5,22 eV à ≥ -5,50 eV, et de manière encore plus préférée ≤ -5,22 eV à ≥ -5,45 eV.

**21.** Dispositif électroluminescent organique selon l'une quelconque des revendications 1 à 20, le deuxième composé de matrice de transport de trous ayant un niveau d'énergie de HOMO calculé dans la plage de ≤ -4,27 eV à ≥ -5,1 eV, lorsqu'il est calculé avec le package de programme TURBOMOLE V6.5 (TURBOMOLE GmbH, Litzenhardtstrasse 19, 76135 Karlsruhe, Allemagne) en appliquant le B3LYP fonctionnel hybride avec un ensemble de base 6-31G* dans la phase gazeuse, de préférence dans la plage de < -4,3 eV à > -5,0 eV, de préférence en outre dans la plage de < -4,5 eV à > -5,0 eV, de manière également préférée dans la plage de < -4,5 eV à > -4,9 eV, de préférence encore dans la plage de < -4,6 eV à > -4,9 eV.

**22.** Dispositif électroluminescent organique selon l'une quelconque des revendications 1 à 21, le composé du premier composé de radialène de formule (I) et le composé du deuxième composé de radialène de formule (II) étant indépendamment représentés par l'une des formules (IVa) à (IVh) suivantes :

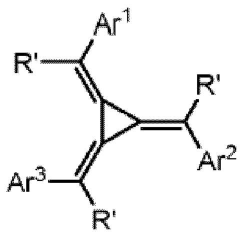
(IVa),

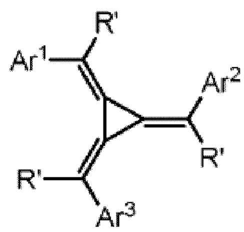
(IVe),

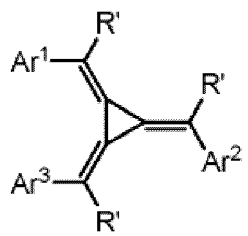
(IVb),

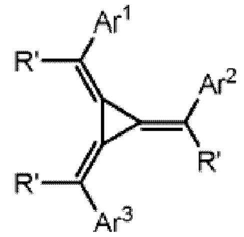
(IVf),

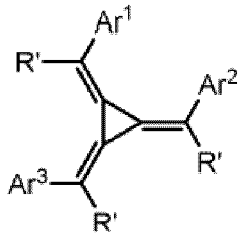
(IVc),

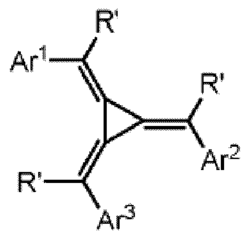
(IVg),

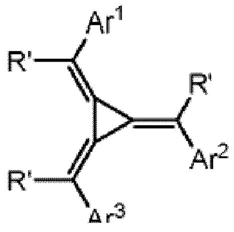

(IVd),

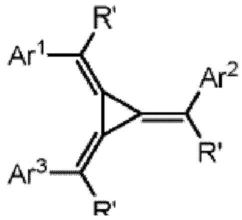

(IVh),

$Ar^1$, $Ar^2$, $Ar^3$, et R' étant indépendamment choisis parmi halogène, F et CN, et préférablement CN ; le premier composé de radialène de formule (I) et le deuxième composé de radialène de formule (II) étant choisis de sorte à être différents l'un de l'autre.

**23.** Dispositif électronique comprenant un dispositif électroluminescent organique selon l'une quelconque des revendications 1 à 22, le dispositif électronique étant de préférence un dispositif d'affichage, un dispositif émetteur de lumière, un transistor en film mince, une batterie, un dispositif d'affichage ou un dispositif photovoltaïque, et de préférence un dispositif émetteur de lumière, de préférence le dispositif électronique faisant partie d'un dispositif d'affichage ou d'un dispositif d'éclairage.

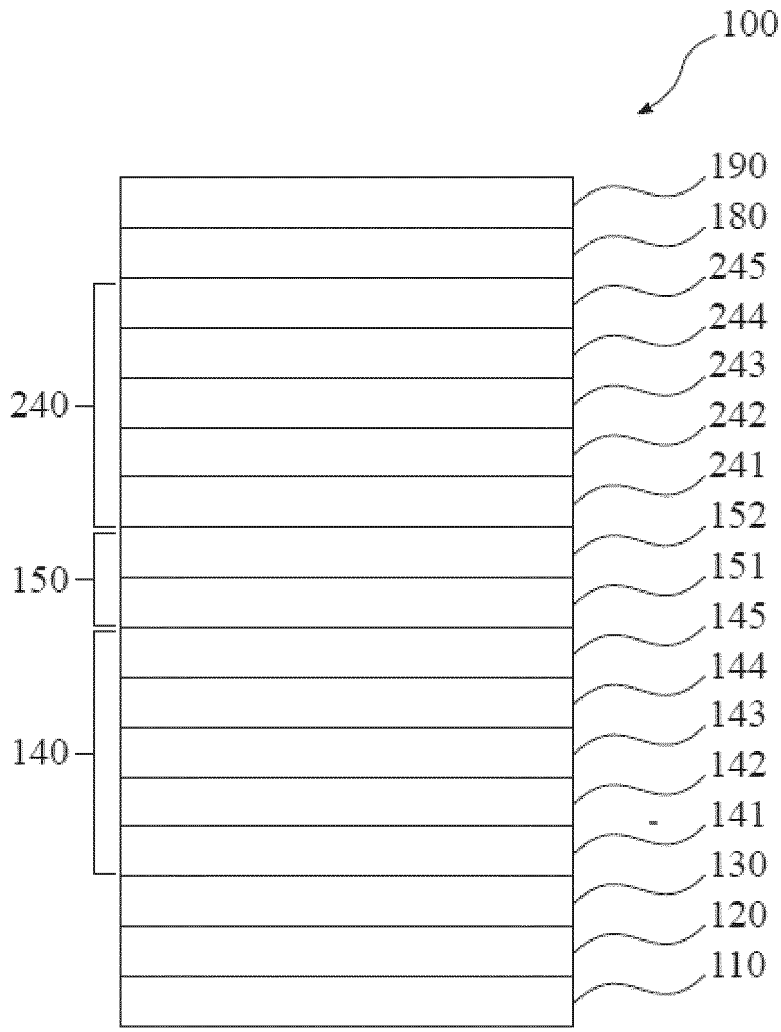
100
190
180
245
244
243
242
241
152
151
145
144
143
142
141
130
120
110
240
150
140

Fig. 1

2/4

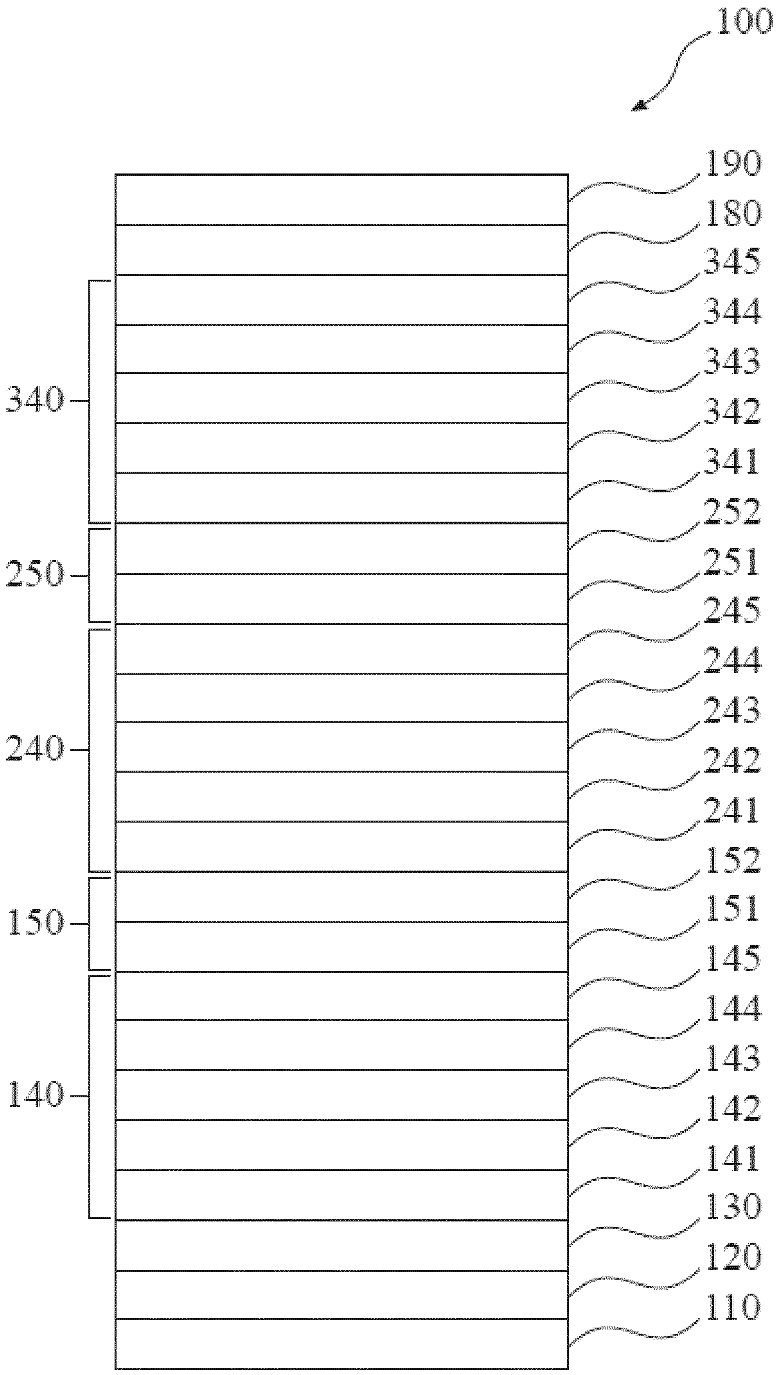
100
190
180
345
344
343
342
341
252
251
245
244
243
242
241
152
151
145
144
143
142
141
130
120
110
340
250
240
150
140

Fig. 2

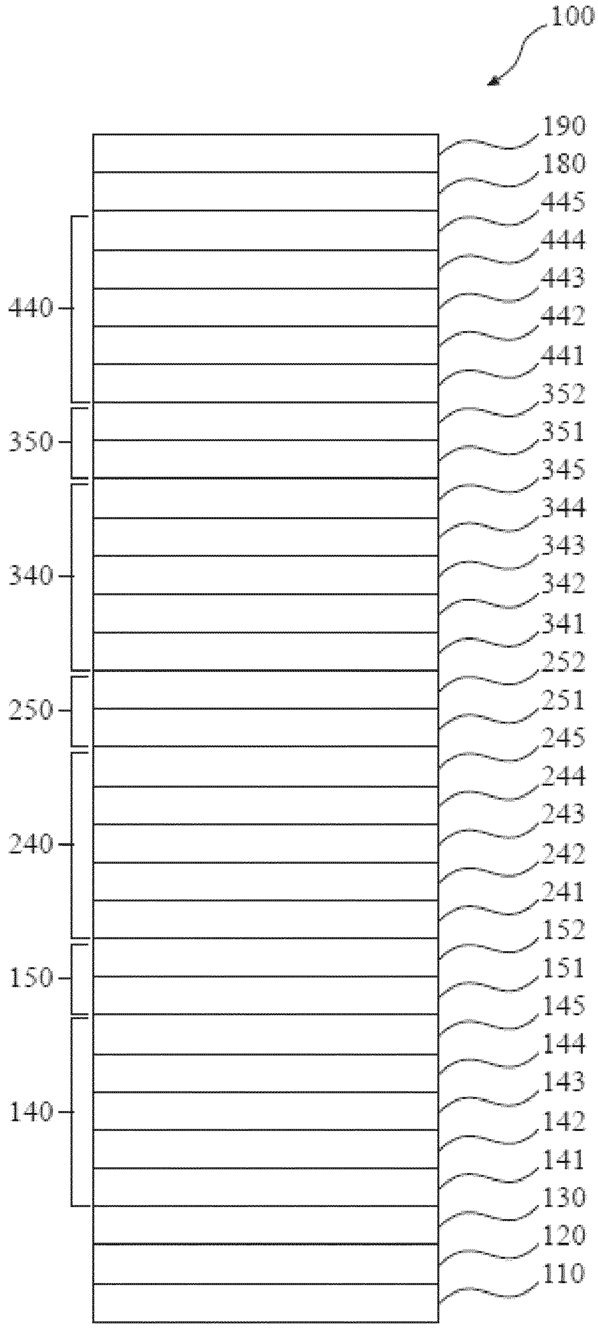
100
190
180
445
444
443
442
441
352
351
345
344
343
342
341
252
251
245
244
243
242
241
152
151
145
144
143
142
141
130
120
110
440
350
340
250
240
150
140

Fig. 3

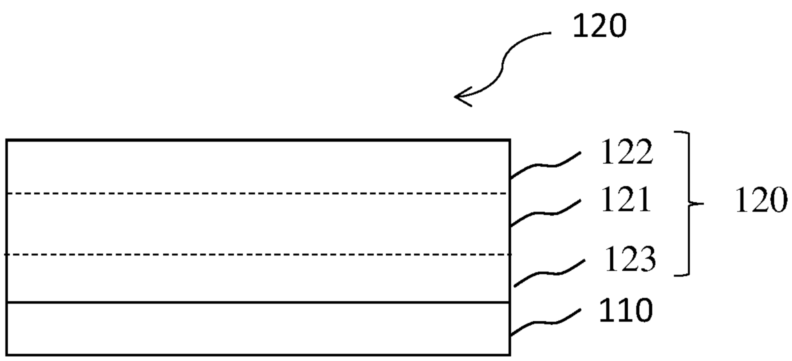


Fig. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2022161706 A1
- EP 3989305 A1
- EP 2722908 A1
- EP 2180029 A1
- WO 2016097017 A1


### Non-patent literature cited in the description


- **YASUHIKO SHIROTA ; HIROSHI KAGEYAMA**. *Chem. Rev.*, 2007, vol. 107, 953-1010